(19) Europäisches Patentamt
European Patent Office
Office européen des brevets

(11) EP 4 300 592 A1

(12) **EUROPEAN PATENT APPLICATION**
published in accordance with Art. 153(4) EPC

(43) Date of publication:
**03.01.2024 Bulletin 2024/01**

(21) Application number: **22759742.4**

(22) Date of filing: **24.02.2022**

(51) International Patent Classification (IPC):
***H01L 29/786*** (2006.01) ***H01L 21/336*** (2006.01)
***H01L 51/05*** (2006.01) ***H01L 51/30*** (2006.01)
***H01L 51/40*** (2006.01)

(52) Cooperative Patent Classification (CPC):
**H01L 29/66477; H01L 29/786; H10K 10/00; H10K 71/00; H10K 85/00;** Y02E 10/549

(86) International application number:
**PCT/JP2022/007658**

(87) International publication number:
**WO 2022/181707 (01.09.2022 Gazette 2022/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.02.2021 JP 2021029329**

(71) Applicants:
- **The University of Tokyo**
  **Bunkyo-ku, Tokyo 113-8654 (JP)**
- **Daicel Corporation**
  **Osaka 530-0011 (JP)**

(72) Inventors:
- **TAKEYA, Junichi**
  **Tokyo 113-8654 (JP)**
- **WATANABE, Shunichiro**
  **Tokyo 113-8654 (JP)**
- **KUMAGAI, Shouhei**
  **Tokyo 113-8654 (JP)**
- **WEI, Xiaozhu**
  **Tokyo 113-8654 (JP)**
- **IKEDA, Daiji**
  **Tokyo 108-8230 (JP)**
- **SATO, Hiroki**
  **Tokyo 108-8230 (JP)**
- **AKAI, Yasuyuki**
  **Tokyo 108-8230 (JP)**

(74) Representative: **Grünecker Patent- und Rechtsanwälte**
**PartG mbB**
**Leopoldstraße 4**
**80802 München (DE)**

# (54) INORGANIC/ORGANIC HYBRID COMPLEMENTARY SEMICONDUCTOR DEVICE AND METHOD FOR PRODUCING SAME

(57) The present disclosure provides an inorganic/organic hybrid complementary semiconductor device that can be manufactured at a lower cost, has excellent long-term stability, has a well-balanced operation between the p-type transistor and the n-type transistor, and operates at a high speed. The present disclosure is related to an inorganic/organic hybrid complementary semiconductor device including a substrate, a p-type organic semiconductor single crystal layer, an n-type amorphous metal oxide inorganic semiconductor layer between the substrate and the single crystal layer, and a protective layer between the single crystal layer and the inorganic semiconductor layer, wherein when viewed from a direction perpendicular to a main surface of the single crystal layer, the single crystal layer is disposed and thus at least a part of the single crystal layer overlaps the inorganic semiconductor layer or the single crystal layer does not overlap the inorganic semiconductor layer, a distance between the single crystal layer and the inorganic semiconductor layer is 1 mm or less, and the inorganic semiconductor layer has a distribution of an oxygen defect amount in a thickness direction in which the oxygen defect amount is larger on the single crystal layer side than on the substrate side.

EP 4 300 592 A1

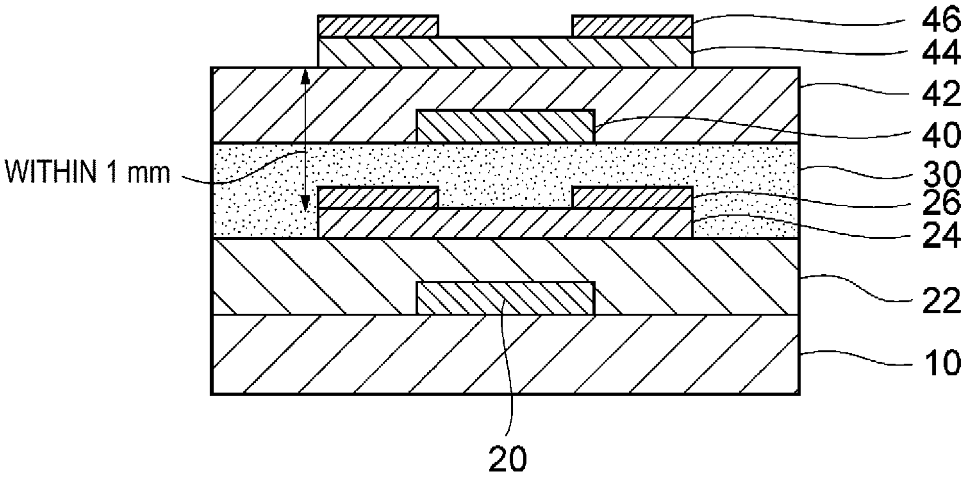


FIG. 1

## Description

### Technical Field

The present invention relates to an inorganic/organic hybrid complementary semiconductor device and a method for manufacturing the same.

### Background Art

Semiconductor devices are expected to be basic elements of electronic devices in the Internet of Things (IoT) society. In particular, a complementary metal oxide semiconductor (CMOS) including p-type and n-type transistors has been a foundation technology of a current integrated circuit.

### Citation List

### Non-Patent Literature

Non-Patent Literature 1: Takeda, Y. et al. Appl. Sci. 2018, 8, 1331
Non-Patent Literature 2: K. Hong, et al. Adv. Mater. 2014, 26, 7032
Non-Patent Literature 3: M. Uno, et al. Adv. Electron. Mater. 2015, 1, 1500178
Non-Patent Literature 4: K. J. Baeg, et al. Org. Electron. 2013, 14, 1407
Non-Patent Literature 5: S. H. Kim, et al, IEEE Electron Device Lett. 2013, 34, 307
Non-Patent Literature 6: W. Smaal, et al. Org. Electron. 2012, 13, 1686
Non-Patent Literature 7: L. Herlogsson, et al. Adv. Mater. 2011, 23, 4684

### Summary of Invention

### Technical Problem

However, there is still a need for an inexpensive CMOS that can be manufactured on a large scale. In addition, a CMOS that has excellent long-term stability, has a well-balanced operation between a p-type transistor and an n-type transistor, and operates at a high speed.

The present invention has been made in view of the above circumstances, and an object of the present invention is to provide a complementary semiconductor device that can be manufactured at a lower cost, has excellent long-term stability, has the well-balanced operation between the p-type transistor and the n-type transistor, and operates at a high speed.

### Solution to Problem

The gist of an embodiment of the present invention is as follows.

(1) An inorganic/organic hybrid complementary semiconductor device including:

a substrate;
a p-type organic semiconductor single crystal layer;
an n-type amorphous metal oxide inorganic semiconductor layer between the substrate and the p-type organic semiconductor single crystal layer; and
a protective layer between the p-type organic semiconductor single crystal layer and the n-type amorphous metal oxide inorganic semiconductor layer, in which
when viewed from a direction perpendicular to a main surface of the p-type organic semiconductor single crystal layer, the p-type organic semiconductor single crystal layer is disposed and thus at least a part of the p-type organic semiconductor single crystal layer overlaps the n-type amorphous metal oxide inorganic semiconductor layer or the p-type organic semiconductor single crystal layer does not overlap the n-type amorphous metal oxide inorganic semiconductor layer,
a distance between the p-type organic semiconductor single crystal layer and the n-type amorphous metal oxide inorganic semiconductor layer is 1 mm or less, and

the n-type amorphous metal oxide inorganic semiconductor layer has a distribution of an oxygen defect amount in a thickness direction in which the oxygen defect amount is larger on the p-type organic semiconductor single crystal layer side than on the substrate side.

(2) The inorganic/organic hybrid complementary semiconductor device according to the above-described (1), in which the p-type organic semiconductor single crystal layer has an average thickness from 2 nm to 100 nm.
(3) The inorganic/organic hybrid complementary semiconductor device according to the above-described (1) or (2), in which the p-type organic semiconductor single crystal film has a single domain of 0.0025 $mm^2$ or greater.
(4) The inorganic/organic hybrid complementary semiconductor device according to any one of the above-described (1) to (3), in which the substrate is a flexible substrate.
(5) The inorganic/organic hybrid complementary semiconductor device according to any one of the above-described (1) to (4), in which

the protective layer includes a first organic film and a second organic film,
the first organic film is located on the n-type amorphous metal oxide inorganic semiconductor layer side, and the second organic film is located on the p-type organic semiconductor single crystal layer side, and
the first organic film contains an organic solvent soluble polymer, and the second organic film is a vacuum deposited film.

(6) The inorganic/organic hybrid complementary semiconductor device according to the above-described (5), in which the first organic film has a thickness of 10 nm or greater, and the second organic film has a thickness from 100 nm to 300 nm.
(7) The inorganic/organic hybrid complementary semiconductor device according to the above-described (5) or (6), in which the first organic film is a PMMA film, and the second organic film is a parylene film.
(8) A method for manufacturing an inorganic/organic hybrid complementary semiconductor device, the method including:

providing a substrate;
forming an n-type structure on the substrate;
forming a protective layer on the n-type structure; and
forming a p-type structure on the protective layer, in which
the forming the n-type structure includes:

preparing a precursor solution of an n-type amorphous metal oxide inorganic semiconductor containing a metal salt by using a sol-gel method,
forming a precursor film by applying the precursor solution on the substrate, and
forming an n-type amorphous metal oxide inorganic semiconductor layer by heat-treating the precursor film at 350°C to 400°C,
the forming the p-type structure includes forming a p-type organic semiconductor single crystal layer by using a coating method,
when viewed from a direction perpendicular to a main surface of the p-type organic semiconductor single crystal layer, the p-type organic semiconductor single crystal layer is disposed and thus at least a part of the p-type organic semiconductor single crystal layer overlaps the n-type amorphous metal oxide inorganic semiconductor layer or the p-type organic semiconductor single crystal layer does not overlap the n-type amorphous metal oxide inorganic semiconductor layer,
a distance between the p-type organic semiconductor single crystal layer and the n-type amorphous metal oxide inorganic semiconductor layer is 1 mm or less, and
the n-type amorphous metal oxide inorganic semiconductor layer has a distribution of an oxygen defect amount in a thickness direction in which the oxygen defect amount is larger on the p-type organic semiconductor single crystal layer side than on the substrate side.

(9) The method for manufacturing an inorganic/organic hybrid complementary semiconductor device according to the above-described (8), in which the forming the precursor film by applying the precursor solution is performed using a spin coating method.
(10) The method for manufacturing an inorganic/organic hybrid complementary semiconductor device according to the above-described (8) or (9), in which
the forming the protective layer includes:

preparing an organic solvent containing a polymer dissolved,
forming a first organic film on the n-type structure by applying the organic solvent containing the polymer dissolved, and
forming a second organic film that is a vacuum deposited film on the first organic film by using a chemical vapor deposition method.

(11) The method for manufacturing an inorganic/organic hybrid complementary semiconductor device according to any one of the above-described (8) to (10), in which
the forming the p-type organic semiconductor single crystal layer includes:

forming a p-type organic semiconductor single crystal film on a first substrate having hydrophilic and water-insoluble properties by using the coating method, and
applying water or an aqueous solution to an interface between the first substrate and the p-type organic semiconductor single crystal film to separate the p-type organic semiconductor single crystal film from the first substrate, and disposing a p-type organic semiconductor single crystal layer on a second substrate, and
the second substrate is at least one of a gate insulating layer or S/D electrodes of the n-type structure, the protective layer, or a combination thereof.

(12) The method for manufacturing an inorganic/organic hybrid complementary semiconductor device according to any one of the above-described (8) to (10), in which
the forming the p-type organic semiconductor single crystal layer includes:

forming a p-type organic semiconductor single crystal film on a third substrate having hydrophilic and water-insoluble properties by using the coating method,
pressing the p-type organic semiconductor single crystal film against a convex portion of a stamp having the convex portion and a concave portion,
applying water or an aqueous solution to an interface between the third substrate and the p-type organic semiconductor single crystal film to transfer the p-type organic semiconductor single crystal film to the convex portion, and
pressing the p-type organic semiconductor single crystal film transferred to the convex portion against a fourth substrate to transfer the p-type organic semiconductor single crystal film to the fourth substrate to obtain a patterned p-type organic semiconductor single crystal layer, and
the fourth substrate is at least one of a gate insulating layer or S/D electrodes of the n-type structure, the protective layer, or a combination thereof.

Advantageous Effects of Invention

According to the present invention, a complementary semiconductor device that can be manufactured at a lower cost, has excellent long-term stability, has well-balanced operation between a p-type transistor and a n-type transistor, and operates at a high speed can be provided.

Brief Description of Drawings

FIG. 1 is a schematic cross-sectional view of a complementary semiconductor device having a bottom-gate top-contact/bottom-gate top-contact structure.
FIG. 2 is a schematic cross-sectional view of a complementary semiconductor device having a bottom-gate bottom-contact/bottom-gate top-contact structure.
FIG. 3 is a schematic cross-sectional view of a complementary semiconductor device having a top-gate top-contact/bottom-gate top-contact structure.
FIG. 4 is a schematic cross-sectional view of a complementary semiconductor device having a top-gate bottom-contact/bottom-gate top-contact structure.
FIG. 5 is a schematic cross-sectional view of a complementary semiconductor device having a bottom-gate top-contact/bottom-gate bottom-contact structure.
FIG. 6 is a schematic cross-sectional view of a complementary semiconductor device having a bottom-gate bottom-contact/bottom-gate bottom-contact structure.
FIG. 7 is a schematic cross-sectional view of a complementary semiconductor device having a top-gate top-contact/bottom-gate bottom-contact structure.

FIG. 8 is a schematic cross-sectional view of a complementary semiconductor device having a top-gate bottom-contact/bottom-gate bottom-contact structure.

FIG. 9 is a schematic cross-sectional view of a complementary semiconductor device having a bottom-gate top-contact/top-gate top-contact structure.

FIG. 10 is a schematic cross-sectional view of a complementary semiconductor device having a bottom-gate bottom-contact/top-gate top-contact structure.

FIG. 11 is a schematic cross-sectional view of a complementary semiconductor device having a top-gate top-contact/top-gate top-contact structure.

FIG. 12 is a schematic cross-sectional view of a complementary semiconductor device having a top-gate bottom-contact/top-gate top-contact structure.

FIG. 13 is a schematic cross-sectional view of a complementary semiconductor device in which a top gate electrode of an n-type structure and a bottom gate electrode of a p-type structure are shared, and a protective layer and a p-type gate insulating layer are shared.

FIG. 14 is a schematic cross-sectional view of a complementary semiconductor device having a bottom-gate top-contact/top-gate bottom-contact structure.

FIG. 15 is a schematic cross-sectional view of a complementary semiconductor device having a bottom-gate bottom-contact/top-gate bottom-contact structure.

FIG. 16 is a schematic cross-sectional view of a complementary semiconductor device having a top-gate top-contact/top-gate bottom-contact structure.

FIG. 17 is a schematic cross-sectional view of a complementary semiconductor device having a top-gate bottom-contact/top-gate bottom-contact structure.

FIG. 18 is a schematic cross-sectional view of a complementary semiconductor device having a bottom-gate top-contact/bottom-gate top-contact structure.

FIG. 19 is a schematic cross-sectional view of a complementary semiconductor device having a bottom-gate top-contact/top-gate top-contact structure.

FIG. 20 is a schematic cross-sectional view of a complementary semiconductor device having a bottom-gate top-contact/bottom-gate bottom-contact structure.

FIG. 21 is a schematic cross-sectional view of a complementary semiconductor device having a bottom-gate top-contact/top-gate bottom-contact structure.

FIG. 22 is a schematic cross-sectional view of a complementary semiconductor device in which a protective layer and a p-type gate insulating layer are shared.

FIG. 23 is a schematic cross-sectional view of a complementary semiconductor device having a bottom-gate bottom-contact/bottom-gate top-contact structure.

FIG. 24 is a schematic cross-sectional view of a complementary semiconductor device having a bottom-gate bottom-contact/top-gate top-contact structure.

FIG. 25 is a schematic cross-sectional view of a complementary semiconductor device having a bottom-gate bottom-contact/bottom-gate bottom-contact structure.

FIG. 26 is a schematic cross-sectional view of a complementary semiconductor device having a bottom-gate bottom-contact/top-gate bottom-contact structure.

FIG. 27 is a schematic cross-sectional view of a complementary semiconductor device having a top-gate top-contact/bottom-gate top-contact structure.

FIG. 28 is a schematic cross-sectional view of a complementary semiconductor device having a top-gate top-contact/top-gate top-contact structure.

FIG. 29 is a schematic cross-sectional view of a complementary semiconductor device having a top-gate top-contact/bottom-gate bottom-contact structure.

FIG. 30 is a schematic cross-sectional view of a complementary semiconductor device having a top-gate top-contact/top-gate bottom-contact structure.

FIG. 31 is a schematic cross-sectional view of a complementary semiconductor device in which a protective layer and a gate insulating layer of a p-type structure are shared.

FIG. 32 is a top-gate bottom-contact/bottom-gate top-contact structure

FIG. 33 is a top-gate bottom-contact/top-gate top-contact structure

FIG. 34 is a top-gate bottom-contact/bottom-gate bottom-contact structure

FIG. 35 is a top-gate bottom-contact/top-gate bottom-contact structure

FIG. 36 is a schematic view illustrating a method for preparing a precursor solution of an amorphous metal oxide inorganic semiconductor (AOS) by using a sol-gel method.

FIG. 37 is a schematic view illustrating a method for forming an AOS layer by using a spin coating method.

FIG. 38 is a schematic view illustrating a patterning operation using a photoradical initiator and a sodium carbonate

developer.

FIG. 39 is a schematic view illustrating a method for forming source/drain electrodes (S/D electrodes) on the AOS layer by vapor deposition.

FIG. 40 is a schematic view of an example of an n-type TFT including the AOS layer in which the S/D electrodes are formed.

FIG. 41 is a schematic cross-sectional view of a fabricated hybrid complementary semiconductor device.

FIG. 42 is a perspective view schematically illustrating the fabricated hybrid complementary semiconductor device.

FIG. 43 illustrates appearance photographs of organic/inorganic hybrid complementary semiconductor devices obtained in an example.

FIG. 44 is a graph showing a summary of output characteristics of a drain current with respect to a drain voltage when a gate voltage is changed from 0 V to -10 V in steps of -2 V and from 0 V to 10 V in steps of 2 V

FIG. 45 illustrates graphs showing a transfer characteristic of a drain current with respect to a gate voltage of a p-type organic TFT and a transfer characteristic of a drain current with respect to a gate voltage of an n-type inorganic TFT.

FIG. 46 is a circuit diagram of an organic-inorganic hybrid complementary semiconductor inverter single element.

FIG. 47 is output characteristics of an output voltage when an input voltage is changed from 0 V to 10 V

FIG. 48 is a graph showing an evaluation of a cause of a voltage amplification effect during switching.

FIG. 49 is a graph showing a relationship between the input voltage and a supply current.

FIG. 50 is a graph showing an evaluation of a noise margin.

FIG. 51 is a graph showing an evaluation of initial characteristics measured immediately after fabrication of the hybrid complementary semiconductor device and characteristics after being left in the air atmosphere for five months.

FIG. 52 illustrates an appearance photograph of a hybrid complementary semiconductor device formed on a polyimide substrate peeled off from a glass supporter by using a laser lift-off (LLO) method.

FIG. 53 is a schematic view of a state in which the hybrid complementary semiconductor device formed on the polyimide substrate is bent.

FIG. 54 is a graph showing voltage transfer curve (VTC) characteristics of a hybrid complementary semiconductor device including an organic TFT and an inorganic TFT before and after LLO treatment (before and after peeling off).

FIG. 55 illustrates an appearance photograph in which the hybrid complementary semiconductor device formed on the polyimide substrate is wound around a surface of a glass cylinder, and a graph showing output characteristics in a case where the hybrid complementary semiconductor device including the organic TFT and the inorganic TFT is disposed on each surface of cylinders having different curvatures.

FIG. 56 illustrates an appearance photograph, a circuit diagram, and an enlarged appearance photograph of a portion surrounded by a square, of a ring oscillator.

FIG. 57 is a graph showing an evaluation of inverter characteristics of a single hybrid complementary semiconductor device when $V_{DD}$ is 10 V

FIG. 58 is a graph showing a measured output voltage of the ring oscillator when $V_{DD}$ is 10 V

FIG. 59 illustrates measurement results of angle-resolved XPS of O1s.

FIG. 60 is a graph showing angle dependence of a ratio ($\eta_{M\text{-}O\text{-}M}$) of M-O-M (in a metal oxide state) to the entire O1s.

FIG. 61 is a graph showing a relationship between a precursor solution concentration and a thickness of the formed AOS layer.

FIG. 62 is a graph showing a relationship between the gate voltage and the drain current of the TFT with changing the thickness of the AOS layer.

FIG. 63 is a graph showing characteristics of transistors fabricated using IZO thin films fabricated by sintering at different temperatures of 350°C, 370°C, and 390°C.

FIG. 64 is each of XRD measurement results of the IZO thin films obtained at a respective one of the sintering temperatures.

FIG. 65 is each of total reflection FT-IR measurement results of the IZO thin films obtained at a respective one of the sintering temperatures.

FIG. 66 illustrates schematic views of a measurement method of angle-resolved XPS.

FIG. 67 illustrates schematic cross-sectional views each illustrating a distribution of oxygen deficiency states depending on the thickness of the AOS film.

FIG. 68 is a graph showing thickness dependence of a ratio of each bonding species to the entire O1s on the thickness of the AOS film from the substrate toward the outermost surface.

FIG. 69 illustrates an atomic force microscope (AFM) image and a measurement result of the X-ray reflectivity method of the IZO thin film before heat treatment.

FIG. 70 illustrates an AFM image and a measurement result of the X-ray reflectivity method of the IZO thin film after the heat treatment.

Description of Embodiments

The present disclosure is directed to an inorganic/organic hybrid complementary semiconductor device including a substrate, a p-type organic semiconductor single crystal layer, an n-type amorphous metal oxide inorganic semiconductor layer between the substrate and the p-type organic semiconductor single crystal layer, and a protective layer between the p-type organic semiconductor single crystal layer and the n-type amorphous metal oxide inorganic semiconductor layer, in which, when viewed from a direction perpendicular to a main surface of the p-type organic semiconductor single crystal layer, the p-type organic semiconductor single crystal layer is disposed and thus at least a part of the p-type organic semiconductor single crystal layer overlaps the n-type amorphous metal oxide inorganic semiconductor layer or the p-type organic semiconductor single crystal layer does not overlap the n-type amorphous metal oxide inorganic semiconductor layer, a distance between the p-type organic semiconductor single crystal layer and the n-type amorphous metal oxide inorganic semiconductor layer is 1 mm or less, and the n-type amorphous metal oxide inorganic semiconductor layer has a distribution of an oxygen defect amount in a thickness direction in which the oxygen defect amount is larger on the p-type organic semiconductor single crystal layer side than on the substrate side.

The inorganic/organic hybrid complementary semiconductor device of the present disclosure (hereinafter, also referred to as a complementary semiconductor device) includes an amorphous metal oxide inorganic semiconductor layer (hereinafter, also referred to as an AOS layer) and an organic semiconductor single crystal layer formed under air atmosphere by using a solution process. Therefore, in the manufacture of the complementary semiconductor device of the present disclosure, a special apparatus such as a high vacuum chamber used in dry process is not required, and the manufacturing cost can be reduced as compared with the related art. In particular, in a case where a large area is to be achieved, increase in the size of the special apparatus such as the high vacuum chamber is not required, and the cost reduction effect is further increased as compared with the dry process.

The complementary semiconductor device of the present disclosure has also excellent long-term stability, and can exhibit substantially the same characteristics before and after being left to stand under air atmosphere for five months.

Since the p-type transistor is made of the organic semiconductor single crystal and the n-type transistor is made of the AOS, the operations of the p-type transistor and the n-type transistor are well-balanced, and the complementary semiconductor device of the present disclosure can operate at a high speed.

Since the AOS layer is formed by the solution process, oxygen deficiency occurs on the surface of the AOS layer, and as schematically illustrated in FIG. 67, the AOS layer has a distribution of the oxygen defect amount in the thickness direction of the AOS layer (direction perpendicular to the main surface). That is, the state of the oxygen deficiency is different between the substrate side and the surface side of the AOS layer. In the complementary semiconductor device, the AOS layer has the distribution of the oxygen defect amount in the thickness direction in which the oxygen defect amount on the organic semiconductor single crystal layer side is large.

Therefore, the AOS layer formed by a solvolysis method operates particularly well when the thickness is preferably from 4 nm to 7 nm, more preferably from 5 nm to 6 nm. Surface oxygen deficiency is exploited to maximize device performance. An AOS film formed by the dry process such as sputtering does not have such a distribution of oxygen deficiency states. A film thickness of the AOS layer can be adjusted by, for example, changing a metal ion concentration in a precursor solution.

The distribution of the oxygen defect amount of the AOS layer in the thickness direction can be evaluated by measuring an angle dependence of a ratio ($\eta_{M\text{-}O\text{-}M}$) of M-O-M (in a metal oxide state) to the entire O1s by angle-resolved X-ray photoelectron spectroscopy (XPS). In the AOS layer having the distribution of the oxygen defect amount in the thickness direction, the closer to the outermost surface of the AOS layer, the less M-O-M (M: In or Zn) bonds.

As illustrated in FIG. 66, the angle-resolved XPS is a method for detecting chemical species in a range from a surface of a measurement target film to a predetermined depth (information depth $d_{inf}$) represented by the following equations 1 and 2:

[Equation 1]

$$I_{(d)} = I_0 e^{-\frac{d}{\lambda}} \quad (1)$$

, where $I_0$ is an incident electron intensity, $I_{(d)}$ is effective intensity at a depth d from a surface, $\lambda$ is an inelastic mean free path of electrons in a solid (estimated to be about 2.8 nm under the present measurement condition), and $3\lambda$ is an escape depth ($I_{(d)}$ to $I_0 \times 5\%$), and

[Equation 2]

$$d = \frac{d_{inf}}{\cos\theta_{sub}} \qquad (2)$$

, where d is a depth from the surface, $d_{inf}$ is a detection depth (information depth), and $\theta_{sub}$ is a tilt angle of the substrate, by changing an angle (inclination angle $\theta$) with respect to an XPS detector (analyzer) with reference (0°) to a direction perpendicular to a surface of a measurement sample. The inclination angle $\theta$ can be set in a range from 0° to less than 90°, and preferably from 0° to 70°.

In the AOS layer, a ratio of $\eta_{M\text{-}O\text{-}M}$ of the outermost surface to $\eta_{M\text{-}O\text{-}M}$ of the inside is preferably smaller by 10% or more, more preferably smaller by 15% or more, and still more preferably smaller by 20% or more.

The AOS layer preferably has an area of 0.0025 $mm^2$ or greater, more preferably 0.005 $mm^2$ or greater, still more preferably 0.5 $mm^2$ or greater, and yet still more preferably 2.0 $mm^2$ or greater.

The AOS layer exhibits a mobility of preferably 0.5 $cm^2/V\cdot s$ or greater, more preferably 3.0 $cm^2/V\cdot s$ or greater, still more preferably 5.0 $cm^2/V\cdot s$ or greater, yet still more preferably 7.5 $cm^2/V\cdot s$ or greater, yet still more preferably 10 $cm^2/V\cdot s$ or greater. The mobility of the AOS layer can be calculated from the measurement result of an organic field effect transistor.

The type of the inorganic semiconductor constituting the AOS layer is not particularly limited, and for example, ZnO, $In_2O_3$, In-Zn-O (IZO), In-Ga-Zn-O (IGZO), or the like may be used.

Whether the AOS layer is amorphous can be confirmed by thin film X-ray diffraction.

The average film thickness of the organic semiconductor single crystal layer is preferably from 2 nm to 100 nm and more preferably from 4 nm to 20 nm. The upper limit of the average film thickness of the organic semiconductor single crystal layer may be 18 nm or less, 16 nm or less, 14 nm or less, 12 nm or less, 10 nm or less, or 8 nm or less. When the average film thickness of the organic semiconductor single crystal layer is in the above range, good device characteristics can be obtained. The average film thickness of the organic semiconductor single crystal layer can be measured using a stylus type surface profile measuring instrument or an atomic force microscope.

The organic semiconductor single crystal layer has preferably from 1 molecular layer to 50 molecular layers, more preferably from 1 molecular layer to 10 molecular layers, still more preferably from 1 molecular layer to 5 molecular layers, even still more preferably from 1 molecular layer to 4 molecular layers, even still more preferably from 1 molecular layer to 3 molecular layers, and even still more preferably from 1 molecular layer to 2 molecular layers in the thickness direction. The organic semiconductor single crystal layer has most preferably 1 molecular layer, but may have 2 or more molecular layers in the thickness direction. The number of molecular layers of the organic semiconductor single crystal layer can be measured by the atomic force microscope.

The film thickness of 1 molecular layer of the organic semiconductor single crystal layer is preferably from 2 nm to 6 nm and more preferably from 2 nm to 4 nm. The thickness of 1 molecular layer of the organic semiconductor single crystal layer can be measured by combining single crystal X-ray structure analysis and atomic force microscope observation.

The organic semiconductor single crystal layer is composed of a single domain or a multi domain, and is preferably composed of the single domain. The domain of the organic semiconductor single crystal layer can be measured by single crystal X-ray diffraction. The organic semiconductor single crystal layer has the single domain having a continuous area of preferably 0.0025 $mm^2$ or greater, more preferably 0.005 $mm^2$ or greater, still more preferably 0.5 $mm^2$ or greater, and yet still more preferably 2.0 $mm^2$ or greater. The area of the single domain of the organic semiconductor single crystal layer may be the same as the above-described preferable area of the AOS. The area of the organic semiconductor single crystal layer may be the same as the area of the single domain.

It should be understood that a separated organic semiconductor single crystal layer including the above-described single domain having the preferable continuous area may be incorporated in the organic semiconductor single crystal layer in the complementary semiconductor device of the present disclosure. For example, the organic semiconductor single crystal layer including the above-described single domain having the preferable continuous area may be separated into a plurality of pieces of the organic semiconductor single crystal layers and incorporated into the organic semiconductor device, and/or an unnecessary portion of the organic semiconductor single crystal layer including the above-described single domain having the preferable continuous area may be etched by photolithography or the like to be separated into the plurality of pieces of the organic semiconductor single crystal layers and incorporated into the complementary semiconductor device. Each organic semiconductor single crystal layer is separated in the complementary semiconductor device, and thus it can be electrically isolated from other elements. The fact that each separated

organic semiconductor single crystal layer is obtained from a single crystal film having an aligned crystal axis direction can be confirmed by measurement by the single crystal X-ray diffraction, electron diffraction, or an observation with a polarizing microscope.

The organic semiconductor single crystal layer exhibits a mobility of preferably 0.5 $cm^2/V \cdot s$ or greater, more preferably 3.0 $cm^2/V \cdot s$ or greater, still more preferably 5.0 $cm^2/V \cdot s$ or greater, yet still more preferably 7.5 $cm^2/V \cdot s$ or greater, yet still more preferably 10 $cm^2/V \cdot s$ or greater. The mobility of the organic semiconductor single crystal layer can be calculated from the measurement result of the organic field effect transistor.

The type of the organic semiconductor constituting the organic semiconductor single crystal layer is not particularly limited, and for example, a polycyclic aromatic compound having four or more rings or a polycyclic compound having four or more rings includingl one or more unsaturated five-membered heterocyclic compounds and a plurality of benzene rings may be used.

The organic semiconductor constituting the organic semiconductor single crystal layer is preferably a material having a high self-condensation function, and examples thereof include a p-type organic semiconductor Cn-DNBDT-NW of the following Formula (1) exhibiting high mobility.

[Chem. 1]

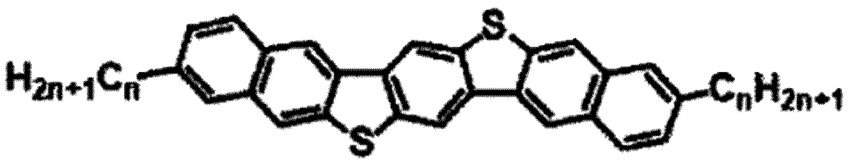

(1)

In the Formula (1), n may be from 1 to 14. The self-condensation function means a tendency of molecules to spontaneously aggregate and crystallize easily when the molecules are precipitated from a solvent.

Other examples of the organic semiconductor constituting the organic semiconductor single crystal layer are illustrated in the following Formulas (2) to (5).

[Chem. 2]

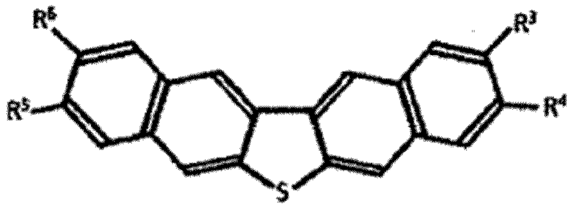

(II)

(2)

In the Formula (2), each of R3, R4, R5, and R6 is independently a hydrogen atom or an alkyl group containing from 1 to 14 carbons. The alkyl group may contain a hetero atom (typically selected from an oxygen atom and a sulfur atom), and a hydrogen atom in the alkyl group may be substituted with a substituent such as a halogen atom. For reasons of self-aggregation capacity, it is preferable that R4 = R5, and it is preferable that R3 = R6. From the viewpoint of solubility, R4 and R5 are preferably hydrogen atoms and each of R3 and R6 is independently an alkyl group containing from 1 to 14 carbons, or R3 and R6 are hydrogen atoms and each of R4 and R5 is independently an alkyl group containing from 1 to 14 carbons. More preferably, R3 and R6 are hydrogen atoms, and each of R4 and R5 is independently an alkyl group containing from 1 to 14 carbons. For reasons of self-aggregation capacity, the number of carbons of the alkyl group is preferably from 4 to 12, and more preferably from 6 to 10.

[Chem. 3]

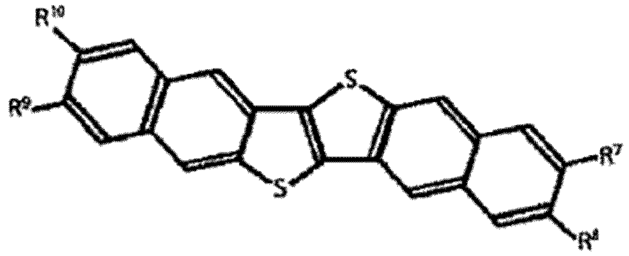

(3)

In the Formula (3), each of R7, R8, R9, and R10 is independently a hydrogen atom or an alkyl group containing from 1 to 14 carbons. The alkyl group may contain a hetero atom (typically selected from an oxygen atom and a sulfur atom), and a hydrogen atom in the alkyl group may be substituted with a substituent such as a halogen atom. For reasons of self-aggregation capacity, it is preferable that R7 = R9, and it is preferable that R8 = R10. From the viewpoint of solubility, R7 and R9 are preferably hydrogen atoms and each of R8 and R10 is independently an alkyl group containing from 1 to 14 carbons, or R8 and R10 are hydrogen atoms and each of R7 and R9 is independently an alkyl group containing from 1 to 14 carbons. More preferably, R8 and R10 are hydrogen atoms, and each of R7 and R9 is independently an alkyl group containing from 1 to 14 carbons. For reasons of self-aggregation capacity, the number of carbons of the alkyl group is preferably from 6 to 13, and more preferably from 8 to 10.

[Chem. 4]

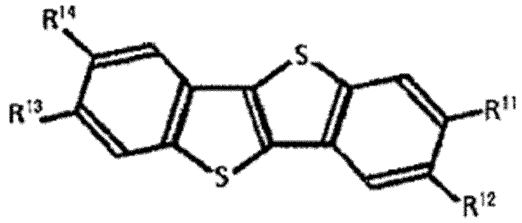

(4)

In the Formula (4), each of R11, R12, R13, and R14 is independently a hydrogen atom or an alkyl group containing from 1 to 14 carbons. The alkyl group may contain a hetero atom (typically selected from an oxygen atom and a sulfur atom), and a hydrogen atom in the alkyl group may be substituted with a substituent such as a halogen atom. For reasons of self-aggregation capacity, it is preferable that R11 = R13, and it is preferable that R12 = R14. From the viewpoint of solubility, R11 and R13 are preferably hydrogen atoms and each of R12 and R14 is independently an alkyl group containing from 1 to 14 carbons, or R12 and R14 are hydrogen atoms and each of R11 and R13 is independently an alkyl group containing from 1 to 14 carbons. More preferably, R12 and R14 are hydrogen atoms, and each of R11 and R13 is independently an alkyl group containing from 1 to 14 carbons. For reasons of self-aggregation capacity, the number of carbons of the alkyl group is preferably from 5 to 12, and more preferably from 8 to 10.

[Chem. 5]

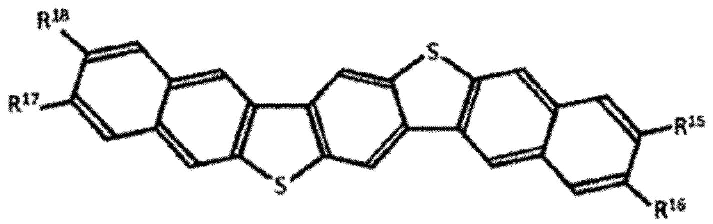

(5)

In the Formula (5), each of R15, R16, R17, and R18 is independently a hydrogen atom or an alkyl group containing from 1 to 14 carbons. The alkyl group may contain a hetero atom (typically selected from an oxygen atom and a sulfur atom), and a hydrogen atom in the alkyl group may be substituted with a substituent such as a halogen atom. For reasons of self-aggregation capacity, it is preferable that R15 = R17, and it is preferable that R16 = R18. From

the viewpoint of solubility, R16 and R18 are preferably hydrogen atoms and each of R15 and R17 is independently an alkyl group containing from 1 to 14 carbons, or R15 and R17 are hydrogen atoms and each of R16 and R18 is independently an alkyl group containing from 1 to 14 carbons. More preferably, R16 and R18 are hydrogen atoms, and each of R15 and R17 is independently an alkyl group containing from 1 to 14 carbons. For reasons of self-aggregation capacity, the number of carbons of the alkyl group is preferably from 5 to 12, and more preferably from 8 to 10.

Still other examples of the organic semiconductor constituting the organic semiconductor single crystal layer are illustrated in the following Formulas (6) to (15). In the Formulas (6) to (15), linear alkyl, branched alkyl, cyclic alkyl, fluorinated linear and branched alkyl, triisopropylsilylethynyl, phenyl, and the like can be used as R.

[Chem. 6]

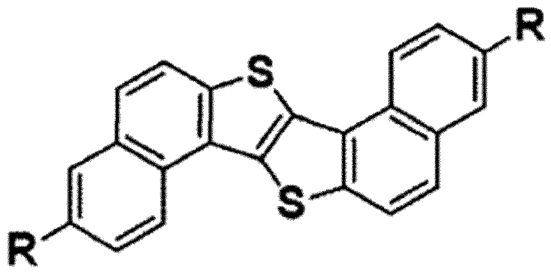

(6)

[Chem. 7]

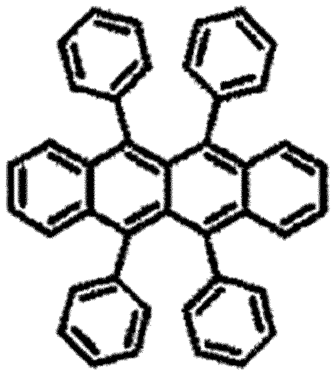

(7)

[Chem. 8]

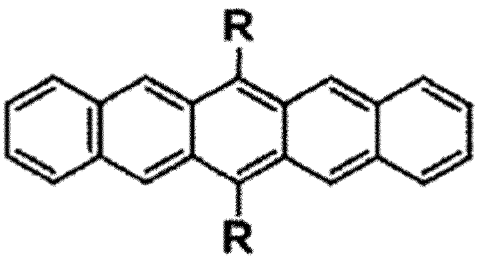

(8)

[Chem. 9]

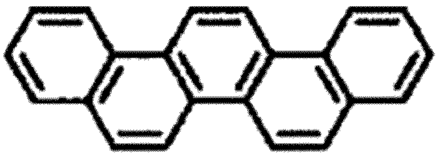

(9)

[Chem. 10]

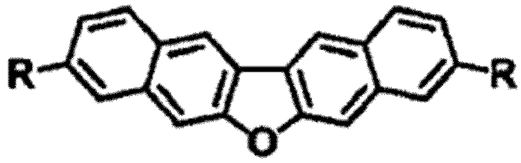

(10)

[Chem. 11]

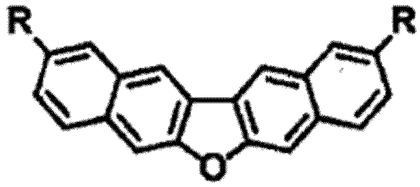

(11)

[Chem. 12]

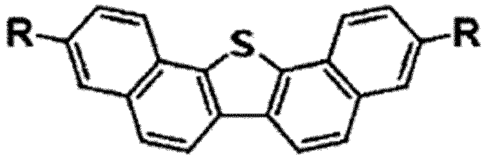

(12)

[Chem. 13]

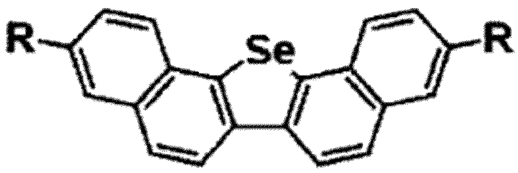

(13)

[Chem. 14]

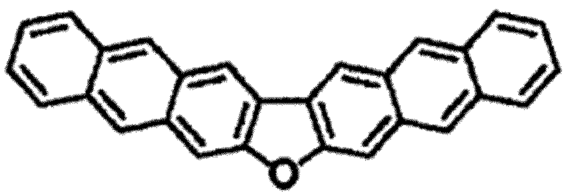

(14)

[Chem. 15]

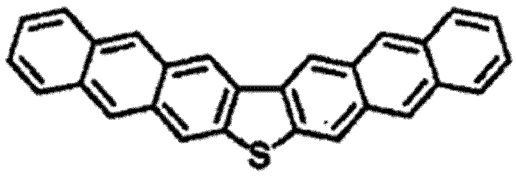

(15)

Whether the organic semiconductor single crystal layer is a single crystal can be confirmed by observation with a transmission electron microscope (TEM).

The substrate used in the complementary semiconductor device of the present disclosure may be a substrate typically used in semiconductor process, a flexible substrate, or the like, and is preferably the flexible substrate. The flexible substrate is a film-like substrate, and is preferably a polyimide substrate, a polyphenylene sulfide substrate, or a silicone substrate. The thickness of the substrate is preferably from 0.001 mm to 1 mm, and more preferably from 0.002 mm to 0.1 mm. By using the flexible substrate, even in a state where the complementary semiconductor device of the present disclosure is strained to a strain $\varepsilon$ of preferably 0.03% or greater, more preferably 0.04% or greater, and still more preferably 0.08% or greater, the complementary semiconductor device of the present disclosure can exhibit substantially the same characteristics as those in a state where there is no strain. The strain $\varepsilon$(%) is approximated by $\varepsilon = h_s/2R \times 100$, where $h_s$ is the thickness of the substrate on which the complementary semiconductor device is disposed and R is a bend radius. For example, when a complementary semiconductor device having a thickness of 200 nm disposed on a polyimide substrate having a thickness of 10 $\mu$m is wound around a glass cylinder having a radius of 6 mm, the strain $\varepsilon$ (%) is calculated as strain $\varepsilon(\%) = 10\ \mu m/(2 \times 6\ mm) \times 100$.

A distance between the organic semiconductor single crystal layer and the AOS layer is 1 mm or less, preferably 0.8 mm or less, more preferably 0.5 mm or less, still more preferably 0.3 mm or less, even still more preferably 0.1 mm or less. The distance between the organic semiconductor single crystal layer and the AOS layer refers to the shortest distance between the organic semiconductor single crystal layer and the AOS layer. When the distance between the organic semiconductor single crystal layer and the AOS layer is within the above range, the complementary semiconductor device can operate at a high speed and the complementary semiconductor device can be highly integrated. When viewed from a direction perpendicular to a main surface of the p-type organic semiconductor single crystal layer, when at least a part of the p-type organic semiconductor single crystal layer overlaps the n-type amorphous oxide inorganic semiconductor layer, the distance between the organic semiconductor single crystal layer and the AOS layer corresponds to a thickness of an intermediate layer of the complementary semiconductor device as illustrated in FIG. 1. When the p-type organic semiconductor single crystal layer is disposed so as not to overlap the n-type amorphous oxide inorganic semiconductor layer, the distance between the organic semiconductor single crystal layer and the AOS layer corresponds to a distance between an end portion of the organic semiconductor single crystal layer and an end portion of the AOS layer as illustrated in FIG. 18.

A protective layer is disposed between the AOS layer and the organic semiconductor single crystal layer. The protective layer may be or need not be adjacent to the AOS layer, but is preferably adjacent to the AOS layer. The protective layer may be or need not be adjacent to the organic semiconductor single crystal layer. The protective layer can protect the AOS layer from being affected by the manufacturing process of the complementary semiconductor device. The protective layer can also prevent components such as water, oxygen, or the like in the air atmosphere from reacting with the AOS layer. As a result, the deterioration of the AOS layer can be prevented and the long-term stability of the complementary semiconductor device can be improved. The protective layer may be disposed parallel to the main surface of the AOS layer, but in addition may also be disposed to protect an end surface of the AOS layer.

The thickness of the protective layer is preferably 1000 nm or less, more preferably 500 nm or less, still more preferably 250 nm or less, even still more preferably 100 nm or less, and even still more preferably 75 nm or less. The lower limit of the thickness of the protective layer is preferably 25 nm or greater. The thinner the thickness of the protective layer, the easier the protective layer having excellent surface flatness is formed, and deterioration in characteristics of the complementary semiconductor device can be suppressed. When the lower limit of the thickness of the protective layer is within the above range, a better barrier function can be obtained.

The protective layer preferably includes a first organic film and a second organic film, the first organic film is located on the n-type amorphous metal oxide inorganic semiconductor layer side, and the second organic film is located on the p-type organic semiconductor single crystal layer side, and the first organic film contains an organic solvent soluble polymer, and the second organic film is a vacuum deposited film.

The organic solvent soluble polymer means a polymer which is soluble in an organic solvent and examples thereof includes those that are polymers or oligomers when dissolved in the organic solvent. The organic solvent is a

solvent which can dissolve the organic solvent soluble polymer but does not dissolve the AOS layer, and examples thereof include butyl acetate, toluene, xylene, and acetonitrile.

The first organic film composed of the organic solvent soluble polymer can be formed on the AOS layer by a mild method such as solution process without damaging the AOS layer. Since the solution process does not use vacuum or radical reaction, further formation of oxygen defects due to desorption of oxygen can be avoided, and there is an advantage of very low or no reactivity with the AOS layer. In the solution process, there is also no reaction in which acid is generated. Therefore, the first organic film can be formed directly on the AOS layer without substantially damaging the AOS layer. Since the second organic film which is a vacuum deposited film is formed on the first organic film, damage to the AOS layer due to vacuum process can be suppressed.

A chemical vapor deposition film (vacuum deposited film) such as parylene can be formed by a chemical vapor deposition (CVD) method which does not need heating of the substrate. However, since the AOS layer has extremely high environmental sensitivity, the AOS layer is easily damaged by a vacuum environment and generated radicals during formation of the vacuum deposited film.

On the other hand, when the first organic film containing the organic solvent soluble polymer is formed on the AOS layer by the solution process, the first organic film can be disposed without substantially damaging the AOS layer.

The first organic film can protect the AOS layer from the radicals generated during the formation of the vacuum deposited film and the vacuum environment. Therefore, the second organic film can be formed on the first organic film without substantially damaging the AOS layer. Since the first organic film has a low density, the first organic film has low gas barrier performance and allows oxygen to pass through the first organic film to some extent. The density of the first organic film is preferably from 0.4 g/cm$^3$ to 1.3 g/cm$^3$, more preferably from 0.5 g/cm$^3$ to 1.2 g/cm$^3$, still more preferably 0.6 g/cm$^3$ to 1.1 g/cm$^3$, and even still more preferably from 0.7 g/cm$^3$ to 1.0 g/cm$^3$. On the other hand, since the second organic film having a relatively high density is located on the first organic film, moisture and oxygen cannot substantially pass through the protective layer. The density of the first organic film is calculated from X-ray reflectivity measurement. By fitting the X-ray reflectivity data, the film thickness and the film density can be simultaneously estimated as fitting parameters.

Unlike the first organic film formed by the solution process, the second organic film which is the vacuum deposited film is formed by the dry process. Therefore, the second organic film is dense and has a high barrier effect. The density of the second organic film composed of the vacuum deposited film is higher than the density of the first organic film containing the organic solvent soluble polymer. The density of the second organic film is preferably from 1.0 g/cm$^3$ to 1.5 g/cm$^3$, and more preferably from 1.0 g/cm$^3$ to 1.45 g/cm$^3$. The density of the second organic film is measured by ASTM D1505 or ASTM E1461.

The protective layer may have any shape, and may be a protective film, a protective sheet, or the like.

The first organic film preferably has a thickness of 10 nm or greater, more preferably 13 nm or greater, and still more preferably 16 nm or greater. When the first organic film has the above-described preferable thickness, damage to the AOS layer due to the vacuum process and generated radicals during vacuum deposition of the second organic film can be further suppressed. The upper limit of the thickness of the first organic film is not particularly limited, and may be, for example, 1 mm or less. However, to avoid increasing the total thickness of the complementary semiconductor device, the thickness of the first organic film is preferably small, and may be preferably 1000 nm or less, more preferably 500 nm or less, and may be 100 nm or less, 50 nm or less, or 30 nm or less.

The second organic film preferably has a thickness from 100 nm to 300 nm, more preferably from 120 nm to 200 nm. When the second organic film which is the vacuum deposited film has the above-described preferable thickness, damage to the AOS layer due to the manufacturing process of the complementary semiconductor device and damage to the AOS layer due to exposure of the complementary semiconductor device to the atmosphere for a long period of time can be further suppressed. Although the vacuum deposited film is a relatively hard polymer film, when the upper limit of the thickness of the second organic film is in the above-described preferable range, the influence on flexibility when the complementary semiconductor device is formed on the flexible substrate can be reduced.

The organic solvent soluble polymer is preferably an acrylic polymer, a styrenic polymer, a fluorine-based polymer, a thermally crosslinkable polymer, or a combination thereof.

The acrylic polymer is preferably polymethyl methacrylate (PMMA), polyadamantyl methacrylate (PADMA), or polycyclohexyl methacrylate (PCMA).

The styrenic polymer is preferably polystyrene, poly-$\alpha$-methylstyrene (P$\alpha$MS), poly-4-methylstyrene (PMS), or polyvinylphenol (PVP).

The fluorine-based polymer is preferably CYTOP (registered trademark) or Teflon (registered trademark) AF.

The thermally crosslinkable polymer is preferably an epoxy resin or a thermally curable cycloolefin polymer.

The vacuum deposited film is preferably parylene. Parylene is sequentially formed at around room temperature, and thus is preferable in terms of high denseness and uniformity. Parylene also includes derivatives thereof.

The protective layer is not limited to the above-described configuration, and may be a protective layer (hereinafter referred to as a second protective layer) preferably including the first organic film and an inorganic oxide insulator film.

In the second protective layer, the first organic film is located on the n-type amorphous metal oxide inorganic semiconductor layer side, and the inorganic oxide insulator film is located on the p-type organic semiconductor single crystal layer side. When the first organic film is present between the AOS layer and the inorganic oxide insulator film, damage to the AOS layer during the formation of the inorganic oxide insulator film can be suppressed.

The first organic film has the same configuration as that of the first organic film described above, and is preferably 50 nm or greater, more preferably 75 nm or greater, and still more preferably 100 nm or greater. When the first organic film has the above-described preferable thickness, damage to the AOS layer during formation of the inorganic oxide insulator film can be further suppressed.

When the inorganic oxide insulator film such as an AlOx layer is directly formed on the AOS layer by using an atomic layer deposition (ALD) method, the AOS is deteriorated because the ALD method is a process in which the substrate is heated under vacuum and which is mediated by water. When the inorganic oxide insulator film is directly formed on the AOS layer by using sputtering, the AOS is deteriorated because the sputtering is vacuum process.

The first organic film can protect the AOS layer from moisture associated with the ALD method or the vacuum environment of the sputtering process. Therefore, the inorganic oxide insulator film can be formed on the first organic film without substantially damaging the AOS layer. Since the first organic film has a low density, the first organic film has low gas barrier performance and allows oxygen to pass through the first organic film to some extent. On the other hand, since the inorganic oxide insulator film having a dense structure is located on the first organic film, moisture and oxygen cannot substantially pass through the second protective layer.

Preferably, the protective layer further includes the second organic film which is the vacuum deposited film located between the first organic film and the inorganic oxide insulator film. When the second organic film which is the vacuum deposited film is located between the first organic film and the inorganic oxide insulator film, damage to the AOS layer during formation of the inorganic oxide insulator film can be further suppressed. The AOS layer can be protected from attack of radical due to the CVD process for forming the second organic film. When the second protective layer includes the second organic film, a preferable thickness of the first organic film may be thin, or may be 10 nm or greater.

The configuration of the second organic film has the same configuration of the second organic film described above, and a thickness of the second organic film in the second protective layer is preferably from 10 nm to 40 nm, and more preferably from 15 nm to 35 nm. Since the second organic film has a high density, the barrier effect can be obtained together with the inorganic oxide insulator even in the above-described preferable thickness range, and thus the total thickness of the second protective layer can be reduced.

In the second protective layer of a hybrid structure including the first organic film, the second organic film, and the inorganic oxide insulator film, the first organic film including the organic solvent soluble polymer and the second organic film which is the vacuum deposited film function as a buffer layer against damage due to the ALD process or the sputtering process during the formation of the inorganic oxide insulator film, and the inorganic oxide insulator film has a strong barrier effect.

The thickness of the inorganic oxide insulator film is preferably from 5 nm to 100 nm, more preferably from 15 nm to 75 nm, and still more preferably from 25 nm to 55 nm. Since the inorganic oxide insulator film has a further higher barrier effect than the second organic film composed of a polymer, the total thickness of the second protective layer can be reduced while exhibiting a good barrier effect in the above-described preferable thickness range. Since the inorganic oxide insulator film has the dense structure and is relatively hard, the thickness of the inorganic oxide insulator film is preferably 100 nm or less from the viewpoint of ensuring flexibility of the electronic element or electronic device including the second protective layer.

When the second protective layer includes the first organic film containing the organic solvent soluble polymer, the second organic film composed of the vacuum deposited film, and the inorganic oxide insulator film, the total thickness of the second protective layer is preferably 100 nm or less, more preferably 90 nm or less, and still more preferably 80 nm or less. When the second organic film composed of the vacuum deposited film is provided, the total thickness of the second protective layer can be reduced. The thickness of the second protective layer is preferably 25 nm or greater, and more preferably 40 nm or greater. When the thickness of the second protective layer is in the above-described preferable range, the thickness of the electronic element or electronic device provided with the second protective layer can be reduced while obtaining the good barrier function.

An inorganic oxide insulator of the inorganic oxide insulator film is preferably AlOx, HfOx, ZrOx, SiOx, TiOx, or a combination thereof. x may be a value satisfying the stoichiometric composition or may be a value not satisfying the stoichiometric composition. The inorganic oxide insulator film has a high density, and large molecules such as water molecules and oxygen in the air cannot pass through the inorganic oxide insulator film, and thus the inorganic oxide insulator film has a high barrier effect against moisture and gases.

The second protective layer preferably has a three layer hybrid structure of a PMMA layer as the first organic film, a parylene layer as the second organic film, and an AlOx layer as the inorganic oxide insulator film. The hybrid three layer protective layer of PMMA/parylene/AlOx can obtain strong protection without deteriorating the performance

of the AOS layer.

A gate insulating film, a gate electrode, and source/drain electrodes (S/D electrodes) may be made of a typically used material.

The complementary semiconductor device of the present disclosure includes a p-type structure and an n-type structure. Examples of the complementary semiconductor device will be described below in which the organic semiconductor single crystal layer is disposed and the organic semiconductor single crystal layer and the AOS layer completely overlap each other when viewed from the direction perpendicular to the main surface of the organic semiconductor single crystal layer.

When the n-type transistor has a bottom-gate top-contact structure, the p-type structure/n-type structure of the complementary semiconductor device may have a bottom-gate top-contact/bottom-gate top-contact structure in FIG. 1, a bottom-gate bottom-contact/bottom-gate top-contact structure in FIG. 2, a top-gate top-contact/bottom-gate top-contact structure in FIG. 3, or a top-gate bottom-contact/bottom-gate top-contact structure in FIG. 4. Referring to FIG. 1, a gate electrode 20 of an n-type structure, a gate insulating layer 22, an n-type amorphous metal oxide inorganic semiconductor layer 24, and S/D electrodes 26 are disposed on a substrate 10, and a gate electrode 40 of a p-type structure, a gate insulating layer 42, a p-type organic semiconductor single crystal layer 44, and S/D electrodes 46 are disposed with a protective layer 30 interposed therebetween.

When the n-type transistor has a bottom-gate bottom-contact structure, the p-type structure/n-type structure of the complementary semiconductor device may have a bottom-gate top-contact/bottom-gate bottom-contact structure in FIG. 5, a bottom-gate bottom-contact/bottom-gate bottom-contact structure in FIG. 6, a top-gate top-contact/bottom-gate bottom-contact structure in FIG. 7, or a top-gate bottom-contact/bottom-gate bottom-contact structure in FIG. 8.

When the n-type transistor has a top-gate top-contact structure, the p-type structure/n-type structure of the complementary semiconductor device may have a bottom-gate top-contact/top-gate top-contact structure in FIG. 9, a bottom-gate bottom-contact/top-gate top-contact structure in FIG. 10, a top-gate top-contact/top-gate top-contact structure in FIG. 11, or a top-gate bottom-contact/top-gate top-contact structure in FIG. 12. When the n-type structure has a top gate structure and the p-type structure has a bottom gate structure as in the structure in FIG. 9, the structure illustrated in FIG. 13 may be employed in which the top gate electrode of the n-type structure and the bottom gate electrode of the p-type structure are shared, and the protective layer and the p-type gate insulating layer are shared. The same applies to a structure in FIG. 10.

When the n-type transistor has a top-gate bottom-contact structure, the p-type structure/n-type structure of the complementary semiconductor device may have a bottom-gate top-contact/top-gate bottom-contact structure in FIG. 14, a bottom-gate bottom-contact/top-gate bottom-contact structure in FIG. 15, a top-gate top-contact/top-gate bottom-contact structure in FIG. 16, or a top-gate bottom-contact/top-gate bottom-contact structure in FIG. 17. When the n-type structure has the top gate structure and the p-type structure has the bottom gate structure as in the structures in FIGS. 14 and 15, the structure may be employed similar to FIG. 13 in which the top gate electrode of the n-type structure and the bottom gate electrode of the p-type structure are shared and the protective layer and the p-type gate insulating layer are shared.

Examples of the complementary semiconductor device will be described below in which the organic semiconductor single crystal layer is disposed and the organic semiconductor single crystal layer do not overlap the AOS layer when viewed from the direction perpendicular to the main surface of the organic semiconductor single crystal layer.

When the n-type transistor has the bottom-gate top-contact structure, the n-type structure/p-type structure of the complementary semiconductor device may have a bottom-gate top-contact/bottom-gate top-contact structure in FIG. 18, a bottom-gate top-contact/top-gate top-contact structure in FIG. 19, a bottom-gate top-contact/bottom-gate bottom-contact structure in FIG. 20, or a bottom-gate top-contact/top-gate bottom-contact structure in FIG. 21. When the n-type structure has the top contact structure and the p-type structure has the bottom gate structure as in FIG. 18, the structure illustrated in FIG. 22 may be employed in which the S/D electrodes of the n-type structure and the gate electrode of the p-type structure are made of the same material in the same layer, and the protective layer and the p-type gate insulating layer are shared. The same applies to a structure in FIG. 20.

When the n-type transistor has the bottom-gate bottom-contact structure, the n-type structure/p-type structure of the complementary semiconductor device may have a bottom-gate bottom-contact/bottom-gate top-contact structure in FIG. 23, a bottom-gate bottom-contact/top-gate top-contact structure in FIG. 24, a bottom-gate bottom-contact/bottom-gate bottom-contact structure in FIG. 25, or a bottom-gate bottom-contact/top-gate bottom-contact structure in FIG. 26.

When the n-type transistor has the top-gate top-contact structure, the n-type structure/p-type structure of the complementary semiconductor device may have a top-gate top-contact/bottom-gate top-contact structure in FIG. 27, a top-gate top-contact/top-gate top-contact structure in FIG. 28, a top-gate top-contact/bottom-gate bottom-contact structure in FIG. 29, or a top-gate top-contact/top-gate bottom-contact structure in FIG. 30. When the n-type structure has the top gate structure and the p-type structure has the bottom gate structure as in FIG. 27, the structure illustrated in FIG. 31 may be employed in which the gate electrode of the n-type structure and the gate electrode of the p-type structure are made of the same material in the same layer, and the protective layer and the p-type gate insulating layer are shared.

The same applies to a structure in FIG. 29.

When the n-type transistor has the top-gate bottom-contact structure, the n-type structure/p-type structure of the complementary semiconductor device may have a top-gate bottom-contact/bottom-gate top-contact structure in FIG. 32, a top-gate bottom-contact/top-gate top-contact structure in FIG. 33, a top-gate bottom-contact/bottom-gate bottom-contact structure in FIG. 34, or a top-gate bottom-contact/top-gate bottom-contact structure in FIG. 35. When the n-type structure has the top gate structure and the p-type structure has the bottom gate structure as in FIG. 32, the structure may be employed similar to FIG. 31 in which the protective layer and the p-type gate insulating layer are shared. The same applies to a structure in FIG. 33.

As illustrated in FIGS. 1 to 35, the AOS layer may be formed on the substrate, on the gate insulating layer, on the gate electrode, on the S/D electrodes, or on a combination thereof. The protective layer, the S/D electrodes, the gate insulating layer, the gate electrode, the organic semiconductor single crystal layer, or a combination thereof may be formed adjacent to each other on the AOS layer.

A method of the present disclosure is directed to a method for manufacturing an inorganic/organic hybrid complementary semiconductor device, the method including providing a substrate, forming an n-type structure on the substrate, forming a protective layer on the n-type structure, and forming a p-type structure on the protective layer, in which the forming the n-type structure includes preparing a precursor solution of an n-type amorphous metal oxide inorganic semiconductor containing a metal salt by using a sol-gel method, forming a precursor film by applying the precursor solution on the substrate, and forming an n-type amorphous metal oxide inorganic semiconductor layer by heat-treating the precursor film at 350°C to 400°C, the forming the p-type structure includes forming a p-type organic semiconductor single crystal layer by using a coating method, when viewed from a direction perpendicular to a main surface of the p-type organic semiconductor single crystal layer, the p-type organic semiconductor single crystal layer is disposed and thus at least a part of the p-type organic semiconductor single crystal layer overlaps the n-type amorphous metal oxide inorganic semiconductor layer or the p-type organic semiconductor single crystal layer does not overlap the n-type amorphous metal oxide inorganic semiconductor layer, a distance between the p-type organic semiconductor single crystal layer and the n-type amorphous metal oxide inorganic semiconductor layer is 1 mm or less, and the n-type amorphous metal oxide inorganic semiconductor layer has a distribution of an oxygen defect amount in a thickness direction in which the oxygen defect amount is larger on the p-type organic semiconductor single crystal layer side than on the substrate side. The n-type structure and the p-type structure may have the above-exemplified configurations of the n-type structure and the p-type structure, respectively, described with reference to FIGS. 1 to 35.

In the method of the present disclosure, the solution process is used as film forming process of the amorphous metal oxide inorganic semiconductor layer (AOS layer) and the organic semiconductor single crystal layer. Since the AOS layer and the organic semiconductor single crystal layer can be formed under air atmosphere by using the solution process, a special apparatus such as a high vacuum chamber used in the dry process is not required, and the organic semiconductor device can be manufactured at a lower cost. In particular, in a case where a large area is to be achieved, increase in the size of the special apparatus such as the high vacuum chamber is not required, and the cost reduction effect is further increased as compared with the dry process.

As the film forming process of the AOS layer, first, as illustrated in FIG. 36, a precursor solution of the AOS is prepared using a sol-gel method. A metal salt is dissolved in water or an organic solvent, and then hydrolyzed, and is condensed to form an M-O-M structure, and thus the precursor solution in which the precursor is solated is prepared. For example, when an IZO layer is formed as the AOS layer, indium nitrate and zinc nitrate are mixed to prepare the precursor solution. M in FIG. 36 is a metal cation element contained in the AOS, and examples thereof include metal elements such as In, Zn, Ga, Al, Sn, and Y R is an alkyl group. Examples of X include chloride salts, nitrate salts, and acetate salts. The solvent may be a solvent such as water, an aqueous solution, or alcohol in which oxygen can bond and crosslink to a metal ion, and may contain O and H, may contain C, and may further contain other elements such as N, F, and Cl. The solvent may be, for example, 2-methoxyethanol.

The precursor solution is then applied on the substrate to form a thin film of the precursor. An application method of the precursor solution is preferably a spin coating method, a bar coating method, a spray coating method, a dip coating method, an ink-jet method, a flexographic printing method, or a gravure printing method, more preferably the spin coating method, the bar coating method, the spray coating method, the dip coating method, or the ink-jet method, and still more preferably the spin coating method. FIG. 37 is a schematic view illustrating an embodiment in which the precursor solution is spin coated on the substrate to form the thin film of the precursor. The thin film of the precursor is subjected to soft bake (heat treatment) to remove the solvent and is subjected to hard bake (heat treatment), and thus a dense amorphous metal oxide inorganic semiconductor layer can be formed.

The spin coating method has advantages in terms of good reproducibility and high uniformity of an as-processed film in deposition of an active layer. The thin film formed by the spin coating method before the heat treatment contains a large amount of impurities such as nitrogen used in the preparation of the precursor solution and is completely different from the thin film obtained by the dry process. However, the impurities such as nitrogen are released as a gas by the heat treatment, and portions from which the impurities are released may be crosslinked by oxygen.

The soft bake for removing the solvent is preferably performed at 100°C to 150°C. When the heat treatment is performed at the above-described preferable temperature, the solvent can be more favorably removed.

The hard bake for firing is performed at 350°C to 400°C. When the heat treatment is performed at a low temperature of 400°C or less, even when the flexible substrate is included, the amorphous metal oxide inorganic semiconductor layer can be formed without damaging the flexible substrate. When the heat treatment temperature is high, the formation of the M-O-M structure is facilitated, and thus the crystallinity is increased, a shallow donor concentration is increased, and the mobility is improved. However, when the temperature is too high, a negative voltage shift of an on-state voltage ($V_{ON}$) or a high off-current is generated, and power consumption tends to increase. Therefore, from this viewpoint, the heat treatment temperature is set to 400°C or less. When the heat treatment temperature is less than 350°C, an organic residue is generated in the amorphous metal oxide inorganic semiconductor layer, and the organic residue functions as an electron trap, and thus the heat treatment temperature is set to 350°C or higher.

The lower limit of the heat treatment temperature is preferably 355°C or higher, more preferably 360°C or higher, and still more preferably 365°C or higher. The upper limit of the heat treatment temperature is preferably lower than 400°C, more preferably 395°C or lower, still more preferably 390°C or lower, even still more preferably 385°C or lower, even still more preferably 380°C or lower, and even still more preferably 375°C or lower. When the heat treatment is performed in the above preferable temperature range, the power consumption and the organic residue can be further reduced.

The area of the AOS layer formed by the present method is preferably 2 $mm^2$ or greater, more preferably 10 $mm^2$ or greater, still more preferably 100 $mm^2$ or greater, even still more preferably 1000 $mm^2$ or greater, and even still more preferably 10000 $mm^2$ or greater. The upper limit of the area of the AOS layer is not particularly limited, and is limited by a size of manufacturing equipment, and may be, for example, 10 $m^2$. Since the AOS layer in the complementary semiconductor device of the present disclosure is formed by the solution process, the AOS layer can have a larger area as described above at a lower cost.

Patterning of AOS Layer

The AOS layer formed by the solution process is preferably patterned using a photoradical initiator and a sodium carbonate developer. FIG. 38 is a schematic view illustrating a patterning operation using the photoradical initiator and the sodium carbonate developer.

The AOS layer formed by the solution process is very sensitive to an external environment such as oxygen, water, and organic solvents. Photoacid generators and strong alkali developers such as tetramethylammonium hydroxide (TMAH) used in known photolithography process can damage the AOS layer. On the other hand, when patterning is performed by a photolithography method using a photoradical initiator and a sodium carbonate developer (1 mass% $Na_2CO_3$ solution) which is a solvent milder than the strong alkali developer, fine patterning can be performed without changing the characteristics of the AOS layer formed by the solution process.

As illustrated in FIG. 39, the S/D electrodes can be formed on the AOS layer by evaporating a metal constituting the S/D electrodes through a shadow mask. A resist PDM may be used for patterning of the S/D electrodes. Examples of the metal constituting the S/D electrodes include Al.

FIG. 40 is a schematic view of an example of an n-type TFT including the AOS (also referred to as an MOS) layer in which the S/D electrodes are formed.

Preferably, the forming the protective layer includes preparing an organic solvent in which a polymer is dissolved, forming the first organic film on the n-type structure by applying the organic solvent in which the polymer is dissolved, and forming the second organic film that is the vacuum deposited film on the first organic film by using chemical vapor deposition method.

By mixing the organic solvent and the polymer, the organic solvent in which the polymer is dissolved can be prepared. The concentration of the polymer may be changed depending on the desired thickness of the first organic film, and is, for example, 1 mg/mL to 80 mg/mL, 2 mg/mL to 70 mg/mL or 3 mg/mL to 60 mg/mL.

The organic solvent in which the polymer is dissolved is applied on the n-type structure to form the first organic film. an application method is preferably a spin coating method, a bar coating method, a spray coating method, a dip coating method, an ink-jet method, a flexographic printing method, or a gravure printing method, more preferably the spin coating method, the bar coating method, the spray coating method, the dip coating method, or the ink-jet method, and still more preferably the spin coating method.

The second organic film which is the vacuum deposited film is formed on the first organic film by using the chemical vapor deposition (CVD) method. The second organic film which is the vacuum deposited film is formed by CVD. CVD is gentle vacuum process and is preferable in terms of deposition rate, processing area, denseness, and uniformity.

The organic semiconductor single crystal layer may be formed directly on the gate insulating layer, the S/D electrodes, the protective layer, or a combination thereof by the coating method.

The coating method is a method in which an organic semiconductor is dissolved in an organic solvent to prepare an organic semiconductor solution, the organic semiconductor solution is applied on the substrate, and the organic solvent is evaporated to form a film. As the organic solvent, an organic solvent typically used in the coating method can be used, and for example, toluene and dichlorobenzene can be used.

The area of the organic semiconductor single crystal layer formed by the coating method is preferably 2 $mm^2$ or greater, more preferably 10 $mm^2$ or greater, still more preferably 100 $mm^2$ or greater, even still more preferably 1000 $mm^2$ or greater, and even still more preferably 10000 $mm^2$ or greater. The upper limit of the area of the organic semiconductor single crystal layer is not particularly limited, and is limited by the size of the manufacturing equipment, and may be, for example, 10 $m^2$. In the related art, when a vapor phase growth method is used, only an organic semiconductor single crystal film having an area of at most about the 1 $mm^2$ is obtained, whereas the organic semiconductor single crystal layer in the present method can have the larger area as described above because it is formed by the solution process.

Preferably, the forming the p-type organic semiconductor single crystal layer includes forming a p-type organic semiconductor single crystal film on a first substrate having hydrophilic and water-insoluble properties by using the coating method, and applying water or an aqueous solution to an interface between the first substrate and the p-type organic semiconductor single crystal film to separate the p-type organic semiconductor single crystal film from the first substrate, and disposing a p-type organic semiconductor single crystal layer on a second substrate, and the second substrate is at least one of a gate insulating layer or S/D electrodes of the n-type structure, a protective layer, or a combination thereof.

The p-type organic semiconductor single crystal film to be separated from the first substrate is disposed on the gate insulating layer, the S/D electrodes, the protective layer, or a combination thereof to form the organic semiconductor single crystal layer. At least one of the gate insulating layer or the S/D electrodes of the n-type structure, the protective layer, or a combination thereof is referred to as the second substrate. The second substrate refers to those located on a surface in contact with the p-type organic semiconductor single crystal layer when the p-type organic semiconductor single crystal layer is disposed. According to this method for forming the organic semiconductor single crystal layer, the organic semiconductor single crystal layer having a thin film thickness can be easily disposed on the second substrate even if the second substrate has characteristics such as hydrophobicity, solvent solubility, non-heat resistance, or a combination thereof, and further includes a concave portion, a convex portion, or an uneven portion.

As the coating method, a typically used method can be used, and for example, an edge casting method, a continuous edge casting method, a drop casting method, a spin coating method, a printing method (an ink-jet method or a gravure printing method), a dispenser method, a spray method, a dip coating method, a die coater method, a roll coater method, a bar coater method, a blade coating method, or the like can be used.

The first substrate is a hydrophilic substrate having a water contact angle of preferably 20 degrees or less, and more preferably 10 degrees or less. The first substrate is water-insoluble and may be, for example, mica or glass. Since the first substrate is water-insoluble, when water or an aqueous solution is applied to the interface between the first substrate and the organic semiconductor single crystal film, the components of the first substrate are not eluted and do not adhere to or react with the organic semiconductor single crystal film, and thus a high-purity organic semiconductor single crystal film can be obtained. In addition, when water or an aqueous solution is applied to the interface between the first substrate and the organic semiconductor single crystal film, the shape of the first substrate is maintained without being deformed, and thus the organic semiconductor single crystal film can be separated from the first substrate without distorting the shape of the organic semiconductor single crystal film. The term water-insoluble refers to not substantially dissolving, decomposing, or swelling in water or an aqueous solution. The glass has a surface which is preferably subjected to UV/ozone treatment or hydrophilization treatment with a hydrophilic coating material or the like.

Water or an aqueous solution is applied to the interface between the first substrate and the organic semiconductor single crystal film to separate the organic semiconductor single crystal film from the first substrate. Since the molecules of the organic semiconductor single crystal film applied on the first substrate are hydrophobic, water or an aqueous solution enters between the hydrophilic first substrate and the hydrophobic molecules of the organic semiconductor single crystal film, and thus the organic semiconductor single crystal film can be separated from the first substrate.

The contact angle of the hydrophilic first substrate with water or an aqueous solution is smaller than the contact angle of the hydrophobic organic semiconductor single crystal film with water or an aqueous solution, and the difference between the contact angles of the first substrate and the organic semiconductor single crystal film with water or an aqueous solution is preferably 80 degrees or more, and more preferably 90 degrees or more. The contact angle of the organic semiconductor single crystal film is preferably from 100 degrees to 120 degrees. When the difference between the contact angles of the hydrophilic first substrate and the hydrophobic organic semiconductor single crystal film is in the above preferable range, the organic semiconductor single crystal film can be more stably peeled off from the first substrate.

The method for applying water or an aqueous solution to the interface between the first substrate and the organic semiconductor single crystal film is not particularly limited, and may be a method for immersing the first substrate

on which the organic semiconductor single crystal film is formed in water or an aqueous solution, a method for dropping water or an aqueous solution to the interface between the first substrate and the organic semiconductor single crystal film with a dropper, or the like.

The method for applying water or an aqueous solution to the interface between the first substrate and the organic semiconductor single crystal film preferably includes immersing the first substrate on which the organic semiconductor single crystal film is formed in water or an aqueous solution. By immersing the first substrate on which the organic semiconductor single crystal film is formed in water or an aqueous solution, the organic semiconductor single crystal film is separated from the first substrate in water or an aqueous solution, and the organic semiconductor single crystal film in a state of self-standing in water or an aqueous solution can be obtained. The self-standing organic semiconductor single crystal film can be disposed on the second substrate.

The disposing the organic semiconductor single crystal film on the second substrate preferably includes, applying water or an aqueous solution to the interface between the first substrate and the organic semiconductor single crystal film while disposing the second substrate to be in contact with the organic semiconductor single crystal film formed on the first substrate to separate the organic semiconductor single crystal film from the first substrate and to dispose the organic semiconductor single crystal film on the second substrate. As described above, by separating the organic semiconductor single crystal film from the first substrate while disposing the second substrate to be in contact with the organic semiconductor single crystal film, the organic semiconductor single crystal film can be transferred from the first substrate onto the second substrate.

Alternatively, the disposing the organic semiconductor single crystal film on the second substrate preferably includes immersing the first substrate on which the organic semiconductor single crystal film is formed in water or an aqueous solution, separating the organic semiconductor single crystal film from the first substrate in water or an aqueous solution to obtain the self-standing organic semiconductor single crystal film, and disposing the organic semiconductor single crystal film on the second substrate in water or an aqueous solution. As described above, by disposing the self-standing organic semiconductor single crystal film on the second substrate in water or an aqueous solution, the organic semiconductor single crystal film can be easily transferred from the first substrate to the second substrate.

More preferably, the disposing the organic semiconductor single crystal film on the second substrate includes, immersing the first substrate, the organic semiconductor single crystal film, and the second substrate in water or aqueous solution while disposing the second substrate so as to be in contact with the organic semiconductor single crystal film formed on the first substrate, and transferring the organic semiconductor single crystal film from the first substrate to the second substrate. As described above, by separating the organic semiconductor single crystal film from the first substrate while disposing the second substrate to be in contact with the organic semiconductor single crystal film in water or an aqueous solution, the organic semiconductor single crystal film can be further easily transferred from the first substrate onto the second substrate.

The patterning of the organic semiconductor single crystal film is not particularly limited and can be performed by a known method, but is preferably performed using a photoresist of a dry film. When the photoresist of the dry film is used, damage to the organic semiconductor single crystal film can be more suppressed than when a photoresist of an application type containing an organic solvent is used.

Preferably, the forming the p-type organic semiconductor single crystal layer includes forming a p-type organic semiconductor single crystal film on a third substrate having hydrophilic and water-insoluble properties by using the coating method, pressing the p-type organic semiconductor single crystal film against a convex portion of a stamp having the convex portion and a concave portion, applying water or an aqueous solution to an interface between the third substrate and the p-type organic semiconductor single crystal film to transfer the p-type organic semiconductor single crystal film to the convex portion, and pressing the p-type organic semiconductor single crystal film transferred to the convex portion against a fourth substrate to transfer the p-type organic semiconductor single crystal film to the fourth substrate to obtain a patterned p-type organic semiconductor single crystal layer, and the fourth substrate is at least one of a gate insulating layer or S/D electrodes of the n-type structure, a protective layer, or a combination thereof.

At least one of the gate insulating layer or the S/D electrodes of the n-type structure, the protective layer, or a combination thereof is referred to as a fourth substrate. The fourth substrate refers to those located on a surface in contact with the p-type organic semiconductor single crystal layer when the p-type organic semiconductor single crystal layer is transferred from the convex portion of the stamp to be patterned.

According to this method, if a mold is fabricated in advance, photolithography is not required and the cost is low. Since the p-type organic semiconductor single crystal layer can be patterned simultaneously with the transfer to the stamp, the patterning can be performed in a short time. Since the patterning of the p-type organic semiconductor single crystal layer is physically performed by utilizing the unevenness of the stamp, there is no need to use a solvent or a laser, and the patterning of various p-type organic semiconductor single crystal layers can be performed, and thus versatility is high. Since only the stamp is pressed against the fourth substrate, a solvent or the like does not damage the fourth substrate. For example, even when the fourth substrate is soluble in a solvent that dissolves an organic material, a patterned p-type organic semiconductor single crystal layer can be formed. Since the stamp is in contact

with only water or an aqueous solution and does not need to be in contact with a solvent or to be heated, there is no swelling or shrinkage of the stamp due to the solvent or heat. For example, a film which has been applied in advance and has become a single crystal can be patterned.

In this method, a water-resistant p-type organic semiconductor single crystal film is formed on the third substrate having hydrophilic and water-insoluble properties by using the coating method. The coating method is a method in which the organic material is dissolved in the organic solvent to prepare an organic solution, the organic solution is applied on the substrate, and the organic solvent is evaporated to form the film. As the organic solvent, an organic solvent typically used in the coating method can be used, and for example, toluene and dichlorobenzene can be used.

As the coating method, a typically used method can be used, and for example, an edge casting method, a continuous edge casting method, a drop casting method, a spin coating method, a printing method (an ink-jet method or a gravure printing method), a dispenser method, a spray method, a dip coating method, a die coater method, a roll coater method, a bar coater method, a blade coating method, or the like can be used.

The third substrate is a hydrophilic substrate having a contact angle with water or an aqueous solution of preferably 20 degrees or less, and more preferably 10 degrees or less. The third substrate may be a substrate having a hydrophilic surface or a substrate having a surface subjected to a hydrophilization treatment, and is preferably a glass substrate or mica, more preferably the glass substrate. The glass substrate is preferably Eagle glass. The hydrophilization treatment can be performed by subjecting the glass substrate to a $UV/O_3$ treatment.

The third substrate is water-insoluble and may be, for example, mica or glass. Since the third substrate is water-insoluble, when water or an aqueous solution is applied to the interface between the third substrate and the p-type organic semiconductor single crystal film, the components of the third substrate are not eluted and do not adhere to or react with the p-type organic semiconductor single crystal film, and thus a high-purity p-type organic semiconductor single crystal film can be obtained. In addition, when water or an aqueous solution is applied to the interface between the third substrate and the p-type organic semiconductor single crystal film, the shape of the third substrate is maintained without being deformed, and thus the organic film can be separated from the third substrate without distorting the shape of the p-type organic semiconductor single crystal film. The term water-insoluble refers to not substantially dissolving, decomposing, or swelling in water or an aqueous solution. The glass has a surface which is preferably subjected to UV/ozone treatment or hydrophilization treatment with a hydrophilic coating material or the like. The third substrate may be flexible.

Water or an aqueous solution is applied to the interface between the third substrate and the p-type organic semiconductor single crystal film to separate the p-type organic semiconductor single crystal film from the third substrate. The p-type organic semiconductor single crystal film may be a hydrophobic p-type organic semiconductor single crystal film. Water or an aqueous solution enters between the hydrophilic third substrate and molecules of the hydrophobic p-type organic semiconductor single crystal film, and thus the p-type organic semiconductor single crystal film can be separated from the third substrate.

The water contact angle of the hydrophilic third substrate is smaller than the water contact angle of the hydrophobic p-type organic semiconductor single crystal film, and the difference between the water contact angles of the third substrate and the p-type organic semiconductor single crystal film is preferably 80 degrees or more, and more preferably 90 degrees or more. The contact angle of the p-type organic semiconductor single crystal film is preferably from 100 degrees to 120 degrees. When the difference between the contact angles of the hydrophilic third substrate and the hydrophobic p-type organic semiconductor single crystal film is in the above preferable range, the p-type organic semiconductor single crystal film can be more stably peeled off from the third substrate.

The method for applying water or an aqueous solution to the interface between the third substrate and the p-type organic semiconductor single crystal film is not particularly limited, and may be a method for dropping water or an aqueous solution to the interface between the third substrate and the p-type organic semiconductor single crystal film with a water supplier such as a dropper or the like, a method for immersing the third substrate on which the p-type organic semiconductor single crystal film is formed in water or an aqueous solution, or the like.

The term hydrophobic means to possibly have a contact angle of preferably 80 degrees or greater, more preferably 90 degrees or greater, still more preferably 100 degrees or greater, even still more preferably 110 degrees or greater, and even still more preferably 150 degrees or greater.

A distance between the uppermost portion of the convex portion and the lowermost portion of the concave portion of the stamp is preferably from 2 $\mu$m to 100 $\mu$m, more preferably from 5 $\mu$m to 50 $\mu$m, still more preferably from 7 $\mu$m to 40 $\mu$m, and even still more preferably from 10 $\mu$m to 30 $\mu$m. When the distance between the uppermost portion of the convex portion and the lowermost portion of the concave portion of the stamp is in the above-described preferable range, physical patterning can be performed while preventing the concave portion from coming into contact with the p-type organic semiconductor single crystal film and preventing the convex portion from being broken when the stamp and the p-type organic semiconductor single crystal film are pressed against each other.

The pressing force for pressing the p-type organic semiconductor single crystal film against the convex portion of the stamp may be appropriately adjusted within a range in which the concave portion does not come into contact with

the p-type organic semiconductor single crystal film and the convex portion is not broken, and may be, for example, from 5 kPa to 200 kPa, from 10 kPa to 100 kPa, or from 15 kPa to 50 kPa.

The constituent material of the stamp is preferably a resin, preferably polydimethylsiloxane (PDMS) or polymethyl methacrylate (PMMA), and more preferably PDMS. The constituent material of the stamp may be mainly composed of PDMS or PMMA. By using a stamp made of such a material, transferring the p-type organic semiconductor single crystal film to the convex portion of the stamp and transferring the p-type organic semiconductor single crystal film from the convex portion of the stamp to the fourth substrate can be favorably performed. The stamp may be hydrophobic. The stamp may include a support substrate of glass or a film.

The support substrate is preferably a glass substrate, a polyethylene naphthalate (PEN) substrate, or a polyethylene terephthalate (PET) substrate.

The glass substrate, the PEN substrate, or the PET substrate (depending on the heat treatment temperature during stamp fabrication) can be selected based on the ease of holding the stamp material before curing and being peeled off from the stamp fabrication mold after thermal curing. When a flexible substrate is used as a base material of the stamp, the peeling is facilitated.

A peeling layer may be formed on a surface of the stamp. The peeling layer is preferably CYTOP or a self-assembled monolayer (SAM), and more preferably CTYOP. The self-assembled monolayer is, for example, decyltrimethoxysilane (DTS), triethoxy-1H,1H,2H,2H-heptadecafluorodecylsilane (F-SAM), or trimethoxy(2-phenylethyl) silane (β-PTS). Since DTS has a contact angle of about 101 degrees, F-SAM has a contact angle of about 110 degrees, and β-PTS has a contact angle of about 80 degrees, when the p-type organic semiconductor single crystal film is transferred to the fourth substrate, the p-type organic semiconductor single crystal film can be more easily peeled off from the stamp to be transferred. The SAM treatment can be performed by a gas phase method or a liquid phase method.

The patterned p-type organic semiconductor single crystal layer preferably includes 10 or more single crystal films, each single crystal film has a thickness of 2 nm or greater, a width of 500 nm or greater, and a length of 500 nm or greater, and a spacing between adjacent single crystal films is 10 μm or greater.

The number of single crystal films included in the patterned p-type organic semiconductor single crystal layer is more preferably 50 or more, and still more preferably 100 or more. Each of the width and the length of the single crystal film may be more preferably 15 μm or greater, and still more preferably 45 μm or greater. The thickness of the single crystal film is more preferably from 2 nm to 100 nm and still more preferably from 7 nm to 20 nm. The spacing between adjacent single crystal films is more preferably 20 μm or greater, and still more preferably 25 μm or greater.

The upper limit of the width of the single crystal film is not particularly limited, and is, for example, 500 μm or less. The upper limit of the spacing between the single crystal films is not particularly limited.

The description described above with respect to the complementary semiconductor device is applied to the configurations of the organic semiconductor single crystal layer, the AOS layer, the protective layer, and the complementary semiconductor device formed in this method. The same applies to the configurations of the gate electrode, the gate insulating film, and the S/D electrodes.

## Examples

### Example 1

#### Fabrication of Complementary Semiconductor Device

The complementary semiconductor device illustrated in FIGS. 41 and 42 was fabricated. FIG. 41 is a schematic cross-sectional view of the fabricated complementary semiconductor device, and FIG. 42 is a perspective view schematically illustrating the fabricated complementary semiconductor device. As illustrated in the cross-sectional view in FIG. 41, the S/D electrodes of the n-type TFT and the gate electrode of the p-type TFT were disposed in the same layer, and a p-type organic TFT was disposed on an n-type inorganic TFT of IZO. PMMA layer/parylene layer was disposed as a protective layer of the n-type inorganic TFT. Since the PMMA layer/parylene layer also functions as a gate insulating film of the p-type organic TFT, an effect of reducing the number of steps can also be obtained. A method for manufacturing the complementary semiconductor device will be described below.

#### Preparation of AOS Precursor Solution by Sol-Gel Method

A precursor solution of indium zinc oxide (IZO) was prepared by the sol-gel method schematically illustrated in FIG. 36. 0.462 g of $In(NO_3)_3$-$xH_2O$ (Aldrich) was added to 10 mL of 2-methoxyethanol, and the mixture was stirred under air atmosphere for 6 hours to obtain a precursor solution (0.1 M) of indium. 0.297 g of $Zn(NO_3)_2$-$xH_2O$ (Aldrich) was added to 10 mL of 2-methoxyethanol, and the mixture was stirred under air atmosphere for 6 hours to obtain a precursor solution (0.1 M) of zinc. The obtained precursor solutions of indium and zinc were mixed at a molar ratio of

In : Zn = 3 : 2 and the mixture was stirred under air atmosphere for 6 hours to prepare a precursor solution of IZO.

Fabrication of PI Substrate

A polyimide vanish (YuPia (registered trademark) - ST, available from UBE Corporation) was spin coated on a 5 cm square glass supporter at 2000 rpm for 3 minutes, and then thermally cured on a hotplate under conditions of 110°C for 60 minutes, 150°C for 30 minutes, 200°C for 10 minutes, 250°C for 10 minutes, and 430°C for 10 minutes under air atmosphere to form a polyimide substrate having a thickness of 10 μm.

Formation of Gate Electrode and Gate Insulating Film

By a lift-off method in which Cr/Au/Cr was vapor-deposited on a pattern formed of photoresist (TLOR, Tokyo Ohka Kogyo Co., Ltd.) and then the photoresist was removed, a gate electrode of Cr/Au/Cr having thicknesses of 5 nm/25 nm/5 nm, respectively, was formed on the polyimide substrate. An AlOx (alumina) gate insulating film having a thickness of 75 nm was formed on the entire surface of the polyimide substrate and the formed gate electrode by the atomic layer deposition (ALD) method.

Formation of AOS Layer

The substrate on which the AlOx gate insulating film was formed was subjected to a treatment with a UV ozone cleaner (UV253H available from Filgen, Inc.) for 10 minutes to remove the organic residue and improve wettability.

As schematically illustrated in FIG. 37, the prepared IZO precursor solution was spin coated on the substrate subjected to the above-described UV treatment at 500 rpm for 5 seconds and then at 5000 rpm for 30 seconds to form an IZO intermediate film. Next, the formed IZO intermediate film was subjected to the heat treatment at 150°C for 5 minutes in the air atmosphere and further subjected to the heat treatment at 370°C for 1 hour to form the AOS film (IZO film) having a thickness of 6 nm. The formed IZO film was subjected to photolithography using a photosensitive dielectric (PDM, TAIYO INK MFG. CO., LTD.) and wet etching using a 1.75 mass% oxalic acid aqueous solution to form an IZO active layer which was a patterned n-type semiconductor.

On the same layer on the substrate including the patterned IZO active layer, the photosensitive dielectric (PDM, TAIYO INK MFG. CO., LTD.) was disposed and patterning is performed by photolithography, and Al was thermally evaporated and lifted off using the patterned PDM as a shadow mask to form the S/D electrodes of the n-type transistor and a gate electrode of the p-type organic semiconductor, having a thickness of 60 nm. Next, a laminate body on which the S/D electrodes were formed was subjected to the heat treatment at 90°C for 3 hours under air atmosphere, and gradually cooled to a room temperature.

Formation of Protective Layer

The PMMA layer having a thickness of 13 nm and the parylene layer having a thickness of 200 nm were formed on the entire surfaces of the AlOx gate insulating film, the IZO layer, and the Al electrode to serve as both the protective layer for the IZO layer and the gate insulating film for the p-type organic transistor to obtain an intermediate body of the complementary semiconductor device.

The PMMA layer was formed by spin coating a butyl acetate solution in which 0.56 mass% PMMA solution (Mw = 120000) was dissolved at 500 rpm for 5 seconds and at 4000 rpm for 30 seconds, and then performing the heat treatment at 150°C for 1 hour. Parylene was deposited by CVD vacuum deposition.

Formation of p-type Organic Semiconductor Single Crystal Layer

An organic semiconductor single crystal layer of $C_9$-DMBDT-NW which is a p-type semiconductor was formed on the protective layer of the p-type transistor portion by the continuous edge casting method. The continuous edge casting method was performed as follows.

A natural mica substrate was prepared as the hydrophilic substrate. A powder of the p-type organic semiconductor $C_9$-DNBDT-NW of the following Formula (16) exhibiting high mobility:

[Chem. 16]

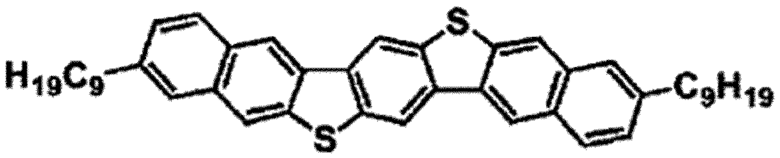

(16)

was prepared as the organic semiconductor. By using 3-chlorothiophene as a solvent, 0.02 mass% organic semiconductor powder was dissolved in the solvent to prepare an organic semiconductor solution. The prepared organic semiconductor solution was applied on the mica substrate heated to 100°C by the continuous edge casting method to form the organic semiconductor single crystal film having an average thickness of 12 nm and an area of 200 $mm^2$. The water contact angle of the organic semiconductor single crystal film surface was 108 degrees.

The intermediate body of the complementary semiconductor device on which the protective layer was formed was disposed and the protective layer was in contact with the organic semiconductor single crystal film formed on the mica substrate, and water was dropped to the interface between the mica substrate and the organic semiconductor single crystal film to separate the organic semiconductor single crystal film from the mica substrate and transfer the organic semiconductor single crystal film onto the protective layer. The transferred organic semiconductor single crystal film was patterned by photolithography to form the organic semiconductor single crystal layer.

Patterning of Organic Semiconductor Single Crystal Film

The patterning of the organic semiconductor single crystal film was performed as follows using a dry film resist (PDM available from TAIYO INK MFG. CO., LTD.) having a thickness of 5 μm as a photoresist.

Au having a thickness of 30 nm was deposited on the organic semiconductor single crystal film by the thermal evaporation, a PMMA solution (Mw = 120000, 0.56 mass%, butyl acetate solution) was spin coated at 500 rpm for 5 seconds and at 1000 rpm for 30 seconds, and then heat treatment was performed at 80°C for 10 minutes to form a PMMA film having a thickness of 300 nm, and laminate a dry film resist on the PMMA film.

The dry film resist was patterned by photolithography, and the PMMA film was removed by $O_2$ plasma treatment using the patterned dry film resist as a mask. Then, an Au film was patterned by etching using Aurum S-50790 (available from Kanto Chemical Co., Inc.). Further, the organic semiconductor single crystal film was patterned by $O_2$ plasma treatment. The PMMA film and dry film resist were then peeled off with acetonitrile which is a mild photoresist remover.

Formation of S/D Electrodes

Au having a thickness of 60 nm was deposited by thermal evaporation on the entire surface of the intermediate body of the complementary semiconductor device fabricated by the above-described method. Next, in the same manner as described above, formation of the PMMA film, lamination of the dry film resist, patterning of the dry film resist by photolithography, removal of the PMMA film by $O_2$ plasma, patterning of the Au film using the Aurum S-50790, and resist peeling off using acetonitrile were performed to form the S/D electrodes of Au having a length of 0.2 mm, a width of 1 mm, and a height of 90 nm (except for a wire portion). Next, a laminate body on which the S/D electrodes were formed was subjected to the heat treatment at 90°C for 3 hours under air atmosphere, and gradually cooled to a room temperature. Thus, the complementary semiconductor device in which the p-type structure/n-type structure is the bottom-gate top-contact/bottom-gate top-contact structure illustrated in FIG. 41 was fabricated. The obtained complementary semiconductor device was disposed on a polyimide substrate having a thickness of 10 μm and had a thickness of about 380 nm except for the polyimide substrate.

Example 2

In the same manner as in Example 1, complementary semiconductor devices having a channel width W of 200 μm and channel lengths L of 100 μm, 80 μm, 60 μm, 40 μm, 20 μm, 10 μm, 7 μm, and 5 μm, respectively, were fabricated. The channel lengths L of the p-type organic TFT and the n-type inorganic TFT were set to be the same.

FIG. 43 shows appearance photographs of the obtained organic/inorganic hybrid complementary semiconductor device. The photographs on the upper side in FIG. 43 are the appearance photographs of the complementary semiconductor devices having the channel lengths L of 100 μm, 80 μm, 60 μm, 40 μm, 20 μm, 10 μm, 7 μm, and 5 μm,

respectively. The photographs on the lower side in FIG. 43 are the expanded photographs of the complementary semiconductor devices of the p-type structure and the n-type structure having the channel lengths L of 40 μm, 20 μm, 10 μm, 7 μm, and 5 μm, respectively. The complementary semiconductor device includes the organic TFT located on the upper side and the inorganic TFT located on the lower side. The distance between the organic semiconductor single crystal layer and the AOS layer in the complementary semiconductor device illustrated in FIG. 43 was 100 μm.

Example 3

In the same manner as in Example 1, an organic/inorganic hybrid complementary semiconductor device including the organic TFT having a W/L of 200 μm/9 μm and the inorganic TFT having the W/L of 200 μm/13 μm was fabricated, and characteristics thereof were evaluated.

FIG. 44 is a graph showing a summary of output characteristics of a drain current with respect to a drain voltage of each of the p-type organic TFT and the n-type inorganic TFT included in the complementary semiconductor device when a gate voltage is changed from 0 V to -10 V in steps of -2 V and from 0 V to 10 V in steps of 2 V A graph on the left in FIG. 45 is a graph showing a transfer characteristic of a drain current with respect to a gate voltage of the p-type organic TFT and a graph on the right is a graph showing a transfer characteristic of a drain current with respect to a gate voltage of the n-type inorganic TFT. These measurements were performed after fabrication of the complementary semiconductor device. In a circuit diagram of the organic-inorganic hybrid complementary semiconductor inverter single element illustrated in FIG. 46, a source voltage and a drain voltage of the TFT on the non-measurement side were set to the same potential. For example, when the p-type organic TFT was measured, the drain voltage was applied to an output terminal of the complementary semiconductor inverter, and at the same time, the same voltage as the drain voltage of the p-type organic TFT was applied to the source voltage in the n-type inorganic TFT, and thus preventing a current from flowing through the n-type inorganic TFT.

The mobility of the p-type organic TFT was 5.1 $cm^2V^{-1}s^{-1}$ and the mobility of the n-type inorganic TFT was 4.0 $cm^2V^{-1}s^{-1}$. An off-current and an on-off ratio of the p-type organic TFT were $10^{-11}$A and $10^8$, respectively, and an off-current and an on-off ratio of the n-type inorganic TFT were $10^{-12}$A and $10^8$, respectively. The threshold voltages of the p-type organic TFT and the n-type inorganic TFT were also substantially the same. As described above, it was confirmed that the p-type organic TFT and the n-type inorganic TFT included in the complementary semiconductor device of the present disclosure had a well-balanced operation and operated at a high speed.

Inverter characteristics of the organic-inorganic hybrid complementary semiconductor device single element obtained in Example 3 were evaluated. FIG. 46 is the circuit diagram of the organic-inorganic hybrid complementary semiconductor inverter single element.

FIG. 47 shows output characteristics of the output voltage for the complementary semiconductor device fabricated in Example 3 when an input voltage is changed from 0 V to 10 V Good rail-to-rail performance was obtained. FIG. 48 shows a graph of an evaluation of a cause of a voltage amplification effect at the time of switching of the complementary semiconductor device fabricated in Example 3. When $V_{DD}$ was about 7 V, a large voltage gain was obtained, and a voltage gain from 30 V to 40 V was obtained.

FIG. 49 shows a graph of a relationship between the input voltage and the supply current of the complementary semiconductor device fabricated in Example 3. It was found that When $V_{DD}$ is 7 V, static power consumption during standby is as low as 0.76 μW or less. FIG. 50 is a graph showing an evaluation of a noise margin of the complementary semiconductor device fabricated in Example 3. $NM_H$ was 2.7 V and $NM_L$ was 1.9 V, and thus a large noise margin was obtained. FIG. 51 is a graph showing evaluations of initial characteristics measured immediately after the fabrication of the complementary semiconductor device fabricated in Example 3 and characteristics after being left in the air atmosphere for five months. In the initial characteristics and after being left for 5 months, substantially the same switching characteristics are indicated, and thus it was found that the device had good long-term stability.

Flexible Evaluation

FIG. 52 shows an appearance photograph of a complementary semiconductor device formed on the polyimide substrate fabricated in the same manner as in Example 3 and peeled off from a glass supporter by using a laser lift-off (LLO) method. More than 750 complementary inverters are integrated on a 5 cm square polyimide substrate. FIG. 53 is a schematic view of a state in which the complementary semiconductor device formed on the polyimide substrate is bent.

FIG. 54 is a graph showing voltage transfer curve (VTC) characteristics of the complementary semiconductor device including the organic TFT and the inorganic TFT in which W/L before and after LLO treatment (before and after peeling off) is 200 μm/10 μm. When $V_{DD}$ was 4 V, 6 V, 8 V, and 10 V, almost the same characteristics were exhibited before and after the LLO treatment, and it was found that there was almost no damage to the complementary semiconductor device by the LLO treatment.

FIG. 55 shows an appearance photograph in which the complementary semiconductor device formed on the

polyimide substrate illustrated in FIG. 52 is wound around a glass cylinder having a radius of 6.0 mm. FIG. 55 shows a graph of output characteristics in a case where complementary semiconductor devices each including the organic TFT and the inorganic TFT having an n-channel W/L of 50 μm/24 μm and a p-channel W/L of 210 μm/19 μm and fabricated in the same manner as in Example 3 are disposed on surfaces of a planar substrate and cylinders having radii of 17.5 mm (strain 0.03%), 12.0 mm (strain 0.04%), and 6.0 mm (strain 0.08%), respectively. The complementary semiconductor devices disposed on the planar substrate and the cylinders having different curvatures showed nearly the same characteristics. When the polyimide substrate was used as the flexible substrate, flexible complementary semiconductor devices could be obtained.

Ring Oscillator Characteristic Evaluation

A five stage ring oscillator (oscillation circuit) was fabricated in which five complementary semiconductor devices fabricated by the same method as in Example 1 were connected to each other in a loop. FIG. 56 shows an appearance photograph of the ring oscillator, a circuit diagram, and an enlarged appearance photograph of a portion surrounded by a square. The TFTs of each stage have the same dimensions of W/L = 200 μm/4 μm and ΔL = 3 μm for the p-channel and W/L = 200 μm/8 μm and ΔL = 1.5 μm for the n-channel. ΔL is a length of a portion where the gate electrode and the S/D electrodes overlap each other.

FIG. 57 is a graph showing an evaluation of inverter characteristics of a single complementary semiconductor device when $V_{DD}$ is 10 V Even in the inverter having a short channel length, rail-to-rail characteristics was exhibited, and it was suggested that $V_M$ was a symmetric transition of about 5V in both forward and reverse voltage sweeps, and a high noise margin was indicated that $NM_H$ was 3.2 V, and $NM_L$ was 2.9 V

FIG. 58 shows a graph measuring an output voltage of the ring oscillator when $V_{DD}$ is 10 V The oscillation frequency $f_{ROSC}$ of the ring oscillator was 77 kHz and the delay time per stage was calculated to be 1.3 μs by the following equation:

[Equation 3]

$$f_{ROSC} = \frac{1}{2tn}$$

where t is the delay time per stage of the ring oscillator and n is the number of stages of the ring oscillator. The ring oscillator operated to output a stationary waveform, and thus it was found that the characteristics of each p-type TFT, each n-type TFT, and each complementary semiconductor device have high uniformity. This is considered to be because each complementary semiconductor device includes the organic semiconductor single crystal film as the p-type semiconductor and the uniform AOS as the n-type semiconductor.

The ring oscillator characteristics of the complementary semiconductor device based on the organic semiconductor and the oxide semiconductor deposited by the previously reported solution process and heat treatment at 400°C or less was compared from the perspective of scalable manufacturing and a flexible circuit. The results are shown in Table 1. The p-type semiconductors are all organic semiconductors. The n-type semiconductors are amorphous oxides in Example 1 and Comparative Example 2, and organic semiconductors in the others. Example 1 in Table 1 is the five stage ring oscillator in which five complementary semiconductor devices fabricated by the same method as in Example 1 were connected to each other in a loop. The delay time is proportional to $V_{DD}$, and a converted delay time when $V_{DD}$ is aligned to 10 V to compare the ring oscillator characteristics of each example is denoted as $t_{10\ V}$. The p-type semiconductor and the n-type semiconductor are formed in the same layer by the ink-jet method in Comparative Examples 1, 2, and 4 to 6, by the continuous edge casting method in Comparative Example 3, and by the spin coating method in Comparative Example 7, and the protective layer is not used.

Table 1

Table 1

| P-TYPE SEMICONDUCTOR | N-TYPE SEMICONDUCTOR | SUBSTRATE | STAGE | L (μm) | $V_{DD}$ (V) | $f_{ROSC}$ (Hz) | t (μs) | tio v* (μs) | Ref. |
|---|---|---|---|---|---|---|---|---|---|
| **$C_9$-DNBDT-NW** | **IZO** | **PI** | **5** | **p4/n8** | **10** | **77k** | **1.3** | **1.3** | **Example 1** |
| MOP-01 | TU-3 and PaMS blender | Glass | 5 | p60/n55 | 10 | 93.9 | 1065 | 1065 | Comparative Example 1 |
| P3HT | ZnO | $Si/SiO_2$ | 5 | 1 | 2 | 2.2k | 45 | **9** | Comparative Example 2 |
| $C_{10}$-DNBDT | BASF GSID-104031-1 | Glass | 5 | p30/n5 | 20 | 22k | 4.5 | **9** | Comparative Example 3 |
| ActivInk P2100 | P(NDI2OD-T2) | PEN | 5 | 5 | 30 | 80k | 1.25 | **3.75** | Comparative Example 4 |
| TIPS-PEN | PDI8CN2 | Glass | 7 | 10 | 4 | 31.8 | 2246 | **898** | Comparative Example 5 |
| TIPS-PEN | ActivInk N3300 | PEN | 19 | 5 | 20 | 2.6k | 10 | **20** | Comparative Example 6 |
| $P(T_0T_0TT_{16})$ | P(NDI2OD-T2) | Glass | 7 | 2.5 | 1.5 | 140 | 500 | **75** | Comparative Example 7 |

Comparative Example 1 was fabricated by the method reported in Takeda, Y. et al. Appl. Sci. 2018, 8, 1331. Comparative Example 2 was fabricated by the method reported in K. Hong, et al. Adv. Mater. 2014, 26, 7032. Comparative Example 3 was fabricated by the method reported in M. Uno, et al. Adv. Electron. Mater. 2015, 1, 1500178. Comparative Example 4 was fabricated by the method reported in K. J. Baeg. et al. Org. Electron. 2013, 14, 1407. Comparative Example 5 was fabricated by the method reported in S. H. Kim, et al, IEEE Electron Device Lett. 2013, 34, 307. Comparative Example 6 was fabricated by the method reported in W. Smaal, et al, Org. Electron. 2012, 13, 1686. Comparative Example 7 was fabricated by the method reported in L. Herlogsson, et al. Adv. Mater. 2011, 23, 4684.

It was found that the converted delay time $t_{10\,V}$ of the ring oscillator fabricated in Example 1 in which five complementary semiconductor devices are connected to each other was much shorter than that of the ring oscillator of the complementary semiconductor device based on the organic semiconductor and the oxide semiconductor deposited by the previously reported solution process and heat treatment at 400°C or less.

Analysis of Concentration Distribution of Oxygen Defects

FIG. 59 shows the measurement results of the angle-resolved XPS of O1s of the AOS layer fabricated by the same method as in Example 1. FIG. 59(a) is a graph showing a summary of measured spectra of O1s of the AOS layer formed in Example 1 when the inclination angle $\theta$ is set to 0°, 40°, 55°, 63°, and 70°. FIGS. 59(b) to 59(f) illustrate graphs obtained by decomposing the measurement spectra measured at the inclination angles $\theta$ of 0°, 40°, 55°, 63°, and 70° and fitting into M-O-M having a peak at 529.7 eV, M-O(H) having a peak at 531.1 eV, and M-O-R having a peak at 532.0 eV.

M refers to In or Zn. M-O-M refers to an oxide of a stoichiometric composition in which oxygen bridges between metal ions and there is no oxygen defect. M-O(H) refers to a composition having oxygen defects containing an oxygen or a hydroxyl group having an unpaired electron not bridging between metal ions. M-O-R refers to a composition having oxygen defects containing oxygen in an organic material such as $H_2O$, $CO_2$, or alcohol bonded to a metal ion.

FIG. 60, FIG. 68 and Table 2 show an angle dependence of the ratio ($\eta_{M\text{-}O\text{-}M}$) of M-O-M (in a metal oxide state) to the entire O1s calculated by the above fitting.

[Table 2]

Table 2

| INCLINATION ANGLE $\theta$ (°) | $\eta_{M\text{-}O\text{-}M}$ (%) | REDUCTION RATE OF $\eta_{M\text{-}O\text{-}M}$ (%) | INFORMATION DEPTH (nm) |
|---|---|---|---|
| 0 | 50 | 0 | 5.5 |
| 40 | 50 | 0 | 5.5 |
| 55 | 50 | 0 | 4.8 |
| 63 | 46 | 4 | 3.8 |
| 70 | 41 | 9 | 2.9 |

The larger the inclination angle $\theta$, the more the surface selective, and thus the composition closer to the surface of the AOS layer is represented. The ratio of the M-O-M bond was constant at about 50% in the inside of the AOS film, but the closer to the surface of the AOS film, the smaller the ratio of the M-O-M bond, and the ratio was decreased to about 40%, that is, the ratio of the M-O-M bond was decreased by about 20%. As described above, it was indicated that the AOS layer had more oxygen defects near the surface than in the inside and had a non-uniform chemical composition in the film thickness direction. In FIG. 68, each of three points at 5.5 nm on the horizontal axis is a ratio of an integrated value of a respective one of M-O species from the AOS outermost surface to the depth of 5.5 nm, and each of three points at 2.8 nm is a ratio of the integrated value of a respective one of the M-O species from the outermost surface to the depth of 2.8 nm. It is considered that the fact that oxygen defects are originally present near the surface of the AOS layer also contributes to the small change over time in the complementary semiconductor device.

Reference Example 1: Example in which Thickness of AOS Layer is changed

A P-doped Si wafer substrate including thermally oxidized $SiO_2$ (having a thickness of 100 nm) as a gate insulating film was ultrasonically cleaned in acetone and then in 2-propanol for 10 minutes each, and then dried at 100°C for 10 minutes under air atmosphere by using a hotplate.

The cleaned and dried substrate was subjected to a treatment with a UV ozone cleaner (UV253H available from Filgen, Inc.) for 10 minutes to remove the organic residue and improve wettability.

IZO films (AOS layers) having different thicknesses were formed in the same manner as in Example 1 except that the precursor solution concentration was changed. FIG. 61 and Table 3 show a relationship between the precursor solution concentrations and the thicknesses of the formed AOS layers. The thickness of the AOS layer was measured by X-ray reflectivity.

The source/drain (S/D) electrodes (Al, 40 nm) were formed and patterned on the IZO film by thermal evaporation using a metal mask. Further, the IZO film was patterned by an yttrium aluminum garnet (YAG) laser, subjected to a heat treatment at 90°C for 3 hours under air atmosphere, and gradually cooled to a room temperature to obtain the IZO active layer.

Butyl acetate solution (50 mg/mL) in which PMMA (Mw: 120000) was dissolved was spin coated at 500 rpm for 5 seconds and at 4000 rpm for 30 seconds on the gate insulating layer on which the IZO active layer and the S/D electrodes were formed, and then subjected to heat treatment at 150°C for 2 hours to form the PMMA layer having a thickness of 100 nm. AlOx having a thickness of 40 nm was deposited on the PMMA layer by the ALD method while the substrate temperature was maintained at 110°C to form a protective layer including two layers of PMMA layer/AlOx layer. Thus, the bottom-gate top-contact n-type inorganic TFT including the protective layer and the IZO film was fabricated. The fabricated n-type inorganic TFT had the channel length (L) of 100 μm and the channel width (W) of 2000 μm.

[Table 3]

Table 3

| PRECURSOR CONCENTRATION (M) | THICKNESS OF AOS LAYER (nm) |
|---|---|
| 0.05 | 2.5 |
| 0.075 | 3.8 |
| 0.1 | 5.5 |
| 0.15 | 9 |
| 0.2 | 11 |

TFT characteristics of IZO formed with the total metal ion concentrations of 0.05 M, 0.1 M, and 0.2 M, respectively, were evaluated. FIG. 62 shows a relationship between the gate voltage and the drain current of each of the TFTs with the AOS layer having a respective one of thicknesses of 2.5 nm, 5.5 nm, and 11 nm when the drain voltage is 2 V and 30 V

When the AOS layer had a thickness of 2.5 nm, the off-current was good, but the mobility was relatively low and hysteresis was also observed. When the AOS layer had a thickness of 5.5 nm, the off-current and the mobility were good, and no hysteresis was observed. When the AOS layer had a thickness of 11 nm, the off-state was not obtained. When the total metal ion concentration was 0.1 M and the AOS layer had a thickness of 5.5 nm, the best TFT characteristics were obtained.

Reference Example 2

Characteristics of an oxide thin film (IZO) formed by the same method as in Reference Example 1 except that the heat treatment temperature was changed, and characteristics of an n-type TFT fabricated by the same method as in Reference Example 1 using the oxide thin film were evaluated.

FIG. 63 shows characteristics of TFTs fabricated using IZO thin films fabricated by sintering at different temperatures of 350°C, 370°C, and 390°C. FIG. 64 shows an XRD measurement results of the IZO thin films obtained at respective sintering temperatures. FIG. 65 shows a total reflection FT-IR measurement results of the IZO thin films obtained at respective sintering temperatures.

The IZO thin films indicating an amorphous structure at respective sintering temperatures, having high uniformity, and having good characteristics were obtained. However, in the heat treatment at 350°C, an organic residue acting as an electron trap was observed. Therefore, the optimum temperature of the IZO system is considered to be 370°C.

FIGS. 69 and 70 show atomic force microscope (AFM, SPM 9700HT available from Shimadzu Corporation) images of the IZO thin film before and after the heat treatment at 370°C, respectively, and thicknesses measured by the X-ray reflectivity method. After the heat treatment as compared with before the heat treatment, the roughness decreased

from 4.3 nm to 0.2 nm, and the depth decreased by about half from 14 nm to 5.5 nm.

Reference Signs List

10 Substrate
20 Gate electrode of n-type structure
22 Gate insulating film of n-type structure
24 n-type amorphous metal oxide inorganic semiconductor layer
26 S/D electrodes of n-type structure
30 Protective layer
40 Gate electrode of p-type structure
42 Gate insulating film of p-type structure
44 p-type organic semiconductor single crystal layer
46 S/D electrodes of p-type structure

## Claims

1. An inorganic/organic hybrid complementary semiconductor device comprising:

   a substrate;
   a p-type organic semiconductor single crystal layer;
   an n-type amorphous metal oxide inorganic semiconductor layer between the substrate and the p-type organic semiconductor single crystal layer; and
   a protective layer between the p-type organic semiconductor single crystal layer and the n-type amorphous metal oxide inorganic semiconductor layer, wherein
   when viewed from a direction perpendicular to a main surface of the p-type organic semiconductor single crystal layer, the p-type organic semiconductor single crystal layer is disposed and thus at least a part of the p-type organic semiconductor single crystal layer overlaps the n-type amorphous metal oxide inorganic semiconductor layer or the p-type organic semiconductor single crystal layer does not overlap the n-type amorphous metal oxide inorganic semiconductor layer,
   a distance between the p-type organic semiconductor single crystal layer and the n-type amorphous metal oxide inorganic semiconductor layer is 1 mm or less, and
   the n-type amorphous metal oxide inorganic semiconductor layer has a distribution of an oxygen defect amount in a thickness direction in which the oxygen defect amount is larger on the p-type organic semiconductor single crystal layer side than on the substrate side.

2. The inorganic/organic hybrid complementary semiconductor device according to claim 1, wherein the p-type organic semiconductor single crystal layer has an average thickness from 2 nm to 100 nm.

3. The inorganic/organic hybrid complementary semiconductor device according to claim 1 or 2, wherein the p-type organic semiconductor single crystal layer has a single domain of 0.0025 $mm^2$ or greater.

4. The inorganic/organic hybrid complementary semiconductor device according to any one of claims 1 to 3, wherein the substrate is a flexible substrate.

5. The inorganic/organic hybrid complementary semiconductor device according to any one of claims 1 to 4, wherein

   the protective layer includes a first organic film and a second organic film,
   the first organic film is located on the n-type amorphous metal oxide inorganic semiconductor layer side, and the second organic film is located on the p-type organic semiconductor single crystal layer side, and
   the first organic film contains an organic solvent soluble polymer, and the second organic film is a vacuum deposited film.

6. The inorganic/organic hybrid complementary semiconductor device according to claim 5, wherein the first organic film has a thickness of 10 nm or greater, and the second organic film has a thickness from 100 nm to 300 nm.

7. The inorganic/organic hybrid complementary semiconductor device according to claim 5 or 6, wherein the first organic film is a PMMA film, and the second organic film is a parylene film.

8. A method for manufacturing an inorganic/organic hybrid complementary semiconductor device, the method comprising:

   providing a substrate;
   forming an n-type structure on the substrate;
   forming a protective layer on the n-type structure; and
   forming a p-type structure on the protective layer, wherein
   the forming the n-type structure includes:

      preparing a precursor solution of an n-type amorphous metal oxide inorganic semiconductor containing a metal salt by using a sol-gel method,
      forming a precursor film by applying the precursor solution on the substrate, and
      forming an n-type amorphous metal oxide inorganic semiconductor layer by heat-treating the precursor film at 350°C to 400°C,
      the forming the p-type structure includes forming a p-type organic semiconductor single crystal layer by using a coating method,
      when viewed from a direction perpendicular to a main surface of the p-type organic semiconductor single crystal layer, the p-type organic semiconductor single crystal layer is disposed and thus at least a part of the p-type organic semiconductor single crystal layer overlaps the n-type amorphous metal oxide inorganic semiconductor layer or the p-type organic semiconductor single crystal layer does not overlap the n-type amorphous metal oxide inorganic semiconductor layer,
      a distance between the p-type organic semiconductor single crystal layer and the n-type amorphous metal oxide inorganic semiconductor layer is 1 mm or less, and
      the n-type amorphous metal oxide inorganic semiconductor layer has a distribution of an oxygen defect amount in a thickness direction in which the oxygen defect amount is larger on the p-type organic semiconductor single crystal layer side than on the substrate side.

9. The method for manufacturing an inorganic/organic hybrid complementary semiconductor device according to claim 8, wherein the forming the precursor film by applying the precursor solution is performed using a spin coating method.

10. The method for manufacturing an inorganic/organic hybrid complementary semiconductor device according to claim 8 or 9, wherein
   the forming the protective layer includes:

   preparing an organic solvent containing a polymer dissolved,
   forming a first organic film on the n-type structure by applying the organic solvent containing the polymer dissolved, and
   forming a second organic film that is a vacuum deposited film on the first organic film by using a chemical vapor deposition method.

11. The method for manufacturing an inorganic/organic hybrid complementary semiconductor device according to any one of claims 8 to 10, wherein
   the forming the p-type organic semiconductor single crystal layer includes:

   forming a p-type organic semiconductor single crystal film on a first substrate having hydrophilic and water-insoluble properties by using the coating method, and
   applying water or an aqueous solution to an interface between the first substrate and the p-type organic semiconductor single crystal film to separate the p-type organic semiconductor single crystal film from the first substrate, and disposing the p-type organic semiconductor single crystal layer on a second substrate, and
   the second substrate is at least one of a gate insulating layer or S/D electrodes of the n-type structure, the protective layer, or a combination thereof.

12. The method for manufacturing an inorganic/organic hybrid complementary semiconductor device according to any one of claims 8 to 10, wherein
   the forming the p-type organic semiconductor single crystal layer includes:

forming a p-type organic semiconductor single crystal film on a third substrate having hydrophilic and water-insoluble properties by using the coating method,
pressing the p-type organic semiconductor single crystal film against a convex portion of a stamp having the convex portion and a concave portion,
applying water or an aqueous solution to an interface between the third substrate and the p-type organic semiconductor single crystal film to transfer the p-type organic semiconductor single crystal film to the convex portion, and
pressing the p-type organic semiconductor single crystal film transferred to the convex portion against a fourth substrate to transfer the p-type organic semiconductor single crystal film to the fourth substrate to obtain a patterned p-type organic semiconductor single crystal layer, and
the fourth substrate is at least one of a gate insulating layer or S/D electrodes of the n-type structure, the protective layer, or a combination thereof.

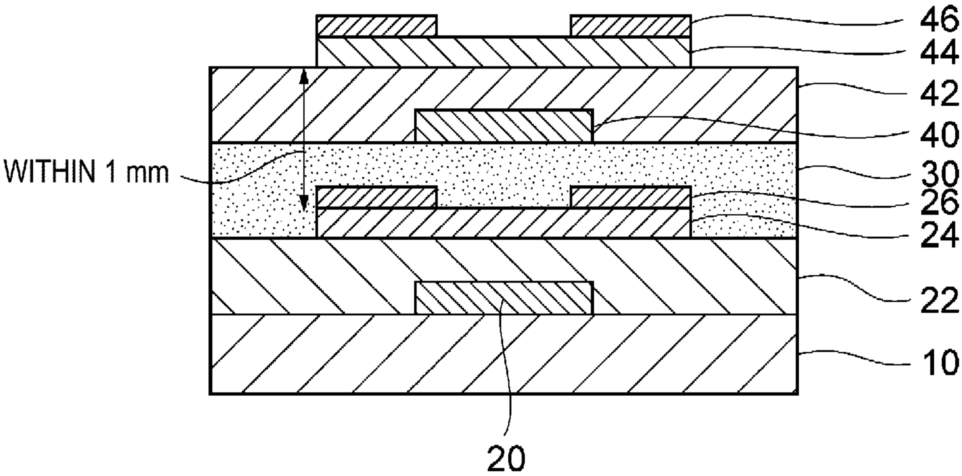


FIG. 1

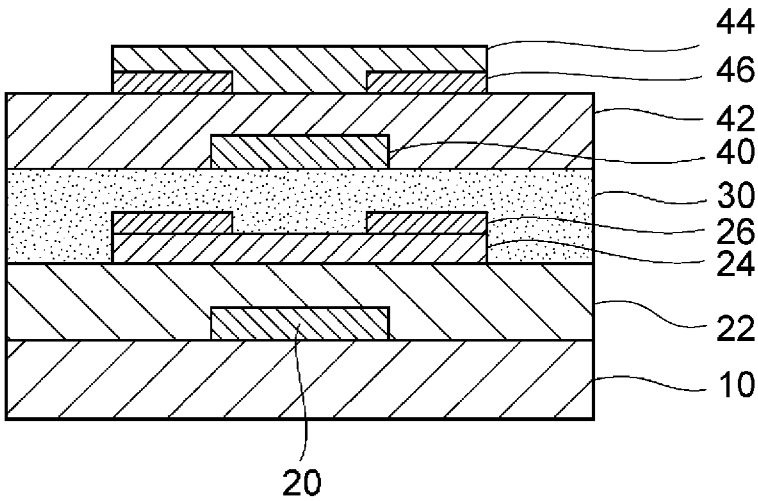


FIG. 2

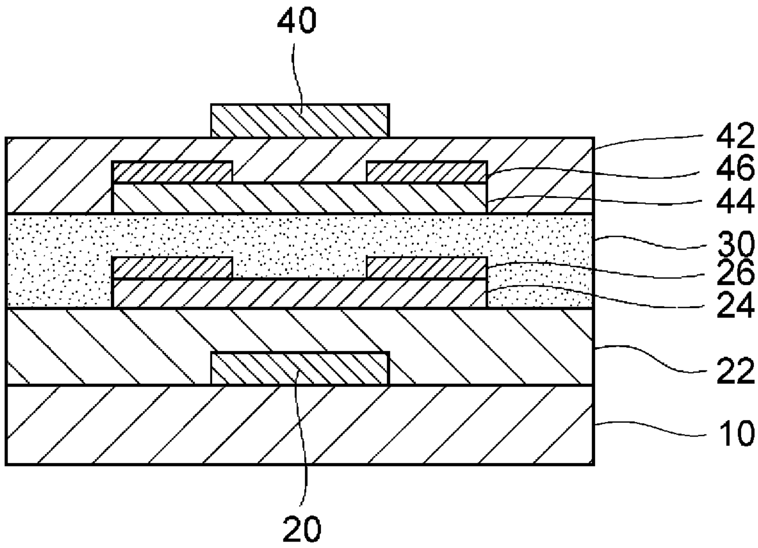


FIG. 3

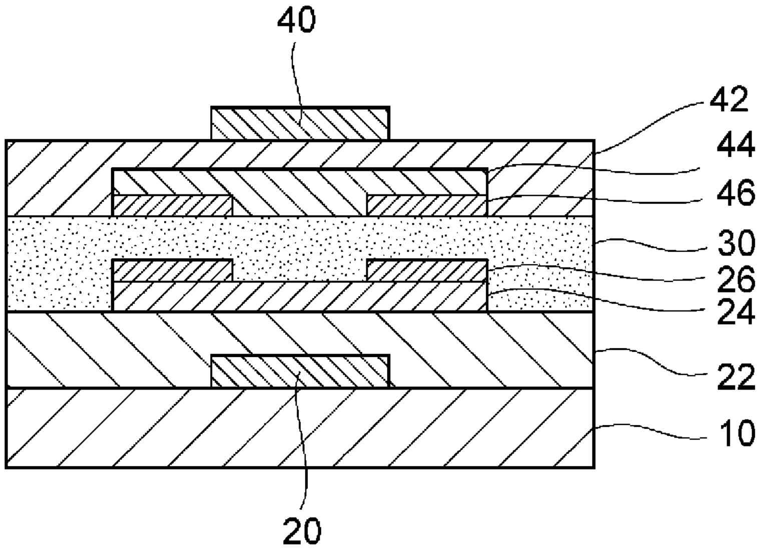


FIG. 4

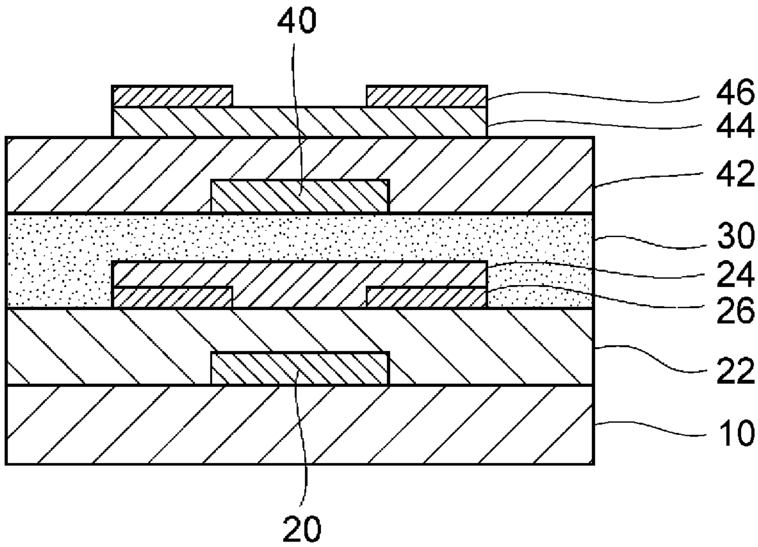


FIG. 5

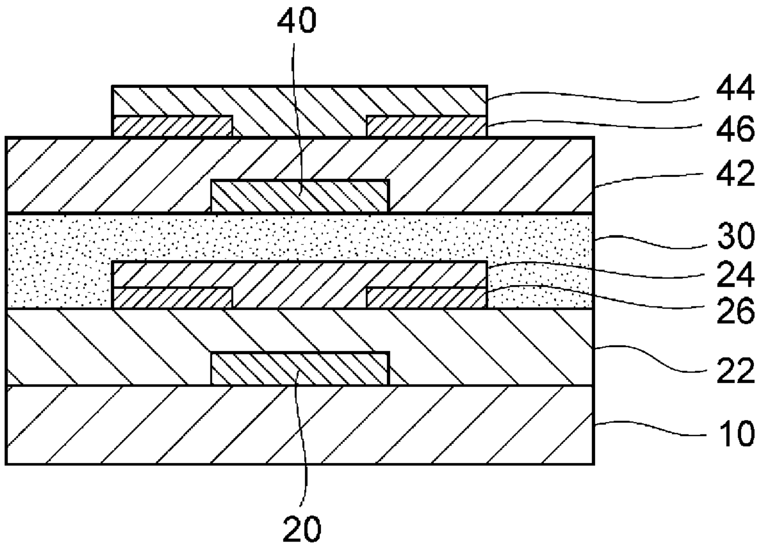


FIG. 6

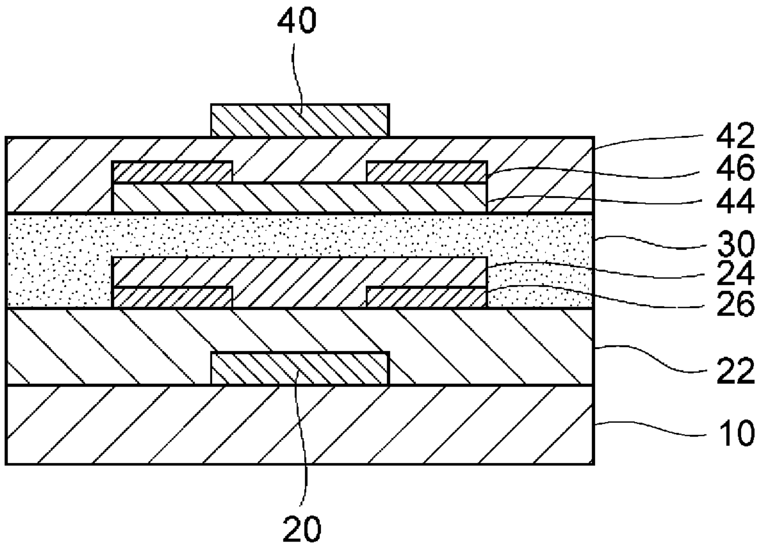


FIG. 7

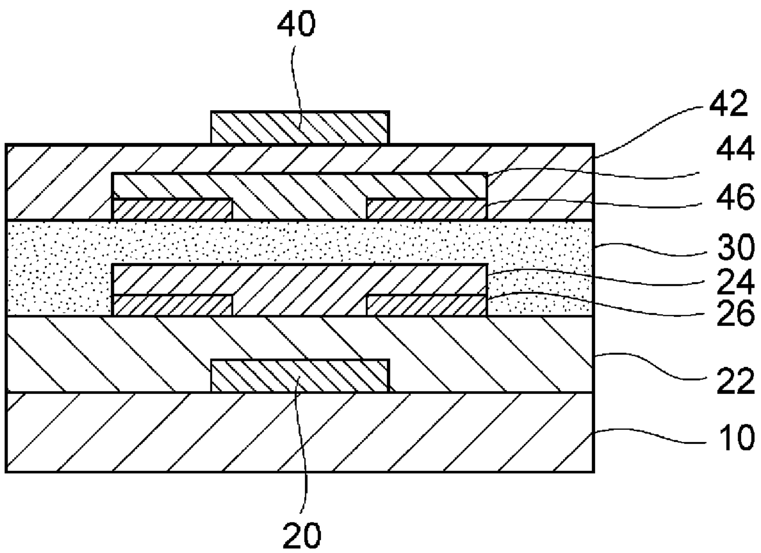


FIG. 8

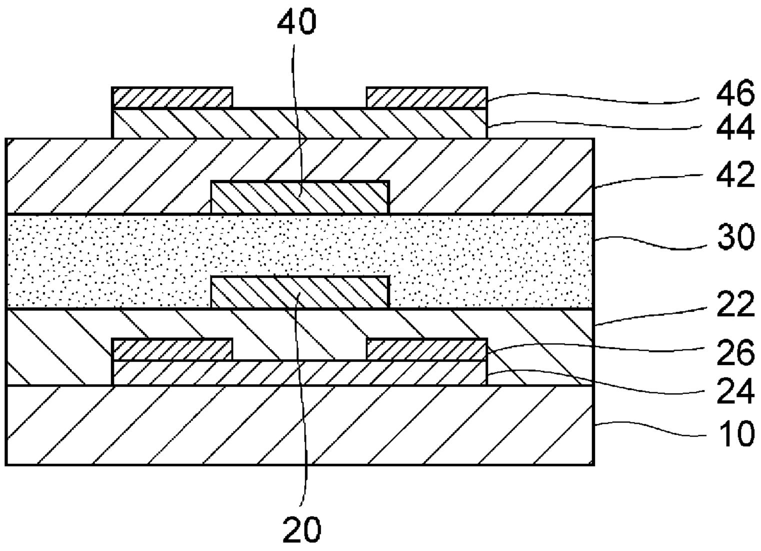


FIG. 9

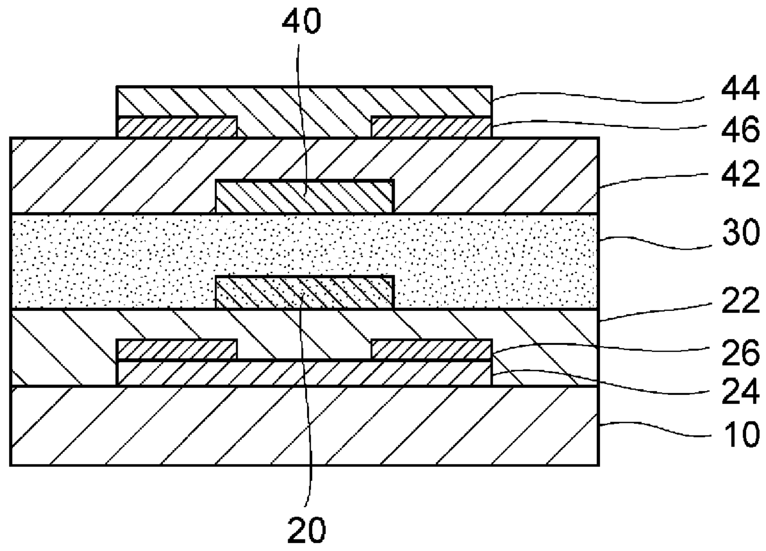


FIG. 10

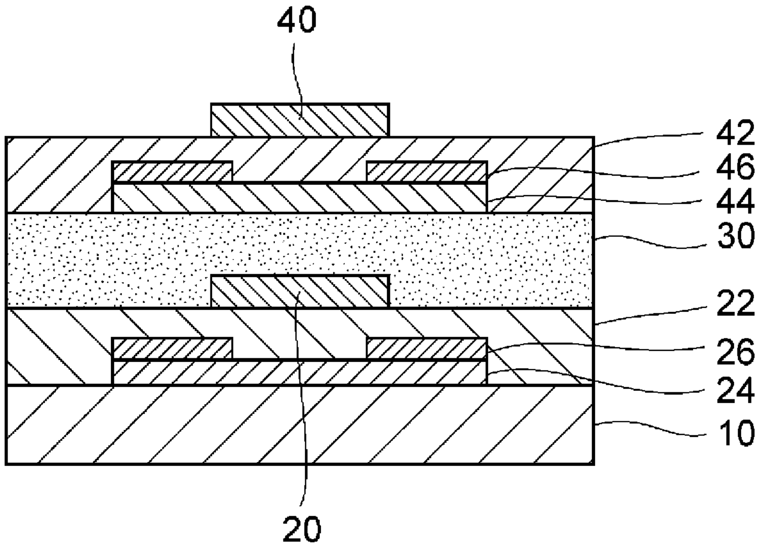


FIG. 11

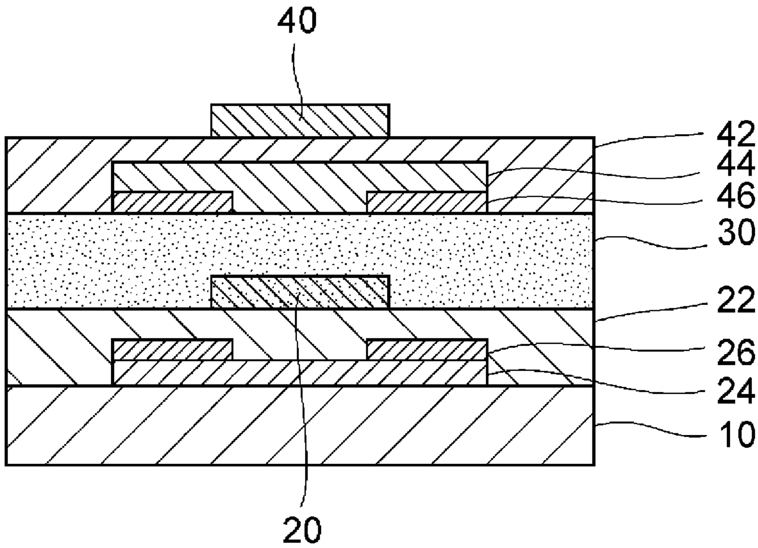


FIG. 12

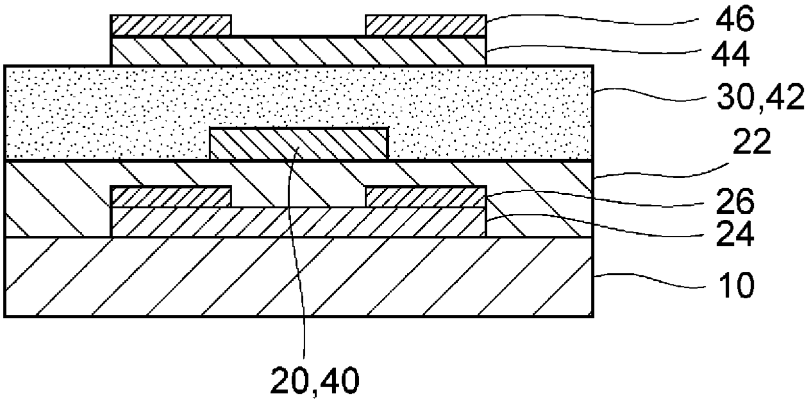


FIG. 13

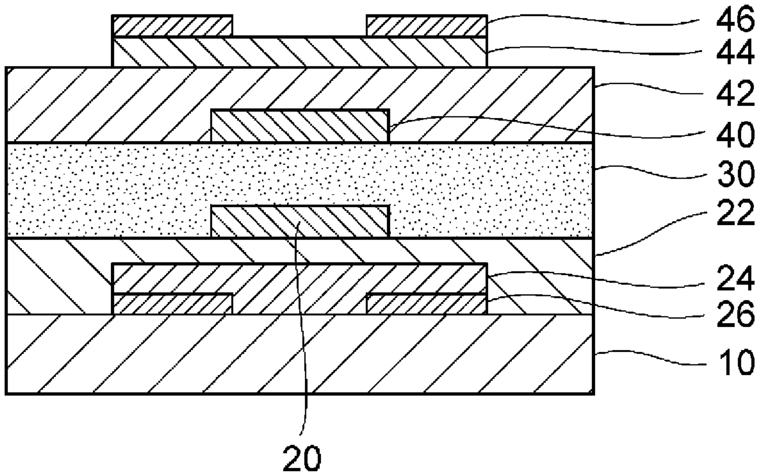


FIG. 14

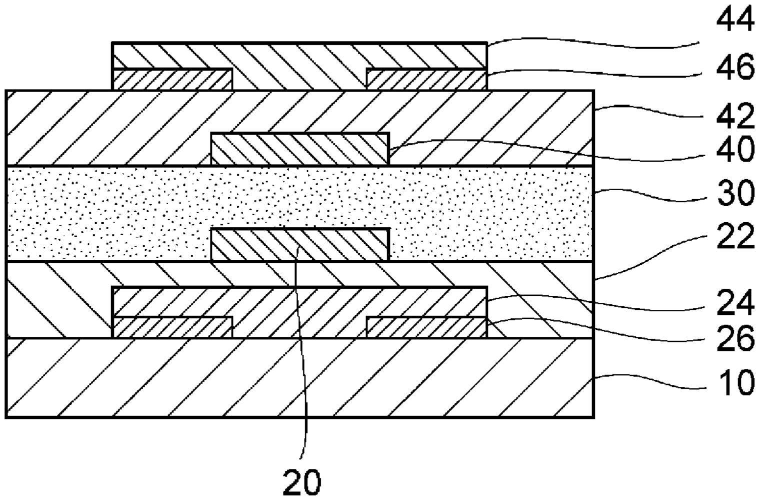


FIG. 15

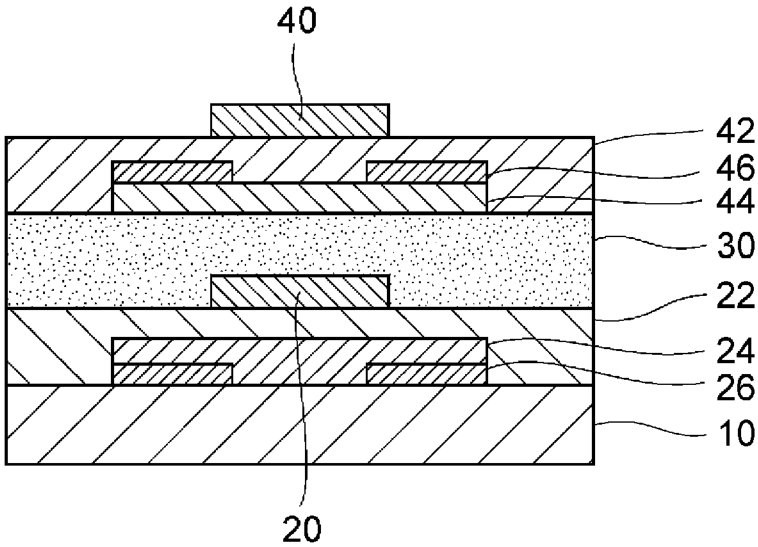


FIG. 16

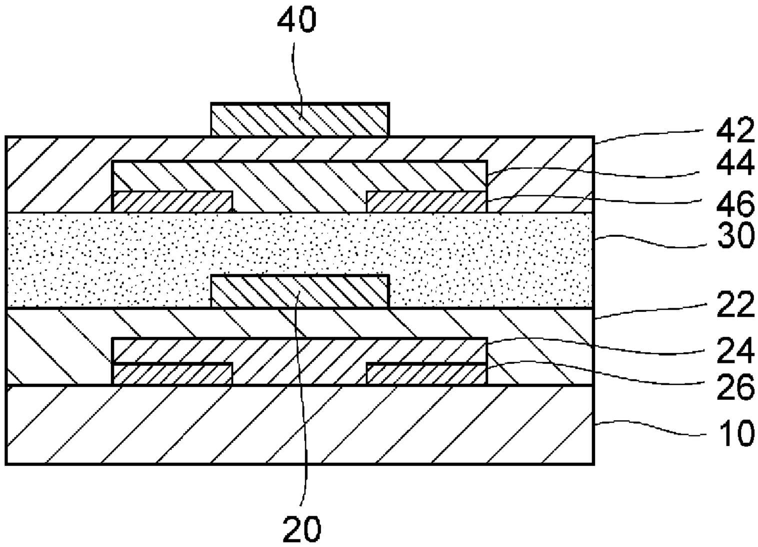


FIG. 17

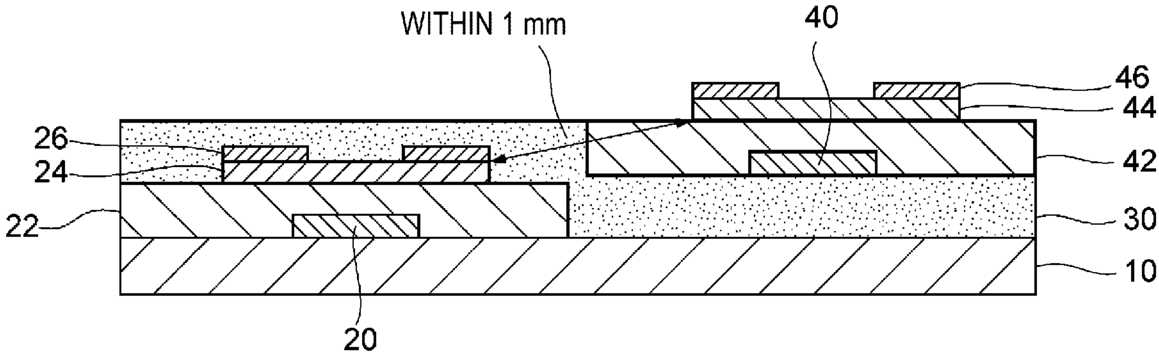


FIG. 18

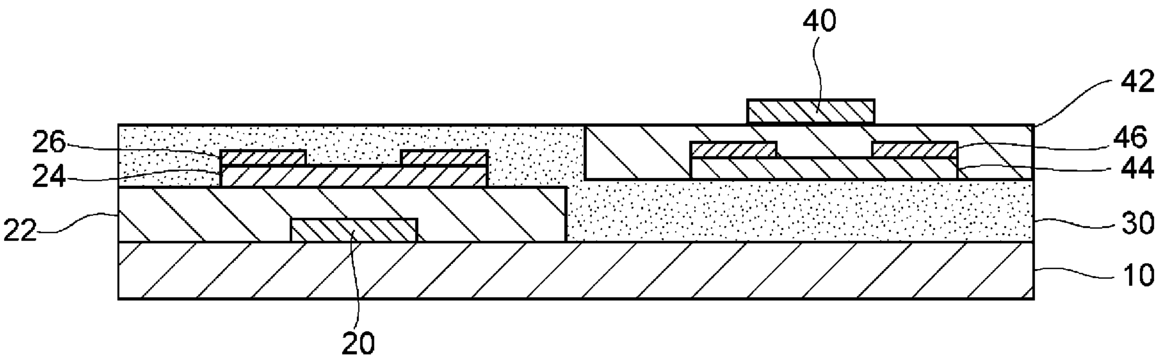


FIG. 19

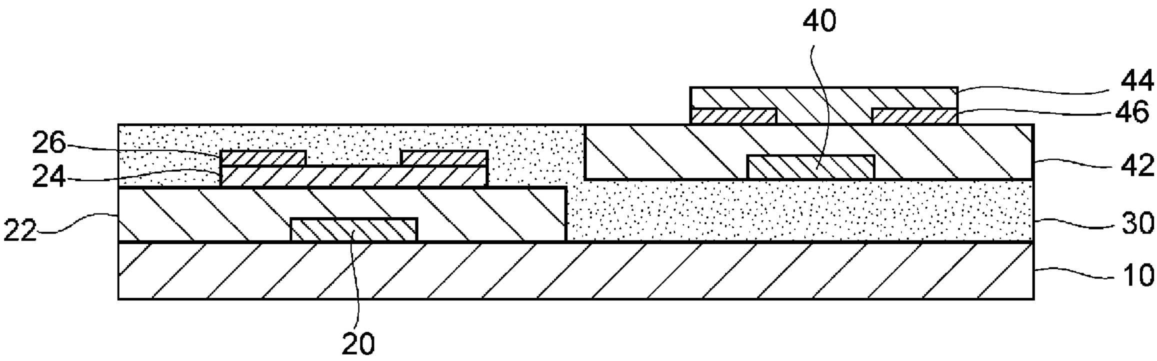


FIG. 20

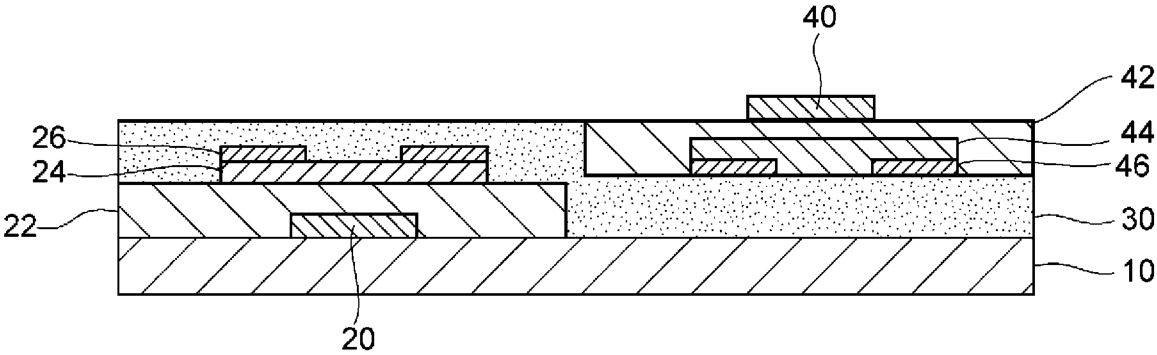


FIG. 21

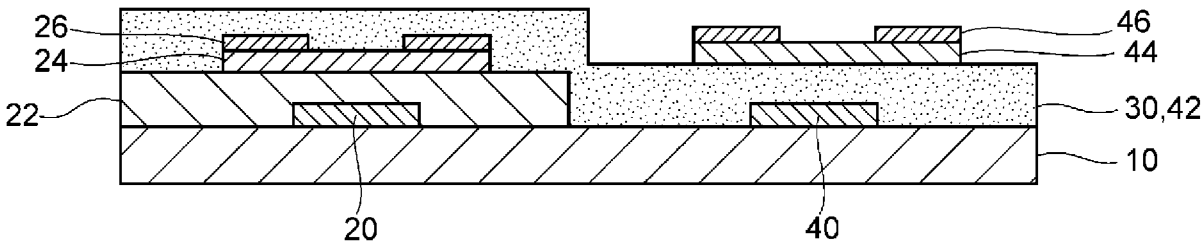


FIG. 22

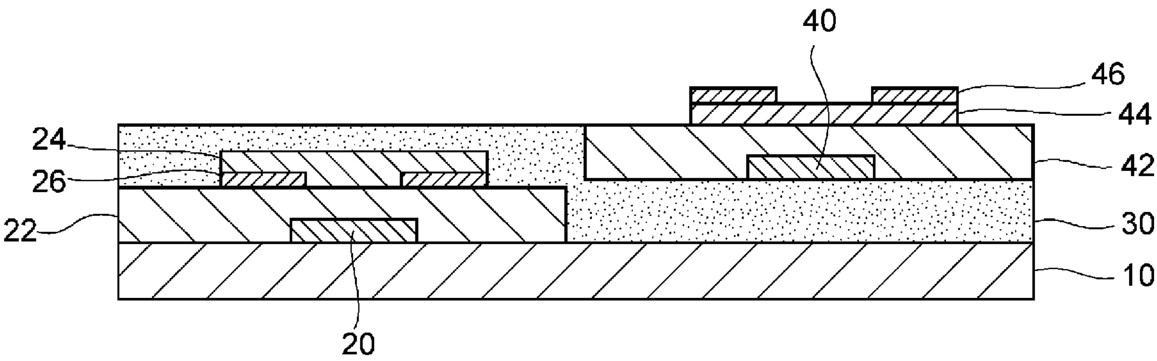


FIG. 23

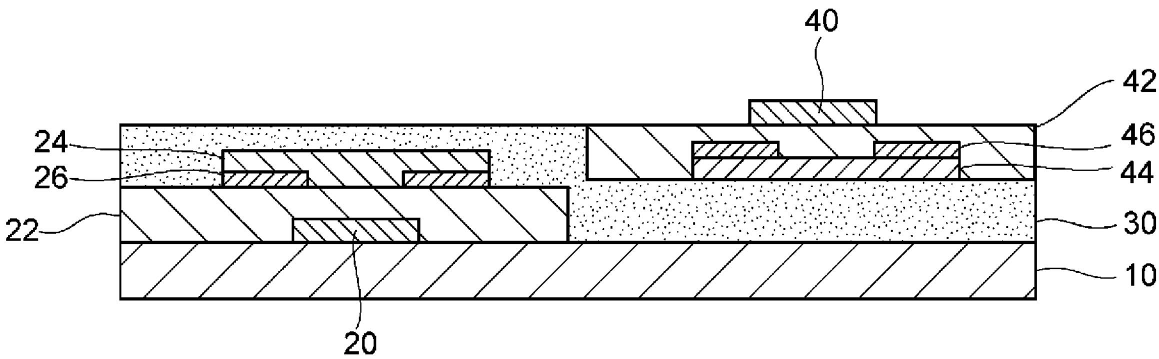


FIG. 24

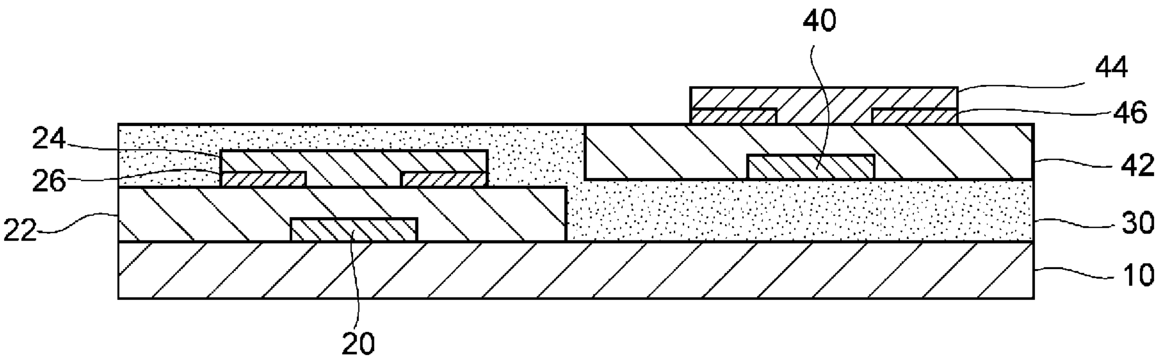


FIG. 25

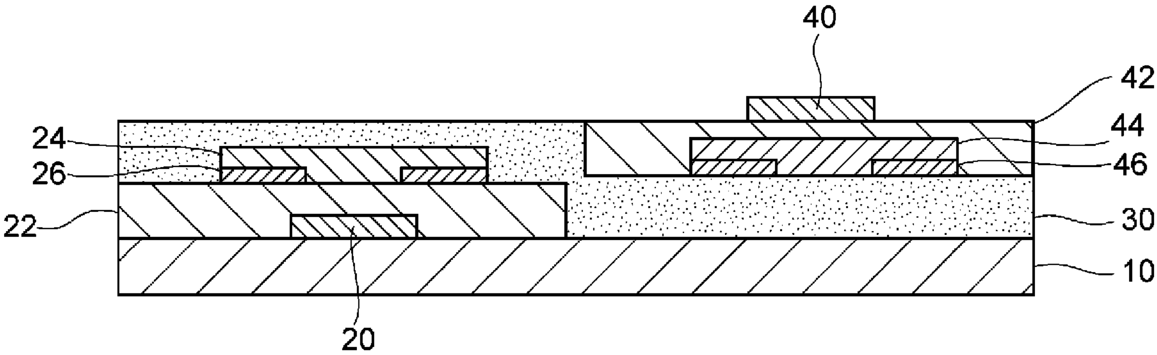


FIG. 26

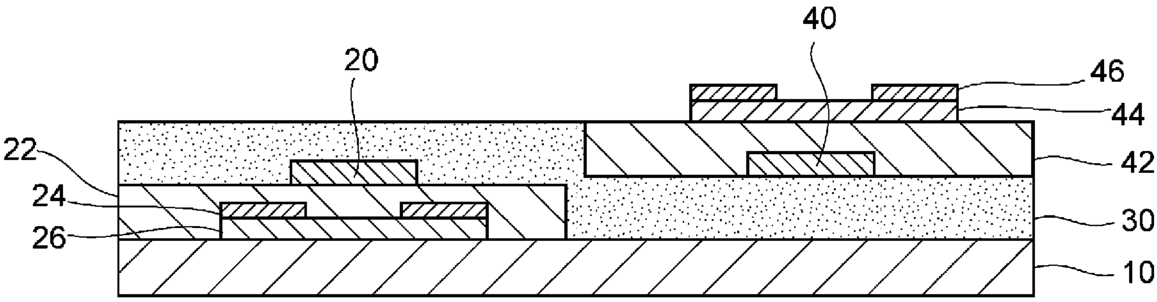


FIG. 27

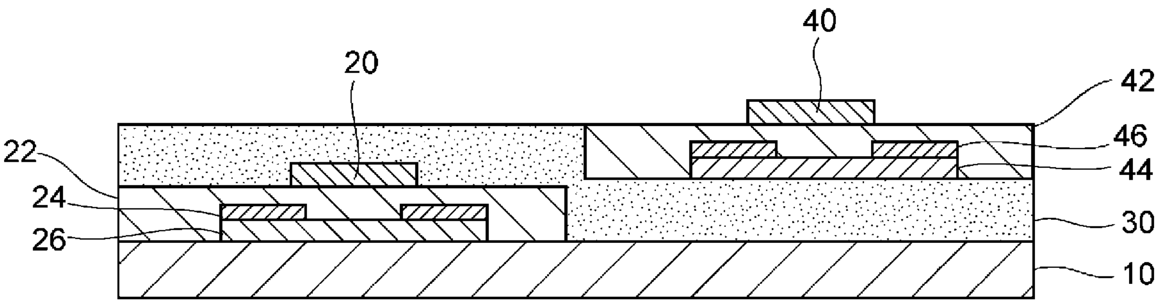


FIG. 28

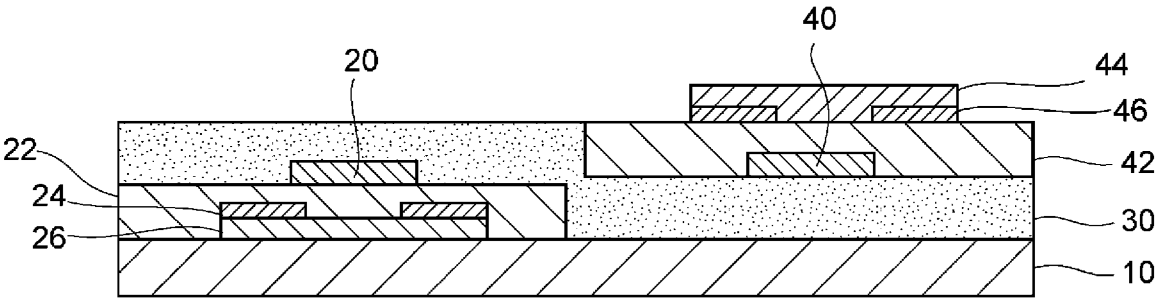


FIG. 29

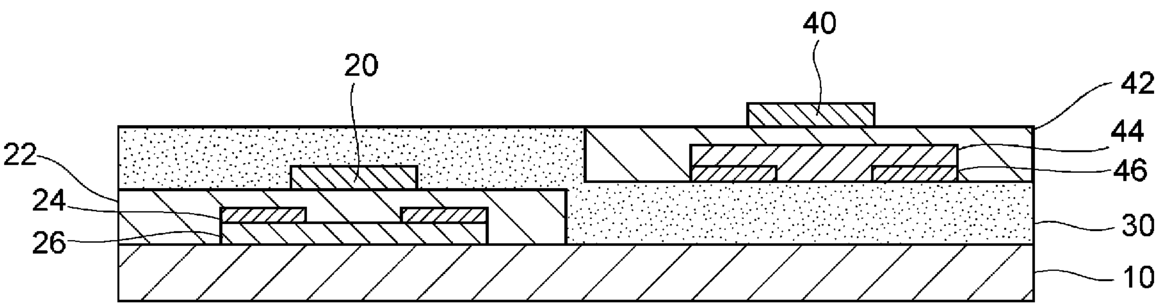


FIG. 30

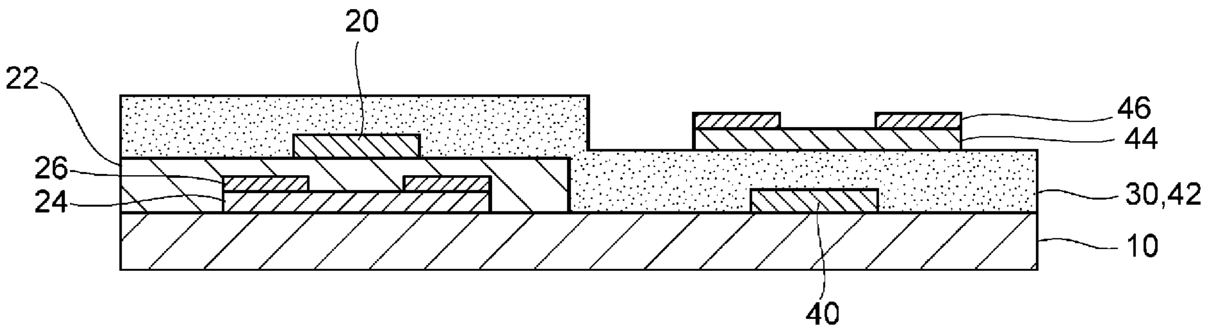


FIG. 31

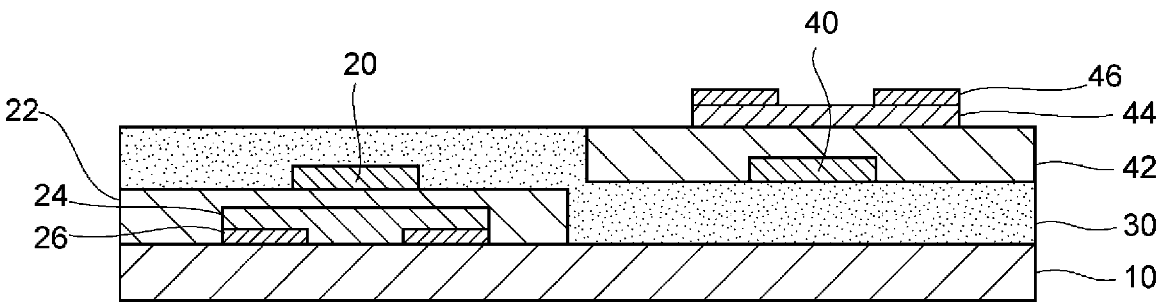


FIG. 32

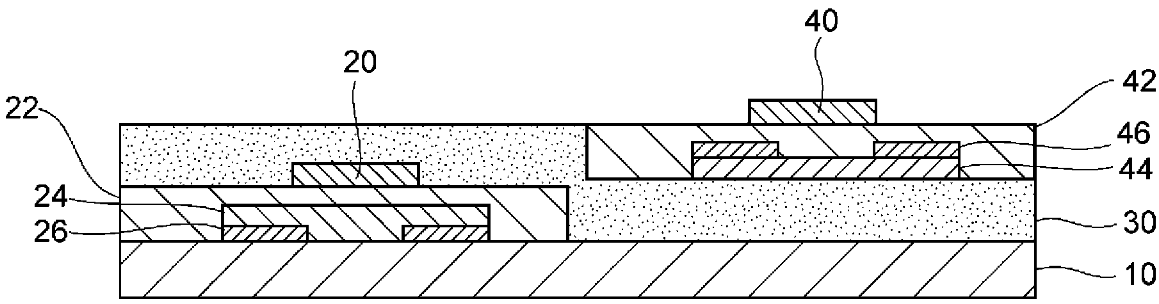


FIG. 33

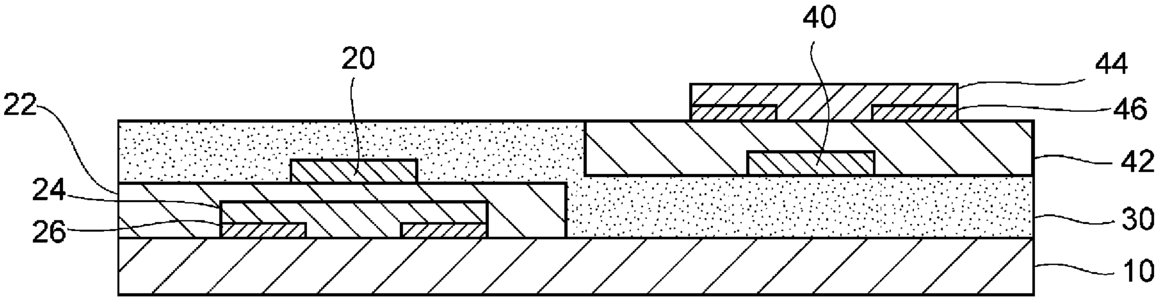


FIG. 34

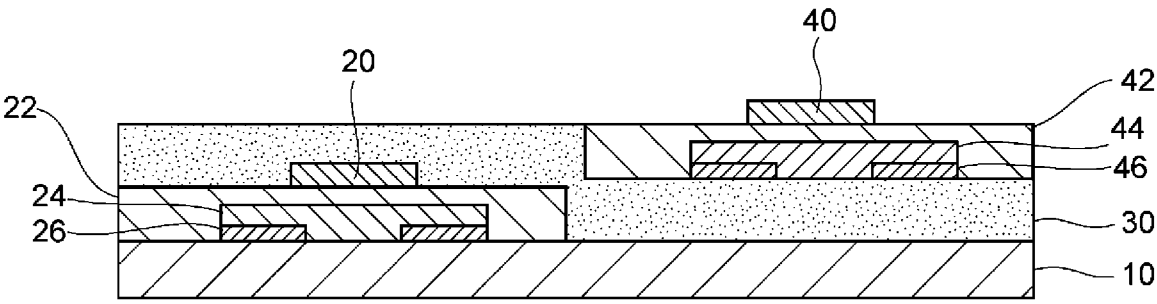


FIG. 35

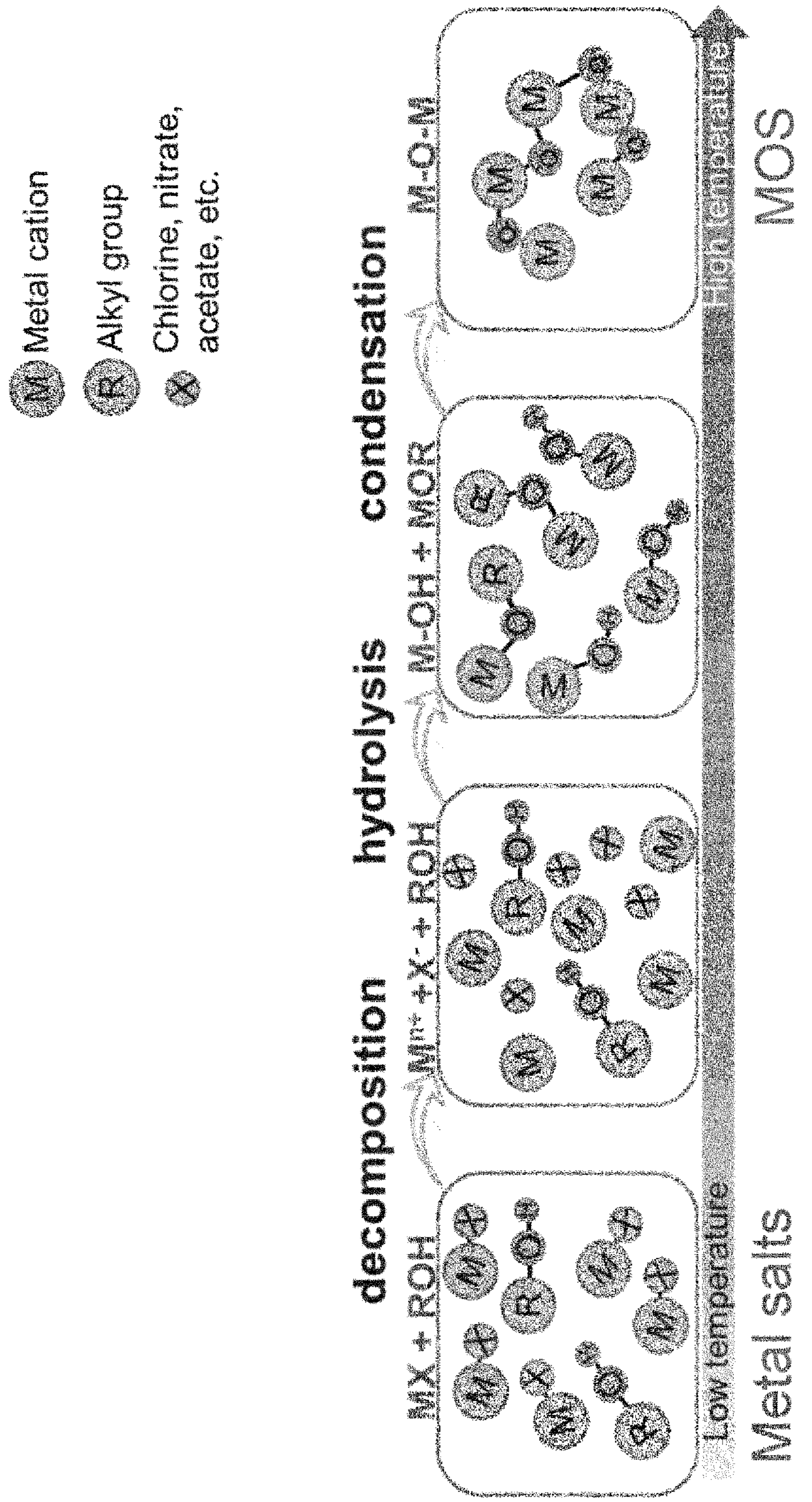
Metal cation
Alkyl group
Chlorine, nitrate, acetate, etc.
decomposition
hydrolysis
condensation
MX + ROH
$M^{n+}$ + $X^-$ + ROH
M-OH + MOR
M-O-M
Low temperature
High temperature
Metal salts
MOS

FIG. 36

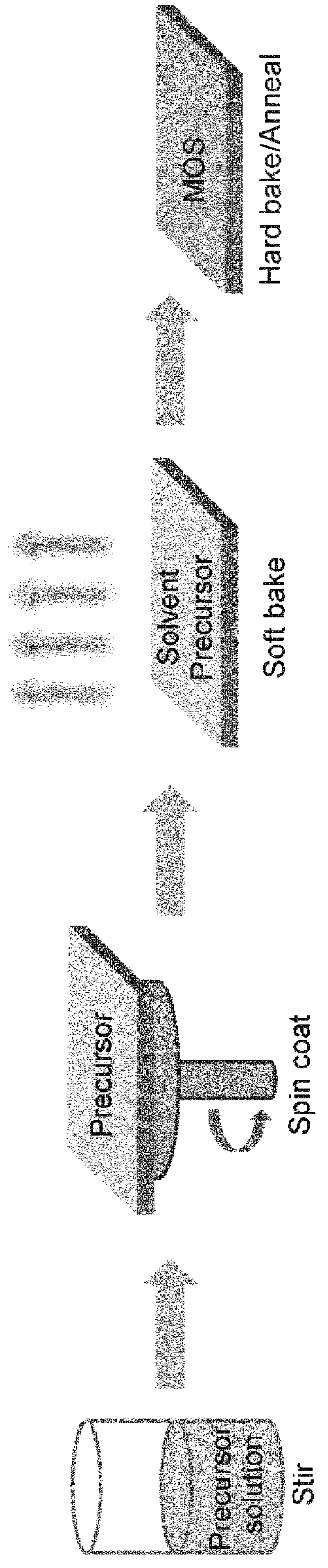
Precursor solution
Stir
Precursor
Spin coat
Solvent
Precursor
Soft bake
MOS
Hard bake/Anneal

FIG. 37

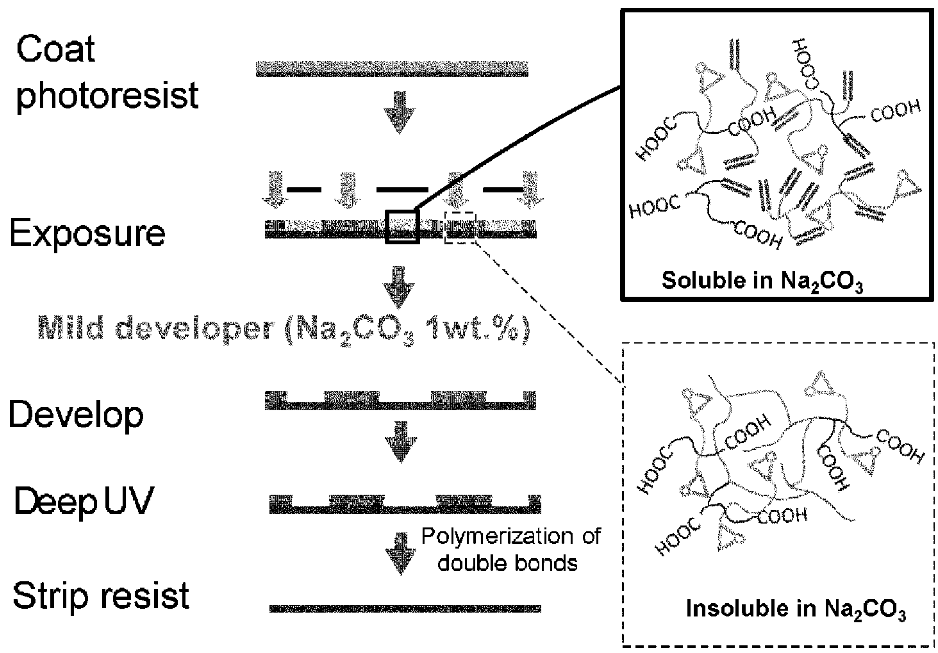
Coat photoresist
Exposure
Mild developer ($Na_2CO_3$ 1wt.%)
Develop
Deep UV
Polymerization of double bonds
Strip resist
Soluble in $Na_2CO_3$
Insoluble in $Na_2CO_3$
HOOC
COOH

FIG. 38

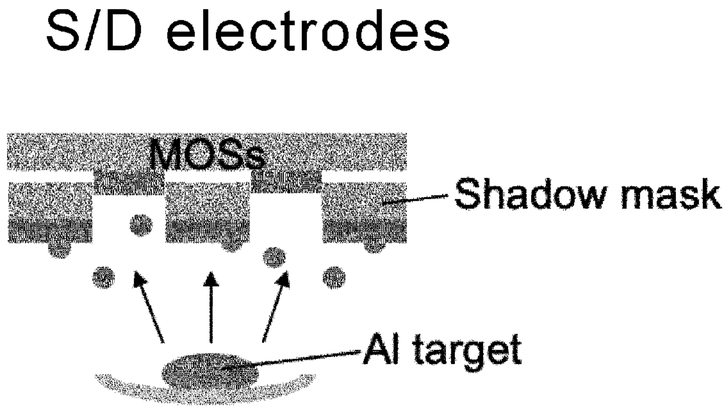


FIG. 39

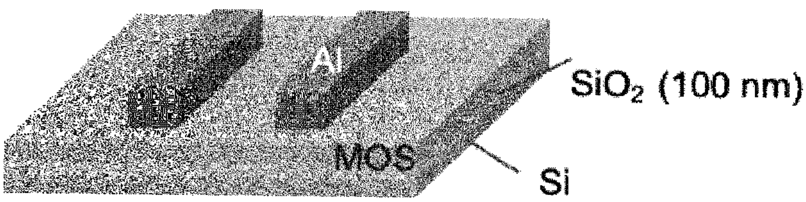


FIG. 40

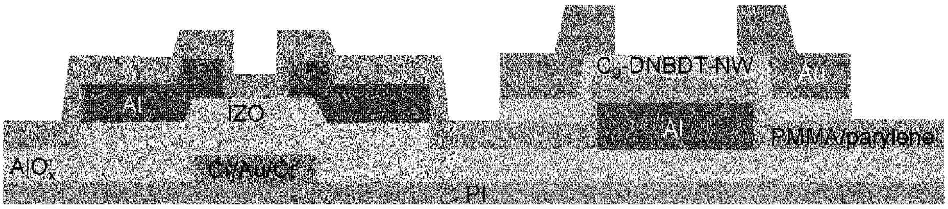


FIG. 41

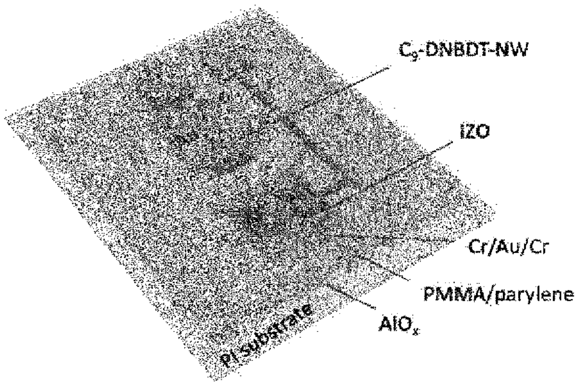


FIG. 42

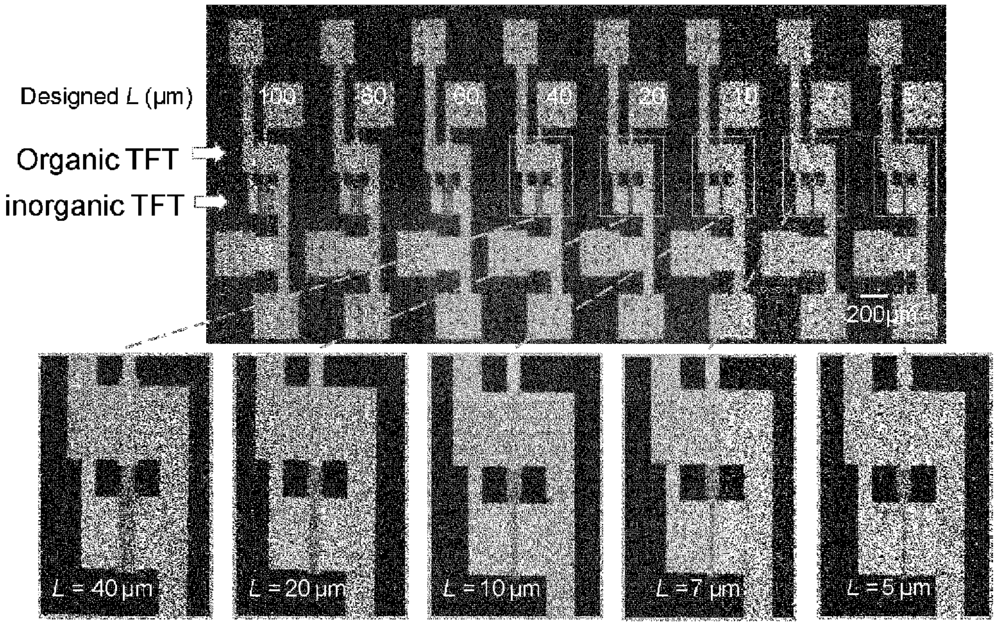
Designed L (μm)
100
80
60
40
20
10
7
5
Organic TFT
inorganic TFT
200μm
L = 40 μm
L = 20 μm
L = 10 μm
L = 7 μm
L = 5 μm

FIG. 43

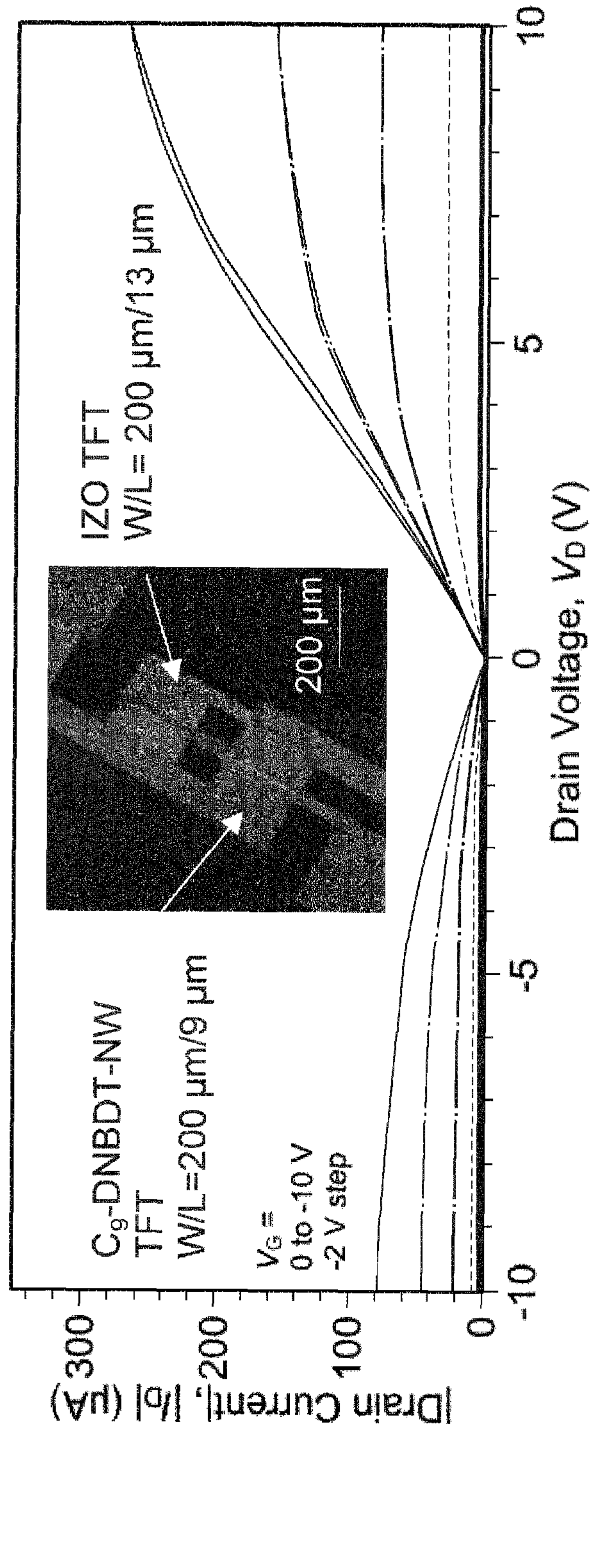

|Drain Current|, $|I_D|$ (μA)
300
200
100
0
-10
-5
0
5
10
Drain Voltage, $V_D$ (V)
$C_9$-DNBDT-NW
TFT
W/L=200 μm/9 μm
$V_G$ =
0 to -10 V
-2 V step
IZO TFT
W/L= 200 μm/13 μm
200 μm


FIG. 44

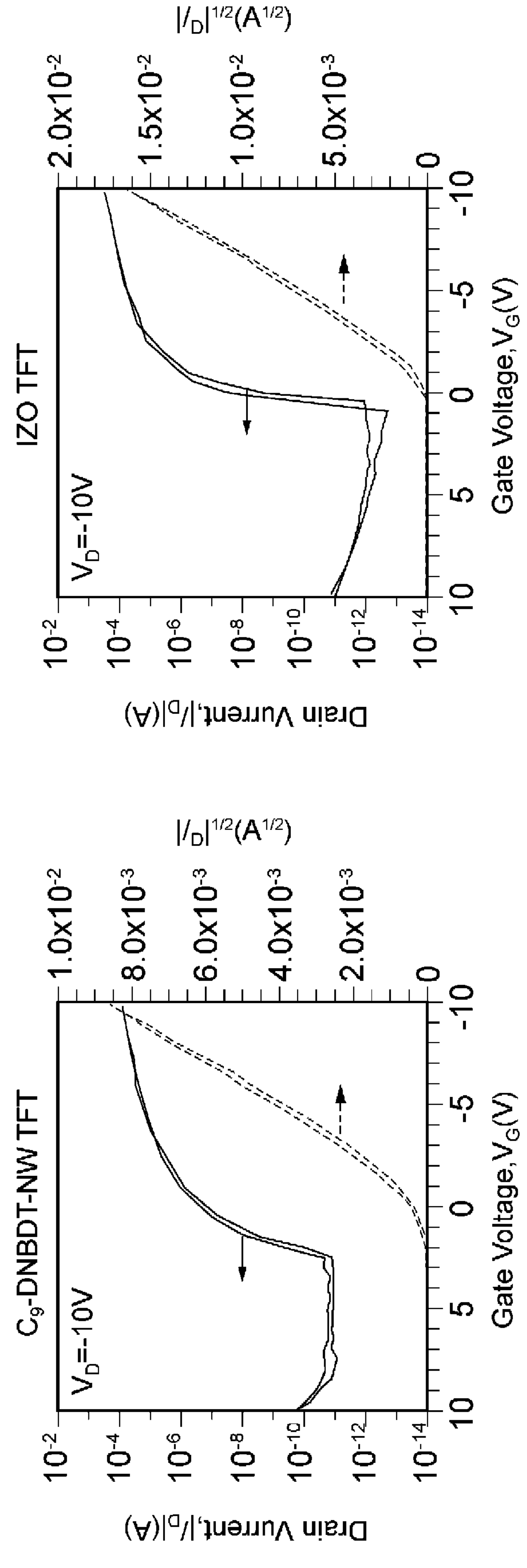
IZO TFT
C9-DNBDT-NW TFT
VD=-10V
Drain Vurrent,|ID|(A)
|ID|1/2(A1/2)
Gate Voltage,VG(V)
10-2
10-4
10-6
10-8
10-10
10-12
10-14
2.0x10-2
1.5x10-2
1.0x10-2
5.0x10-3
1.0x10-2
8.0x10-3
6.0x10-3
4.0x10-3
2.0x10-3
0
10
5
0
-5
-10

FIG. 45

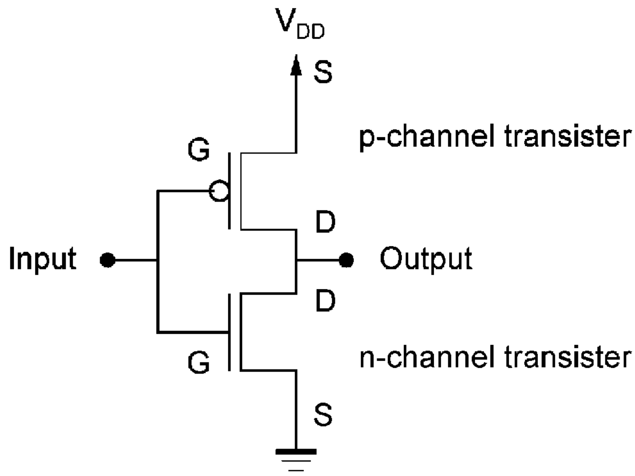
VDD
S
G
p-channel transister
D
Input
Output
D
G
n-channel transister
S

FIG. 46

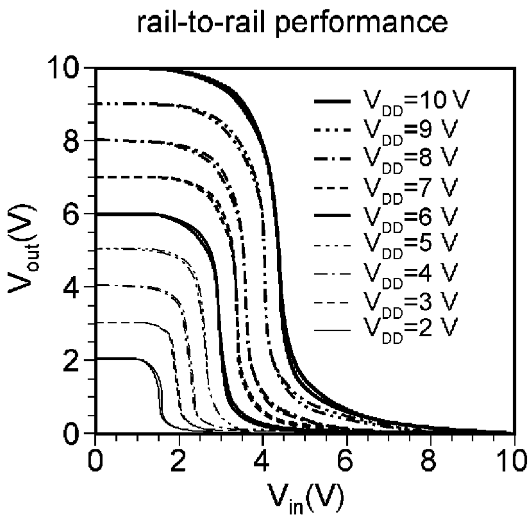
rail-to-rail performance
10
8
6
4
2
0
0
2
4
6
8
10
$V_{out}(V)$
$V_{in}(V)$
$V_{DD}$=10 V
$V_{DD}$=9 V
$V_{DD}$=8 V
$V_{DD}$=7 V
$V_{DD}$=6 V
$V_{DD}$=5 V
$V_{DD}$=4 V
$V_{DD}$=3 V
$V_{DD}$=2 V

FIG. 47

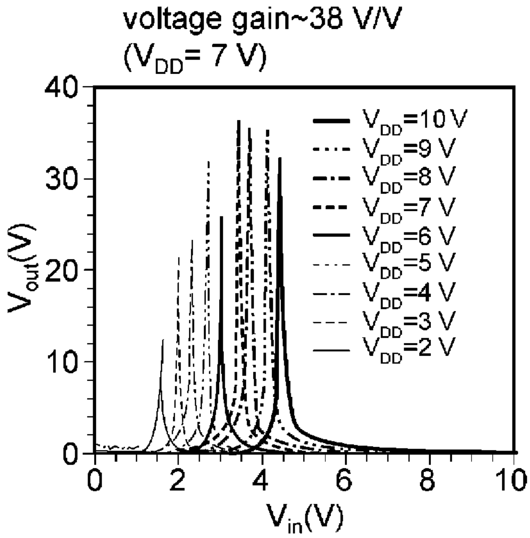
voltage gain~38 V/V
($V_{DD}$= 7 V)
40
30
20
10
0
$V_{out}$(V)
0
2
4
6
8
10
$V_{in}$(V)
$V_{DD}$=10 V
$V_{DD}$=9 V
$V_{DD}$=8 V
$V_{DD}$=7 V
$V_{DD}$=6 V
$V_{DD}$=5 V
$V_{DD}$=4 V
$V_{DD}$=3 V
$V_{DD}$=2 V

FIG. 48

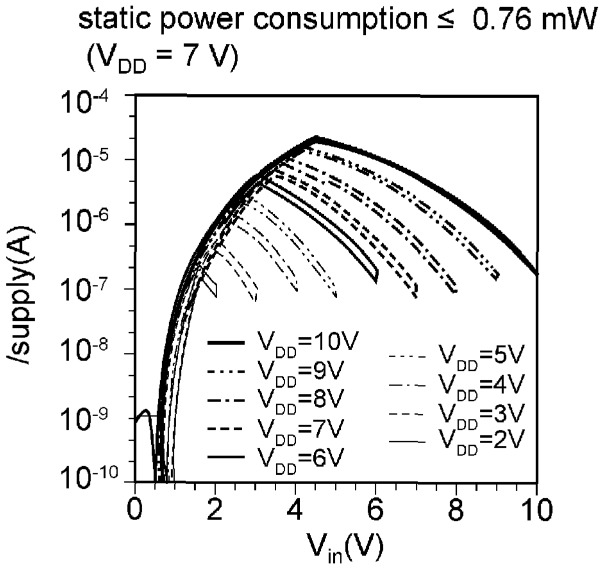
static power consumption ≤ 0.76 mW
(V_DD = 7 V)
10^-4
10^-5
10^-6
10^-7
10^-8
10^-9
10^-10
/supply(A)
0
2
4
6
8
10
V_in(V)
V_DD=10V
V_DD=9V
V_DD=8V
V_DD=7V
V_DD=6V
V_DD=5V
V_DD=4V
V_DD=3V
V_DD=2V

FIG. 49

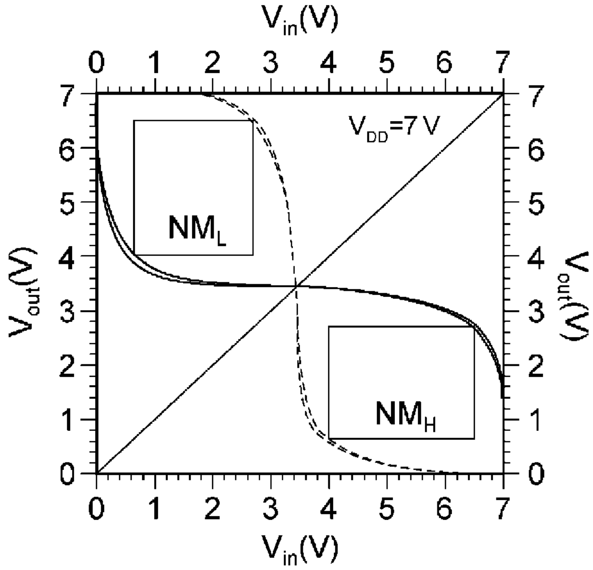


$NM_L$= 1.9 V $NM_H$ = 2.7 V

FIG. 50

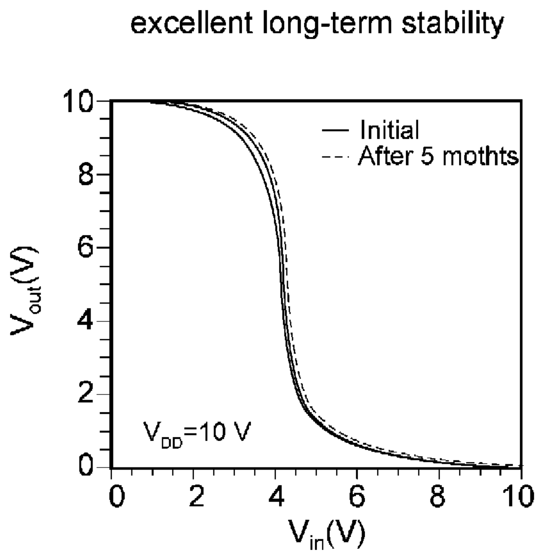
excellent long-term stability
Initial
After 5 mothts
$V_{DD}$=10 V
$V_{out}$(V)
$V_{in}$(V)
0
2
4
6
8
10

FIG. 51

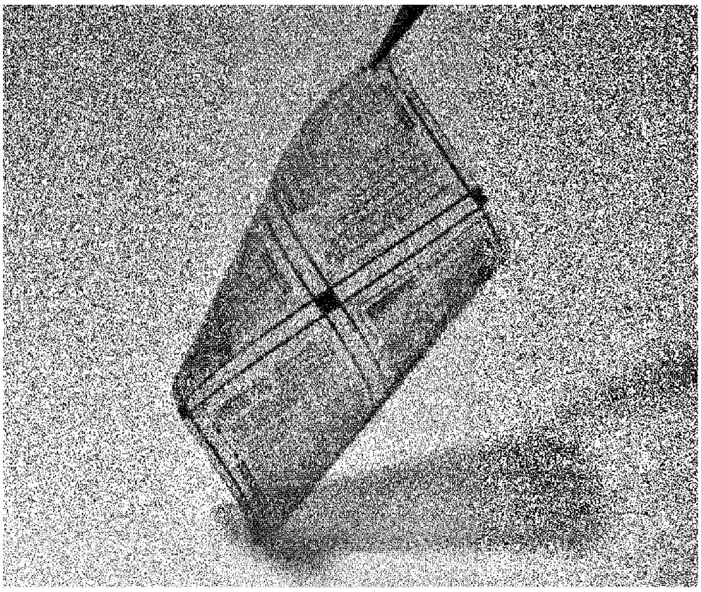

FIG. 52

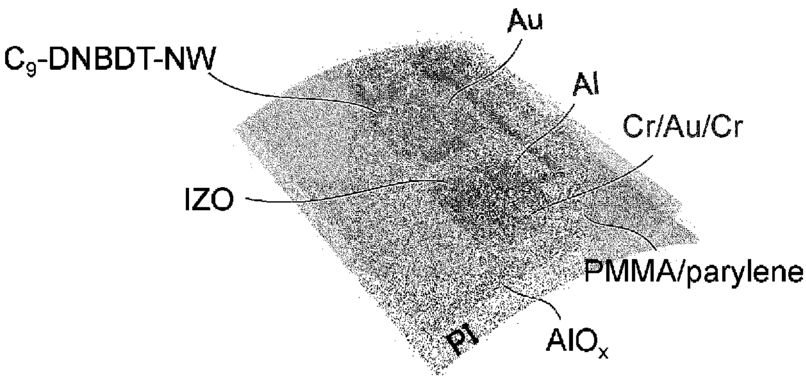


FIG. 53

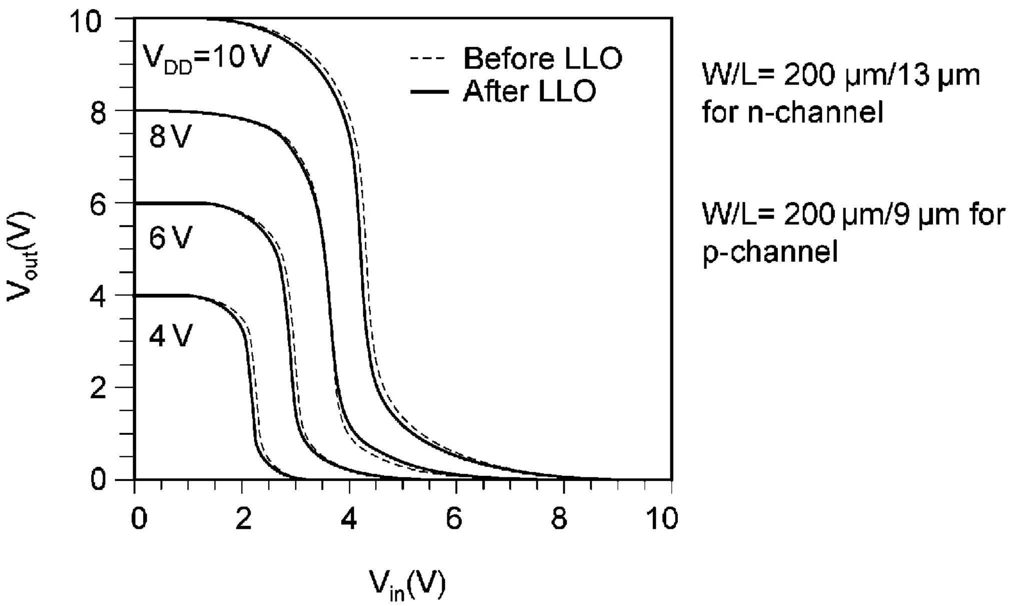
10
8
6
4
2
0
$V_{out}(V)$
$V_{DD}$=10 V
8 V
6 V
4 V
--- Before LLO
— After LLO
0
2
4
6
8
10
$V_{in}(V)$
W/L= 200 µm/13 µm for n-channel
W/L= 200 µm/9 µm for p-channel

FIG. 54

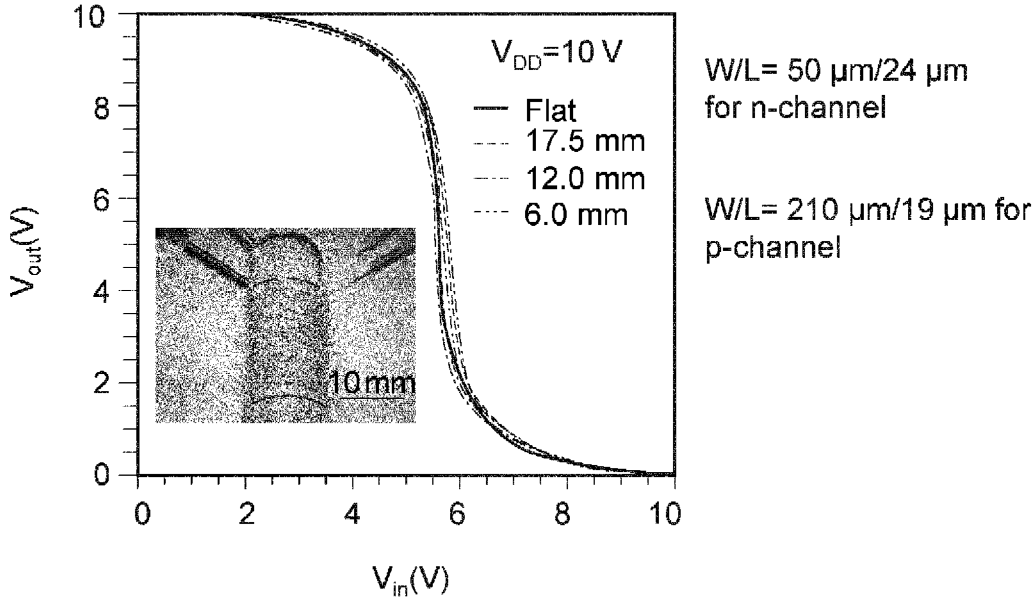
10
8
6
4
2
0
0 2 4 6 8 10
$V_{out}$(V)
$V_{in}$(V)
$V_{DD}$=10 V
Flat
17.5 mm
12.0 mm
6.0 mm
10 mm
W/L= 50 μm/24 μm for n-channel
W/L= 210 μm/19 μm for p-channel

FIG. 55

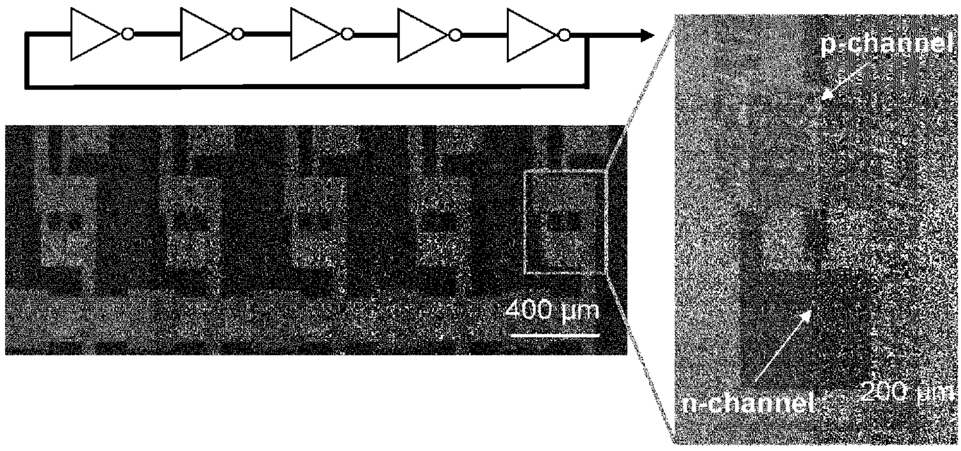


FIG. 56

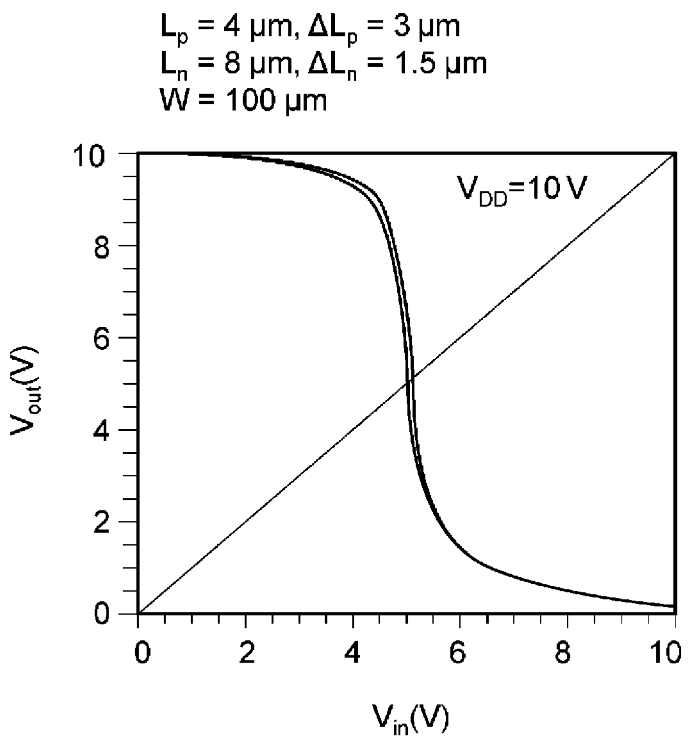
$L_p$ = 4 μm, $\Delta L_p$ = 3 μm
$L_n$ = 8 μm, $\Delta L_n$ = 1.5 μm
W = 100 μm
$V_{DD}$=10 V
$V_{out}$(V)
$V_{in}$(V)
0
2
4
6
8
10

FIG. 57

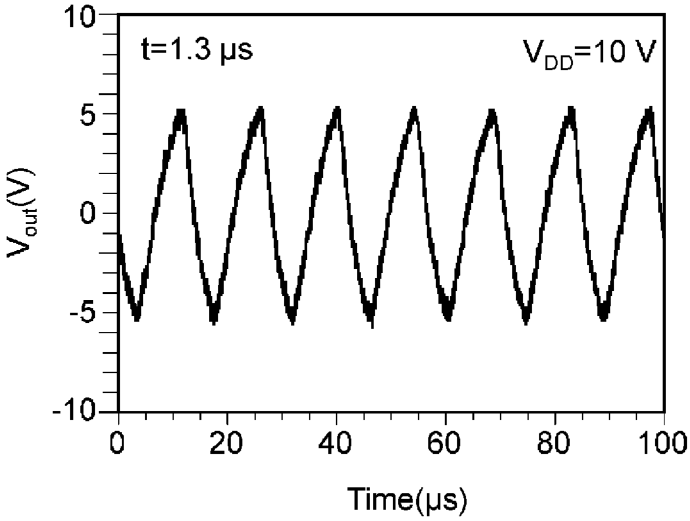


FIG. 58

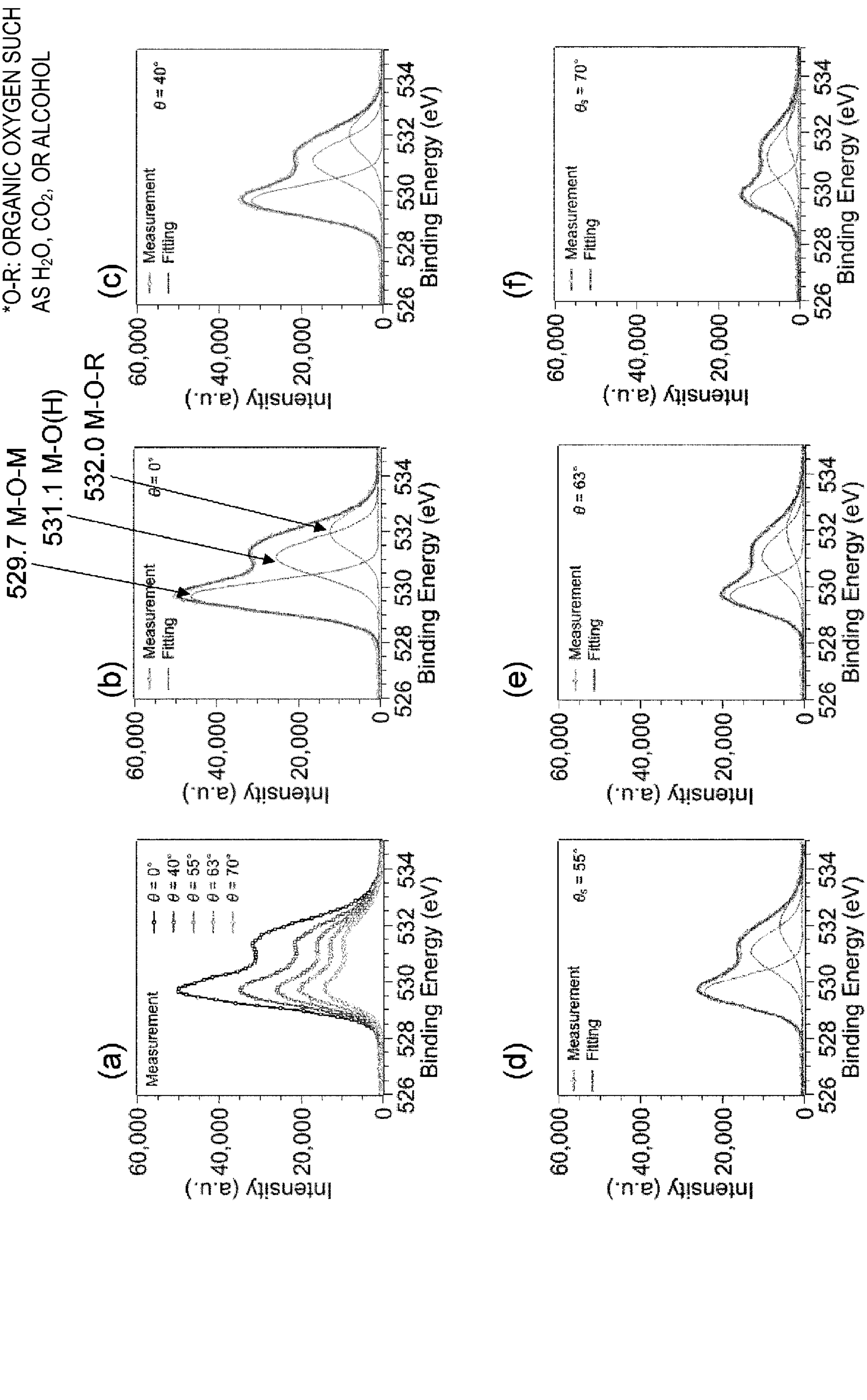
*O-R: ORGANIC OXYGEN SUCH AS $H_2O$, $CO_2$, OR ALCOHOL
529.7 M-O-M
531.1 M-O(H)
532.0 M-O-R
(a)
(b)
(c)
(d)
(e)
(f)
Measurement
Fitting
θ = 0°
θ = 40°
θ = 55°
θ = 63°
θ = 70°
Intensity (a.u.)
Binding Energy (eV)
60,000
40,000
20,000
0
526
528
530
532
534

FIG. 59

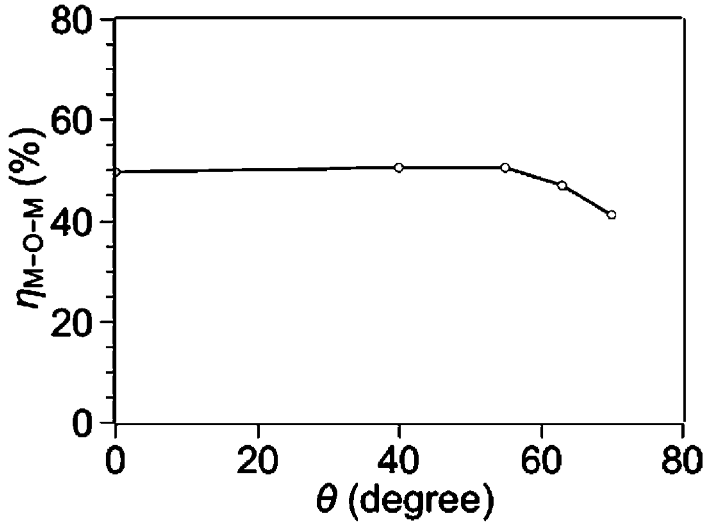


FIG. 60

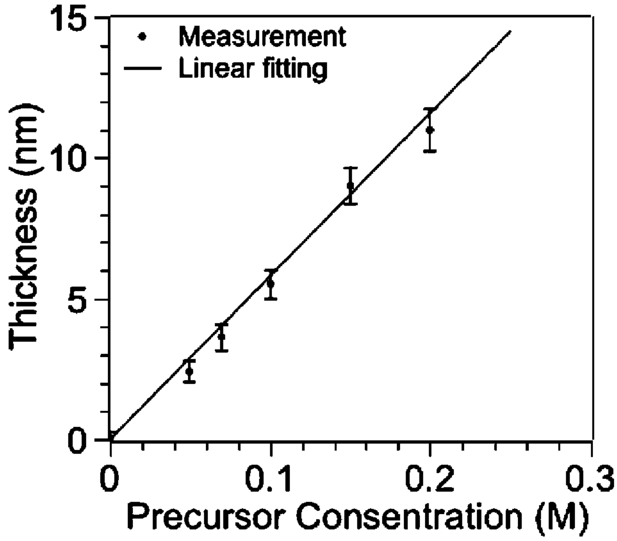
Measurement
Linear fitting
Thickness (nm)
15
10
5
0
0
0.1
0.2
0.3
Precursor Consentration (M)

FIG. 61

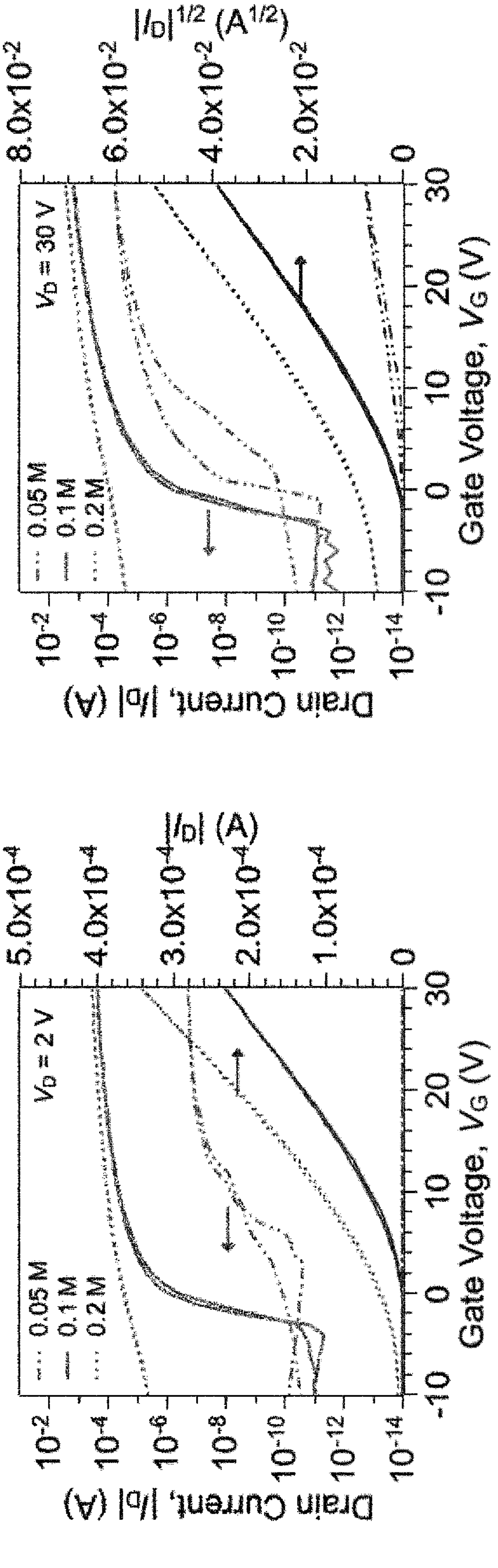
$V_D$ = 30 V
0.05 M
0.1 M
0.2 M
Drain Current, $|I_D|$ (A)
$|I_D|^{1/2}$ ($A^{1/2}$)
Gate Voltage, $V_G$ (V)
$V_D$ = 2 V
$|I_D|$ (A)

FIG. 62

High temperature

- Form M-O-M structure
- Increase shallow donor concentration

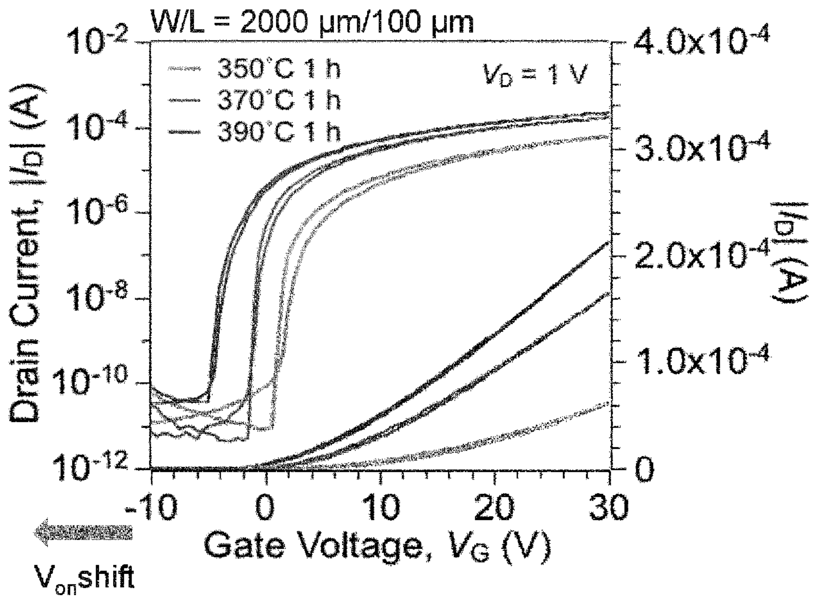


FIG. 63

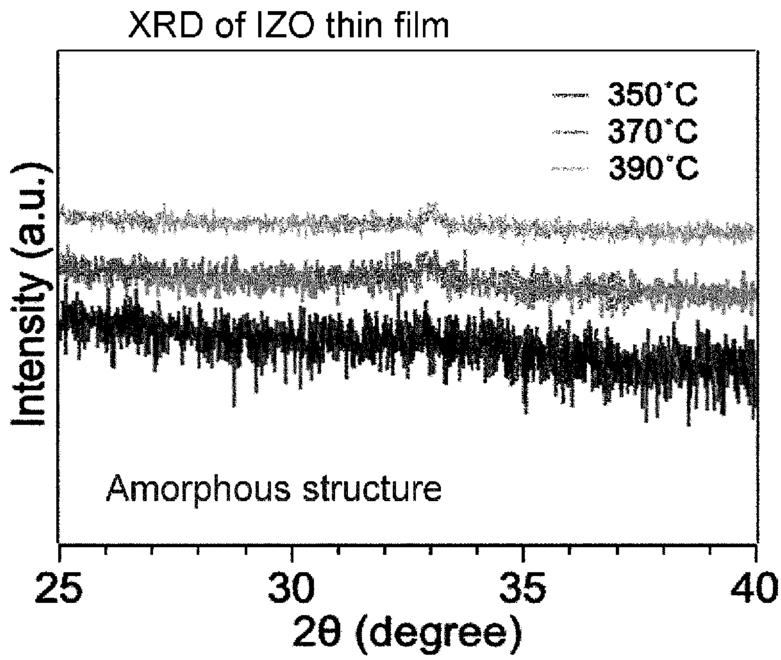
XRD of IZO thin film
350°C
370°C
390°C
Intensity (a.u.)
Amorphous structure
25
30
35
40
2θ (degree)

FIG. 64

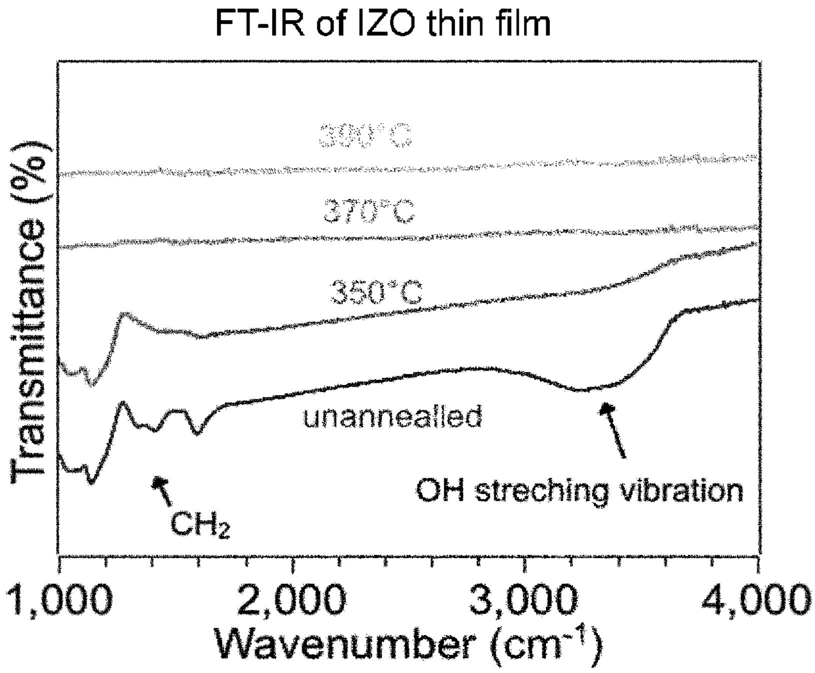
FT-IR of IZO thin film
390°C
370°C
350°C
unannealled
CH2
OH streching vibration
Transmittance (%)
1,000
2,000
3,000
4,000
Wavenumber (cm-1)

FIG. 65

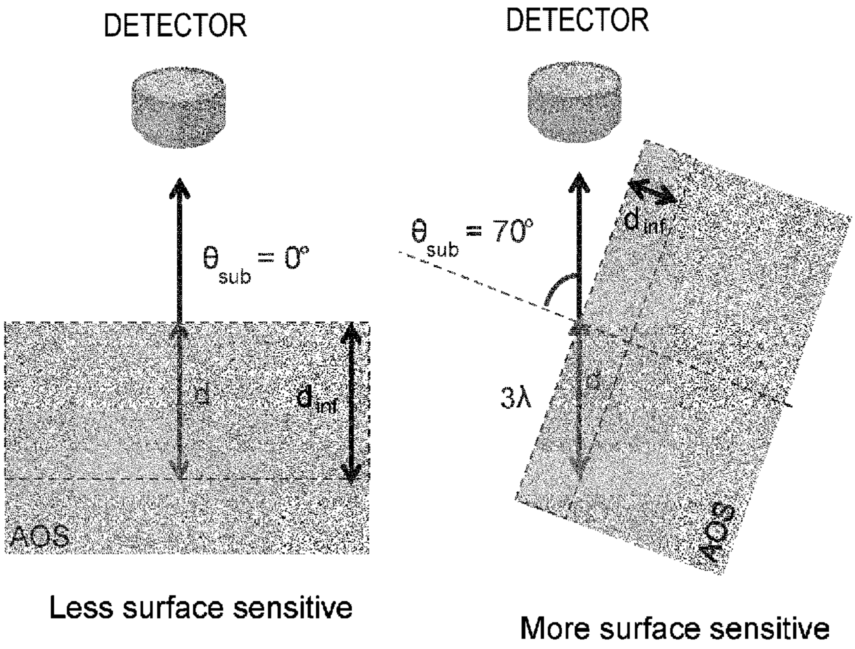
DETECTOR
$\theta_{sub}$ = 0°
d
$d_{inf}$
AOS
Less surface sensitive
DETECTOR
$\theta_{sub}$ = 70°
$d_{inf}$
3λ
d
AOS
More surface sensitive

FIG. 66

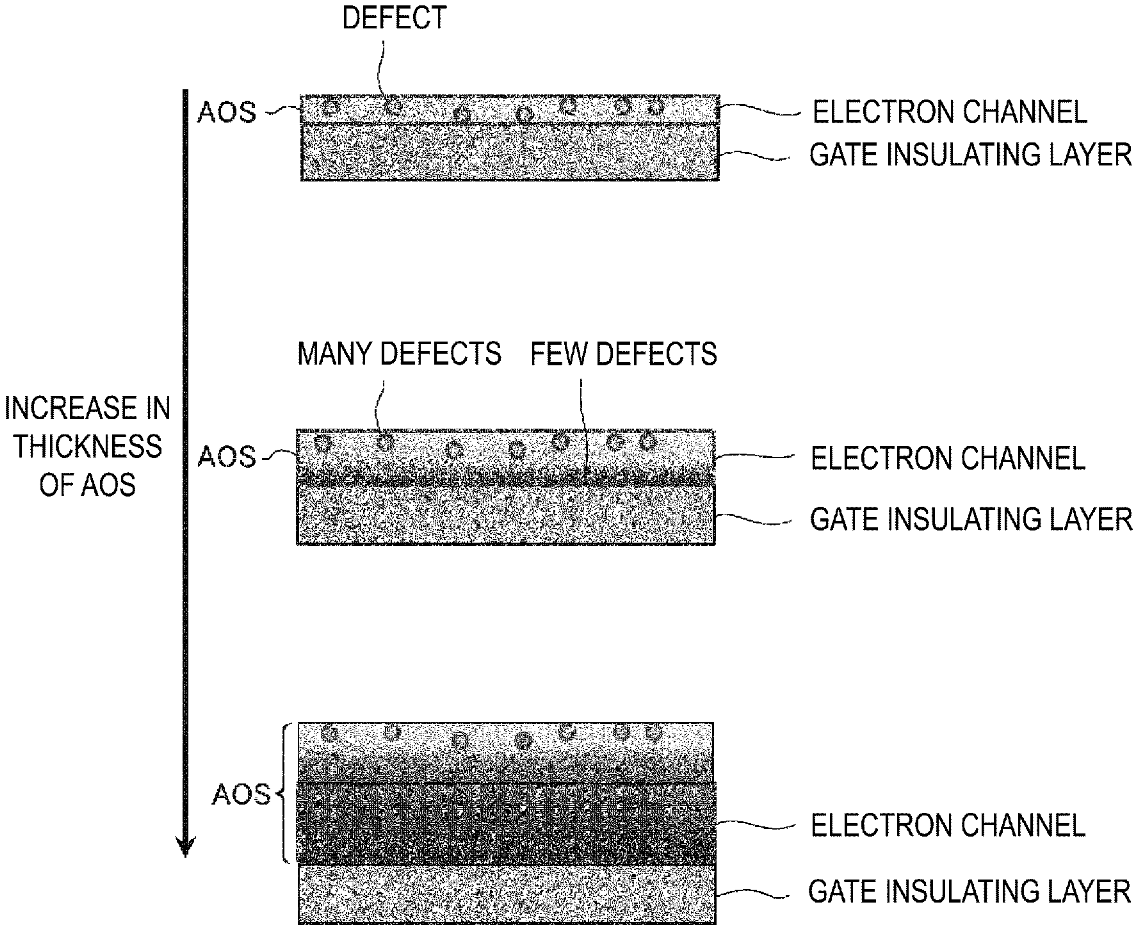
DEFECT
AOS
ELECTRON CHANNEL
GATE INSULATING LAYER
MANY DEFECTS
FEW DEFECTS
INCREASE IN THICKNESS OF AOS
AOS
ELECTRON CHANNEL
GATE INSULATING LAYER
AOS
ELECTRON CHANNEL
GATE INSULATING LAYER

FIG. 67

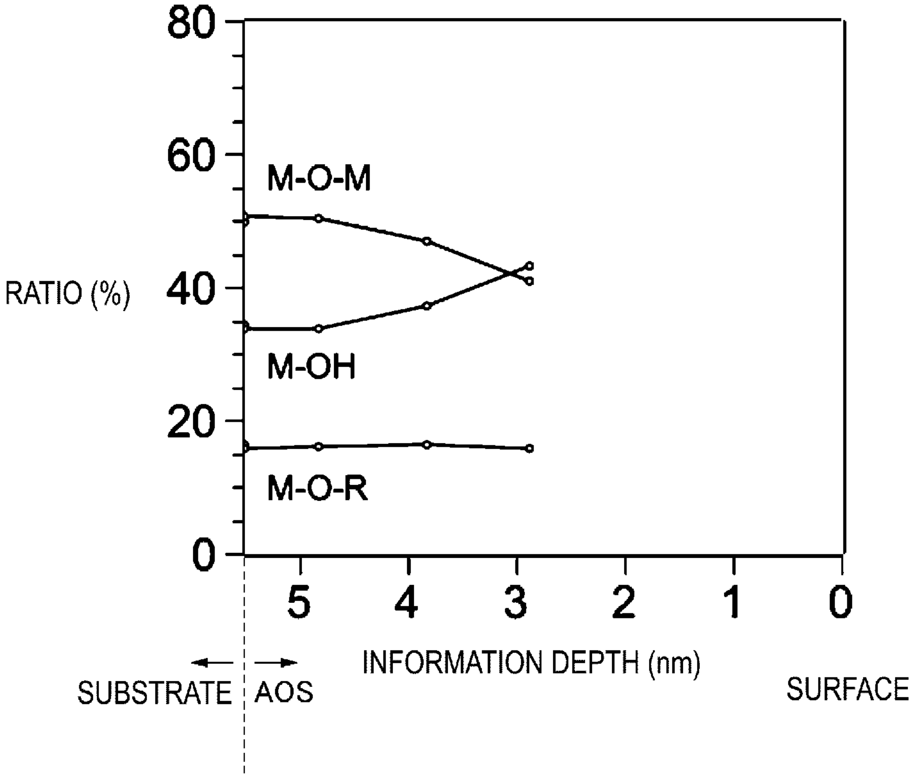
80
60
40
20
0
RATIO (%)
M-O-M
M-OH
M-O-R
5
4
3
2
1
0
INFORMATION DEPTH (nm)
SUBSTRATE
AOS
SURFACE

FIG. 68

AFTER HEAT TREATMENT AT 150°C FOR 5 MINUTES

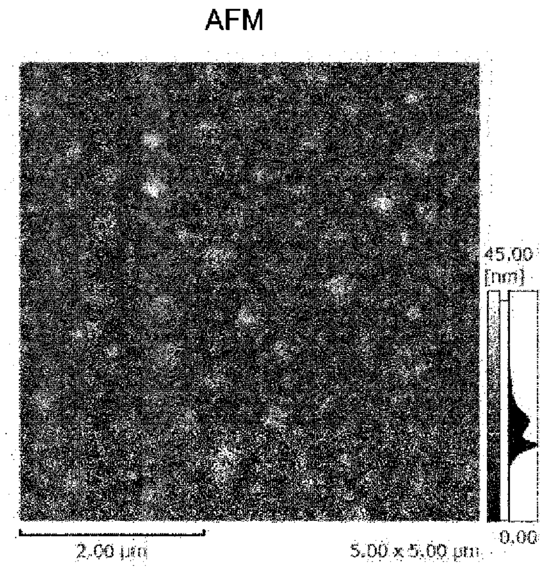


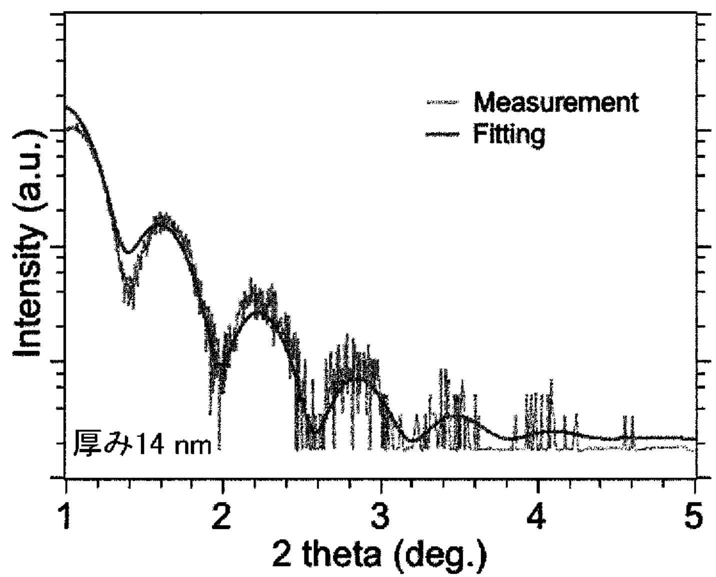


FIG. 69

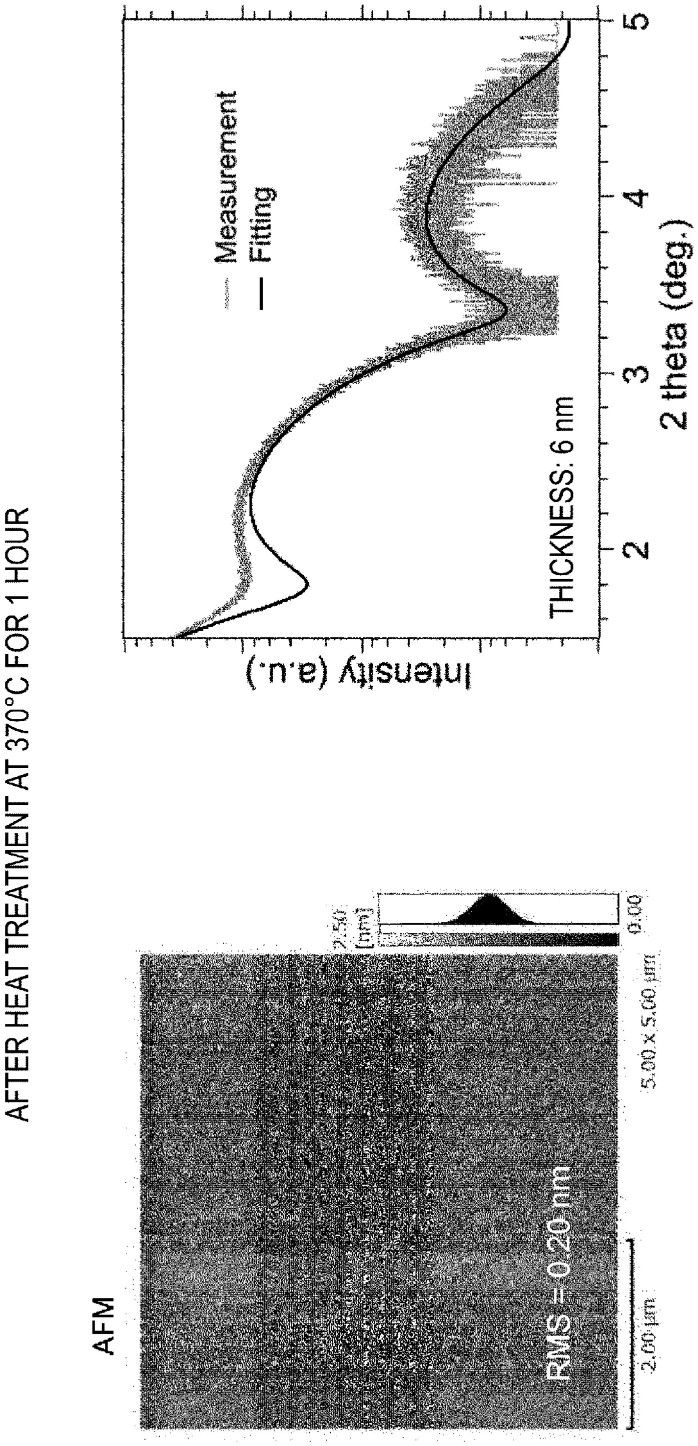

AFTER HEAT TREATMENT AT 370°C FOR 1 HOUR
AFM
RMS = 0.20 nm
2.00 µm
5.00 x 5.00 µm
2.50 [nm]
0.00
Measurement
Fitting
THICKNESS: 6 nm
Intensity (a.u.)
2 theta (deg.)
2
3
4
5


FIG. 70

## INTERNATIONAL SEARCH REPORT

International application No.
**PCT/JP2022/007658**

**A. CLASSIFICATION OF SUBJECT MATTER**

***H01L 29/786***(2006.01)i; ***H01L 21/336***(2006.01)i; ***H01L 51/05***(2006.01)i; ***H01L 51/30***(2006.01)i; ***H01L 51/40***(2006.01)i
FI: H01L29/78 613A; H01L29/78 618B; H01L29/78 618C; H01L29/78 626C; H01L29/28 250H; H01L29/28 100A; H01L29/28 220C; H01L29/78 618A; H01L21/368 L

According to International Patent Classification (IPC) or to both national classification and IPC

**B. FIELDS SEARCHED**

Minimum documentation searched (classification system followed by classification symbols)

H01L29/786; H01L21/336; H01L51/05; H01L51/30; H01L51/40

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2011-258760 A (RICOH CO LTD) 22 December 2011 (2011-12-22) paragraphs [0024]-[0035], [0046]-[0054], fig. 5, 6, 21 | 1-4, 8, 9, 11 |
| A | paragraphs [0024]-[0035], [0046]-[0054], fig. 5, 6, 21 | 5-7, 10, 12 |
| Y | WO 2020/171131 A1 (UNIV TOKYO) 27 August 2020 (2020-08-27) paragraphs [0017], [0021], [0058], [0068], [0069], [0078] | 1-4, 8, 9, 11 |
| Y | JP 2010-56540 A (SEMICONDUCTOR ENERGY LAB CO LTD) 11 March 2010 (2010-03-11) paragraphs [0081], [0084] | 1-4, 8, 9, 11 |
| Y | JP 2013-123045 A (SEMICONDUCTOR ENERGY LAB CO LTD) 20 June 2013 (2013-06-20) paragraph [0161] | 1-4, 8, 9, 11 |
| Y | WO 2016/199680 A1 (SHARP KK) 15 December 2016 (2016-12-15) paragraph [0164] | 1-4, 8, 9, 11 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **26 April 2022** | **10 May 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2022/007658**

**C. DOCUMENTS CONSIDERED TO BE RELEVANT**

| Category* | Citation of document, with indication, where appropriate, of the relevant passages | Relevant to claim No. |
|---|---|---|
| Y | US 2018/0166503 A1 (SHENZHEN CHINA STAR OPTOELECTRONICS TECHNOLOGY CO., LTD.) 14 June 2018 (2018-06-14) paragraphs [0024]-[0034], [0036], fig. 2 | 1-4, 8, 9, 11 |
| A | paragraphs [0024]-[0034], [0036], fig. 2 | 5-7, 10, 12 |
| Y | JP 2014-143403 A (NATIONAL INSTITUTE OF ADVANCED INDUSTRIAL SCIENCE AND TECHNOLOGY) 07 August 2014 (2014-08-07) paragraphs [0025], [0026] | 8, 9, 11 |
| A | JP 2010-34343 A (SUMITOMO CHEMICAL CO LTD) 12 February 2010 (2010-02-12) entire text, all drawings | 1-12 |
| A | JP 2011-9413 A (SEIKO EPSON CORP) 13 January 2011 (2011-01-13) entire text, all drawings | 1-12 |
| A | JP 2002-518844 A (THIN FILM ELECTRONICS ASA) 25 June 2002 (2002-06-25) entire text, all drawings | 1-12 |
| A | JP 2010-114171 A (HITACHI LTD) 20 May 2010 (2010-05-20) entire text, all drawings | 1-12 |
| A | JP 2013-21190 A (DAINIPPON PRINTING CO LTD) 31 January 2013 (2013-01-31) entire text, all drawings | 1-12 |
| P, A | WO 2021/182545 A1 (UNIV TOKYO) 16 September 2021 (2021-09-16) entire text, all drawings | 1-12 |

Form PCT/ISA/210 (second sheet) (January 2015)

**INTERNATIONAL SEARCH REPORT**
**Information on patent family members**

International application No.
**PCT/JP2022/007658**

| Patent document cited in search report | Publication date (day/month/year) | Patent family member(s) | Publication date (day/month/year) |
|---|---|---|---|
| JP 2011-258760 A | 22 December 2011 | (Family: none) | |
| WO 2020/171131 A1 | 27 August 2020 | EP 3930018 A1<br>paragraphs [0017], [0021], [0043], [0053], [0054], [0063]<br>CN 113454800 A<br>KR 20210126020 A | |
| JP 2010-56540 A | 11 March 2010 | US 2010/0025676 A1<br>paragraphs [0113], [0116]<br>CN 101640220 A | |
| JP 2013-123045 A | 20 June 2013 | US 2013/0119373 A1<br>paragraph [0175]<br>CN 103107200 A<br>KR 10-2013-0052513 A | |
| WO 2016/199680 A1 | 15 December 2016 | US 2018/0151595 A1<br>paragraph [0185] | |
| US 2018/0166503 A1 | 14 June 2018 | CN 105742308 A<br>WO 2017/147970 A1 | |
| JP 2014-143403 A | 07 August 2014 | (Family: none) | |
| JP 2010-34343 A | 12 February 2010 | WO 2010/013621 A1<br>EP 2312638 A1<br>KR 10-2011-0038703 A<br>CN 102105988 A<br>TW 201013848 A | |
| JP 2011-9413 A | 13 January 2011 | US 2010/0327282 A1 | |
| JP 2002-518844 A | 25 June 2002 | US 6528816 B1<br>EP 1093663 A2<br>CA 2334862 A<br>KR 10-2001-0053039 A | |
| JP 2010-114171 A | 20 May 2010 | (Family: none) | |
| JP 2013-21190 A | 31 January 2013 | WO 2013/008880 A1 | |
| WO 2021/182545 A1 | 16 September 2021 | TW 202141179 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **TAKEDA, Y. et al.** *Appl. Sci.,* 2018, vol. 8, 1331
- **K. HONG et al.** *Adv. Mater.,* 2014, vol. 26, 7032
- **M. UNO et al.** *Adv. Electron. Mater.,* 2015, vol. 1, 1500178
- **K. J. BAEG et al.** *Org. Electron.,* 2013, vol. 14, 1407
- **S. H. KIM et al.** *IEEE Electron Device Lett.,* 2013, vol. 34, 307
- **W. SMAAL et al.** *Org. Electron.,* 2012, vol. 13, 1686
- **L. HERLOGSSON et al.** *Adv. Mater.,* 2011, vol. 23, 4684
- **K. J. BAEG. et al.** *Org. Electron.,* 2013, vol. 14, 1407